(19) Europäisches Patentamt
European Patent Office
Office européen des brevets

(11) EP 1 039 556 A1

(12) **EUROPEAN PATENT APPLICATION**
published in accordance with Art. 158(3) EPC

(43) Date of publication:
**27.09.2000 Bulletin 2000/39**

(21) Application number: **98936676.0**

(22) Date of filing: **05.08.1998**

(51) Int. Cl.$^7$: **H01L 35/14**, H01L 35/34

(86) International application number:
**PCT/JP98/03496**

(87) International publication number:
**WO 99/22410 (06.05.1999 Gazette 1999/18)**

(84) Designated Contracting States:
**DE FR GB IT NL**

(30) Priority: **24.10.1997 JP 30993397**
**22.12.1997 JP 36567497**
**22.12.1997 JP 36567597**
**22.12.1997 JP 36567697**
**22.12.1997 JP 36567797**
**27.12.1997 JP 36882897**
**19.06.1998 JP 18971498**
**19.06.1998 JP 18971598**
**26.06.1998 JP 19654698**

(71) Applicant:
**SUMITOMO SPECIAL METALS COMPANY LIMITED**
**Osaka-shi, Osaka 541-0041 (JP)**

(72) Inventors:
- **YAMASHITA, Osamu**
  **Ibaraki-shi, Osaka 567-0046 (JP)**
- **SADATOMI, Nobuhiro**
  **Ibaraki-shi, Osaka 567-0806 (JP)**
- **SAIGO, Tsunekazu**
  **Matsubara-shi, Osaka 580-0033 (JP)**

(74) Representative: **Butler, Lance**
**Barker Brettell**
**10-12 Priests Bridge**
**London SW15 5JE (GB)**

# (54) THERMOELECTRIC TRANSDUCING MATERIAL AND METHOD OF PRODUCING THE SAME

(57) A novel silicon-base thermoelectric transducing material containing a P- or N-type semiconductor obtained by adding various impurities to Si, which is produced with good productivity at low cost and has a stable quality and a high performance index. Generally when various elements are added to Si, the Seebeck coefficient of the material decreases with the carrier concentration until the carrier concentration exceeds $10^{18}$ M/m$^3$, and a minimum value of the Seebeck coefficient is in a range from $10^{18}$ to $10^{19}$ M/m$^3$. The material of the invention is a P- or N-type semiconductor having a carrier concentration of $10^{17}$ to $10^{20}$ M/m$^3$ and containing Si and 0.001 to 0.5 atomic % of one or more elements of Be, Mg, Ca, Sr, Ba Zn, Cd, Hg, B, Al, Ga, In, and Tl, or one or more elements of N, P, As, Sb, Bi, O, S, Se, and Te, and another material is a P- or N-type semiconductor having a carrier concentration of $10^{19}$ to $10^{21}$ M/m$^3$ and containing Si and 0.5 to 10 atomic % of one or more of the elements.

*Fig. 4*

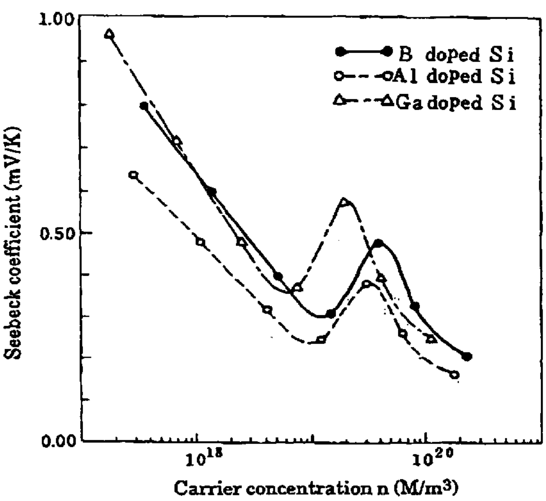


EP 1 039 556 A1

## Description

### TECHNICAL FIELD

This invention relates to a novel thermoelectric conversion material based primarily on silicon and having a high conversion efficiency, and to a method for manufacturing this material, and more particularly relates to a silicon-based thermoelectric conversion material that is inexpensive, has stable quality, and affords good productivity because it is based primarily on silicon, and that is composed of a p-type or n-type semiconductor with an extremely high Seebeck coefficient and a markedly increased thermoelectric conversion efficiency, which is accomplished by selecting dopants and adjusting the doping amounts such that the carrier concentration in the silicon semiconductor is $10^{17}$ to $10^{20}$ (M/m$^3$) or $10^{19}$ to $10^{21}$ (M/m$^3$).

### BACKGROUND ART

Thermoelectric conversion elements are devices that are expected to see practical use because of their efficient utilization of the high levels of thermal energy required in recent industrial fields. An extremely broad range of applications have been investigated, such as a system for converting waste heat into electrical energy, small, portable electric generators for easily obtaining electricity outdoors, flame sensors for gas equipment, and so forth.

Thermoelectric conversion elements known up to now have not gained widespread acceptance, however, some of the reasons for which are that the conversion efficiency thereof is generally low, the usable temperature range is extremely narrow, the manufacturing method is complicated, and the cost is high.

This conversion efficiency from thermal energy to electrical energy is a function of the performance index ZT, and rises in proportion to ZT. This performance index ZT is expressed by Formula 1.

$$ZT=\alpha^2\rho T/\kappa \qquad \text{Formula 1}$$

Here, $\alpha$ is the Seebeck coefficient of the thermoelectric material, $\rho$ is the electrical conductivity, $\kappa$ is the thermal conductivity, and T is the absolute temperature expressed as the average value for the thermoelectric element on the high temperature side ($T_H$) and the low temperature side ($T_L$).

The thermoelectric material with the highest performance index at the present time is $IrSb_3$ having a skutterudite-type crystal structure (T. Caillet, A. Borshchrysky, and J.P. Fleurial: Proc. 12th Int. Conf. on Thermoelectrics (Yokohama, Japan, 1993), p. 132), which exhibits a ZT value of approximately 2.0. This material has yet to see practical use, however, because the iridium raw material is prohibitively expensive.

Meanwhile, an Si-Ge- or an Fe-Si-based material is considered to be the most promising in terms of cost and the environment. Despite having a relatively high Seebeck coefficient, however, an Fe-Si-based material has high electrical resistance, and its performance index (ZT) is 0.2 or less, so it does not necessarily meet the requirements of a thermoelectric conversion material.

With an Si-Ge-based material, the germanium content is 20 to 30 at%, and the cost of germanium is high. Also, the germanium tends to be segregated, making it difficult to make a uniform material, and in terms of characteristics, the Seebeck coefficient is high at high temperatures, and while the thermal conductivity is low, the electrical resistance is high, so the performance index (ZT) is 1.0 at 1200K, and therefore an Si-Ge-based material does not necessarily meet the requirements of a thermoelectric conversion material, either.

In principle, the Seebeck coefficient of a thermoelectric conversion material is determined by the temperature differential when one end of a thermoelectric conversion material is heated to a high temperature and the other end cooled to a low temperature. Research into these thermoelectric conversion materials has centered around semiconductors and intermetallic compounds that exhibit semiconductor characteristics.

The reasons for this are that thermal conductivity is kept lower than with a metal or semi-metal, there is a certain amount of size to the band gap, it is easy to obtain a high energy state density at the donor or acceptor level in the band gap by adding various types of dopants, and a high Seebeck coefficient can be obtained.

As to the optimal conditions for the performance index related to a thermoelectric semiconductor, Ioffe (A.F. Ioffe: Semiconductor Thermoelements and Thermoelectric Cooling, London, Infosearch Ltd., 1957) showed $\alpha$, $\rho$, and $\kappa$ for a nondegenerative semiconductor in the form of the following Formulas 2, 3, and 4 as functions of the carrier concentration (n).

$$\alpha=\pm\frac{k_B}{e}\left[r+2+ln\frac{2(2\pi m^*k_BT)^{3/2}}{h^3n}\right] \qquad \text{Formula 2}$$

$$\rho = en\mu \qquad \text{Formula 3}$$

$$\kappa = \kappa_{el} + \kappa_{ph} = LT\rho + \kappa_{ph} \qquad \text{Formula 4}$$

Meanwhile, the Seebeck coefficient when the band is degenerated, as with a metal or semi-metal, is determined as in Formula 5 by free electron approximation (A.H. Wilson: The Theory of Metals, New York, 7, Cambridge Univ. Press, 2nd ed., p. 264).

$$\alpha = \frac{8\pi^2 k_B{}^2 T}{3eh^2} m^* \left(\frac{\pi}{3n}\right)^{2/3} \qquad \text{Formula 5}$$

Here, h is Planck's constant, $k_B$ is Boltzmann's constant, n is the carrier concentration, $\mu$ is the mobility, e is the electrical charge, m* is the effective mass of the carrier, r is a factor dependent on the diffusion mechanism of the carrier, and L is Lorentz's number.

Figure 1 is a graphic representation of the Seebeck coefficient ($\alpha$), the electrical conductivity ($\rho$), and the thermal conductivity ($\kappa$) on the basis of these theories. $\alpha$ is the inverse log of the carrier concentration n, and decreases as n increases. The electrical conductivity is proportional to n, and increases along with n.

As expressed by Formula 4, $\kappa$ is given by the sum of the phonon conduction $\kappa_{ph}$ and the carrier conduction $\kappa_{el}$. The phonon conduction is dominant and $\kappa$ remains more or less constant with respect to the carrier concentration when n is $10^{19}$ (M/m$^3$) or less, but when n is greater than or equal to $10^{19}$ (M/m$^3$), $\kappa$ increases gradually along with n. Thus, it has been said that the maximum performance index (Z) is somewhere around n = $5 \times 10^{19}$ (M/m$^3$).

DISCLOSURE OF THE INVENTION

The above theories are indeed correct when the carrier concentration is low. The inventors, however, wondered whether an electron correlation or hole correlation is at work between the electrons or holes that are the carriers, and conversely whether the energy state density of the carrier is higher though the segregation of the carriers in the semiconductor, when the carrier reaches a certain concentration. In other words, even though the carrier concentration increased up to a specific density, electrical resistance continued to decrease, but the inventors thought that the Seebeck coefficient might increase sharply at a certain carrier concentration, which would result in a marked increase in the performance index.

Thereupon, the inventors learned that adding various elements to silicon alone causes the Seebeck coefficient to be equivalent or higher on the basis of the above assumption, and far higher at a specific carrier concentration, compared to the Si-Ge and Fe-Si systems known in the past, and confirmed the validity of the above assumption through various experiments, without losing the fundamental advantages had by silicon alone.

Also, since silicon is the primary component, the cost can would be far lower than with an Si-Ge system containing expensive germanium in an amount of 20 to 30 at%, which would further enhance the feasibility of practical application.

Furthermore, it was thought that the use of silicon as the primary component would make it easy to obtain stable product quality even with a conventional manufacturing method such as arc melting.

On the basis of the above-mentioned findings and assumptions of the inventors, it is an object of the present invention to provide a thermoelectric conversion material that is inexpensive, has stable quality, and can be obtained with good productivity, and that is composed of a p-type semiconductor or n-type semiconductor in which silicon has been doped with various dopants, and to provide a novel silicon-based thermoelectric conversion material that has an even higher performance index.

On the basis of their assumptions, the inventors produced p-type semiconductor and n-type semiconductor by adding various dopants to silicon having a diamond-type crystal structure, and examined the relation between the doping amounts thereof and the thermoelectric characteristics, and as a result learned that while the Seebeck coefficient decreases along with the doping amount, that is, with the carrier concentration, up to $10^{18}$ (M/m$^3$), the maximum is attained from $10^{18}$ to $10^{19}$ (M/m$^3$), as shown in Figures 4 and 5. Further investigation revealed that with a silicon system the performance index shows a maximum value when the above-mentioned carrier concentration is between $10^{19}$ and $10^{21}$ (M/m$^3$), which confirmed the validity of the assumptions of the inventors and perfected the present invention.

First of all, the inventors selected a dopant A (Be, Mg, Ca, Sr, Ba, Zn, Cd, Hg, B, Al, Ga, In, Tl) as the dopant for making a p-type semiconductor, selected a dopant B (N, P, As, Sb, Bi, O, S, Se, Te) as the dopant for making an n-type semiconductor, and examined the relation between the doping amounts thereof and the thermoelectric characteristics.

The inventors learned by experimentation that, as mentioned above, the Seebeck coefficient decreases as the carrier concentration increases up to $10^{18}$ (M/$m^3$), but is extremely high from $10^{18}$ to $10^{19}$ (M/$m^3$).

The following are possible causes of this extremely large Seebeck coefficient. The Seebeck coefficient of a semiconductor is said to be a function of the size of the band gap between the valence band and the conduction band, and when acceptors or donors are added to this, the acceptors form holes over the valence band, and the donors form an impurity level having electrons under the conduction band.

Figure 2 shows the band structure of a semiconductor with few carriers, and although there is a single level as long as there are few carriers, these levels form a band having a certain amount of width as the number of carriers increases, as shown in Figure 3. As a result, the band gap is smaller and the Seebeck coefficient is lower. C.b. in the figure is the conduction band, V.b. is the valence band, and Eg is the energy gap.

It is believed, however, that what happened is that when the carrier concentration reached a certain point, the level at which there was a band shape for the acceptors and donors locally degenerated into a valence band and conduction band, the energy state density dropped in this portion, and the Seebeck coefficient increased.

Meanwhile, the electrical conductivity ($\rho$) increased along with n, as shown in Figures 6 and 7. It is believed that $\rho$ increased proportionally to the carrier concentration, regardless of band degeneration.

As to thermal conductivity, it decreased as the carrier concentration increased, as shown in Figures 8 and 9. Figure 1 tells us that $\kappa$ was more or less constant at $10^{19}$ (M/$m^3$) or lower, and increased along with the carrier concentration, but in the case of a silicon semiconductor, as the dopant concentration increased and the carrier concentration rose, the thermal conductivity decreased. This seems to be because $\kappa_{ph}$ was decreased by local phonon scattering of impurities due to the dopants in the crystals.

In short, the inventors discovered a novel Si-based, high-efficiency thermoelectric conversion material of a p-type semiconductor or n-type semiconductor in which the electrical resistance is lowered, the Seebeck coefficient is raised, and the performance index is markedly enhanced, without losing the inherent advantages of silicon alone, by adding various impurities to silicon, that is, to a silicon semiconductor having a diamond-type crystal structure, and adjusting the carrier concentration.

Here, if we consider the applications of thermoelectric conversion materials, the conditions that vary with the application in question, such as the heat source, where the material will be used, its shape, and the amount of current and voltage that it can handle, require that emphasis be placed on one of the characteristics, such as the Seebeck coefficient, the electrical conductivity, or the thermal conductivity, but the thermoelectric conversion material of the present invention allows the carrier concentration to be specified by using the doping amounts of the selected elements.

For instance, if the elements of the above-mentioned dopant A (either singly or in combination) are contained in an amount of 0.001 to 0.5 at%, a p-type semiconductor whose carrier concentration is $10^{17}$ to $10^{20}$ (M/$m^3$) will be obtained, but if dopant A is contained in an amount of 0.5 to 5.0 at%, a p-type semiconductor whose carrier concentration is $10^{19}$ to $10^{21}$ (M/$m^3$) will be obtained.

Similarly, if the elements of the above-mentioned dopant B (either singly or in combination) are contained in an amount of 0.001 to 0.5 at%, an n-type semiconductor whose carrier concentration is $10^{17}$ to $10^{20}$ (M/$m^3$) will be obtained, but if dopant B is contained in an amount of 0.5 to 10 at%, an n-type semiconductor whose carrier concentration is $10^{19}$ to $10^{21}$ (M/$m^3$) will be obtained.

When the elements of the above-mentioned dopant A or dopant B are contained, and when they are added in an amount of 0.5 to 5.0 at% so that the carrier concentration will be $10^{19}$ to $10^{21}$ (M/$m^3$), a highly efficient thermoelectric conversion element is obtained, which has excellent thermoelectric conversion efficiency, but the thermal conductivity thereof is about 50 to 150 W/m • K at room temperature, and if the thermal conductivity could be reduced, it should be possible to enhance the performance index ZT even further.

In general, the thermal conductivity of a solid is given by the sum of conduction by phonons and conduction by carriers. In the case of a thermoelectric conversion material of an Si-based semiconductor, conduction by phonons is dominant because of the low carrier concentration. Thus, to lower the thermal conductivity, the absorption or scattering of phonons must be increased. Disrupting the regularity of the grain size or crystal structure is effective in order to increase the absorption or scattering of phonons.

In view of this, the inventors investigated various dopants to silicon, and as a result discovered that by adding at least one type of Group 3 element and at least one type of Group 5 element, and thereby controlling the carrier concentration to a range of $10^{19}$ to $10^{21}$ (M/$m^3$), it is possible to disrupt the crystal structure without changing the carrier concentration in the silicon, allowing the thermal conductivity to be decreased 30 to 90% to no more than 150 W/m • K at room temperature, and yielding a highly efficient thermoelectric conversion material.

The inventors also discovered that with a thermoelectric conversion material of the above structure, a p-type semiconductor will be obtained if the Group 3 elements are contained in an amount of 0.3 to 5 at% greater than that of the Group 5 elements, and that an n-type semiconductor will be obtained if the Group 5 elements are contained in an amount of 0.3 to 5 at% greater than that of the Group 3 elements.

The inventors further investigated whether a reduction in thermal conductivity could be achieved with something other than Group 3 or Group 5 elements, whereupon they discovered that by adding a Group 3-5 compound semiconductor or a Group 2-6 compound semiconductor to silicon, and further adding at least one type of Group 3 element or Group 5 element and controlling the carrier concentration to a range of $10^{19}$ to $10^{21}$ ($M/m^3$), it is possible to disrupt the crystal structure without changing the carrier concentration in the silicon, so the thermal conductivity can be kept to 150 W/m • K or less at room temperature, and a highly efficient thermoelectric conversion material can be obtained.

The inventors also investigated various other dopants to silicon, and as a result learned that if the Group 4 elements of germanium, carbon, and tin are contained in silicon in an amount of 0.1 to 5 at%, and part of the elemental silicon is substituted with a Group 4 element with a different atomic weight, there will be greater scattering of phonons in the crystals, and it will be possible to decrease the thermal conductivity of the semiconductor by 20 to 90% and keep it under 150 W/m • K at room temperature, and that a thermoelectric conversion material will be obtained in the form of a p-type semiconductor when a Group 3 element is contained in an amount of 0.1 to 5.0 at%, while a thermoelectric conversion material will be obtained in the form of an n-type semiconductor when a Group 5 element is contained in an amount of 0.1 to 10 at%.

The inventors checked to see if elements other than the above-mentioned Group 3 elements and Group 5 elements could be similarly added to silicon in the thermoelectric conversion material of the present invention, which confirmed that while there are no particular restrictions as long as the result is a p-type or n-type semiconductor, if elements whose ion radii are too different are added, almost all of them will precipitate in the grain boundary phase, so it is preferable to use elements whose ion radii are relatively close to that of silicon, and it is particularly effective to use elements from the following groups, either singly or in combination, as the dopant $\alpha$ used to made a p-type semiconductor and as the dopant $\beta$ used to make an n-type semiconductor.

Dopant $\alpha$ comprises the groups of dopant A (Be, Mg, Ca, Sr, Ba, Zn, Cd, Hg, B, Al, Ga, In, Tl) and transition metal elements $M_1$ ($M_1$; Y, Mo, Zr), while dopant $\beta$ comprises the groups of dopant B (N, P, As, Sb, Bi, O, S, Se, Te), transition metal elements $M_2$ ($M_2$; Ti, V, Cr, Mn, Fe, Co, Ni, Cu, Nb, Ru, Rh, Pd, Ag, Hf, Ta, W, Re, Os, Ir, Pt, Au; where Fe accounts for 10 at% or less), and rare earth elements RE (RE; La, Ce, Pr, Nd, Pm, Sm, Eu, Gd, Tb, Dy, Ho, Er, Yb, Lu).

The inventors also learned that if at least one dopant $\alpha$ used to make a p-type semiconductor and at least one dopant $\beta$ used to make an n-type semiconductor are contained in a total amount of 0.002 to 20 at%, and, to obtain a p-type semiconductor, for example, the total amount of dopants $\alpha$ exceeds that of the dopants $\beta$ and the dopants $\alpha$ are contained in just the amount required to produce a p-type semiconductor, then the exact combination of the different dopant groups can be selected as desired.

The inventors next examined the basic structure of the thermoelectric conversion material of the present invention.

Obtaining a thermoelectric conversion material with a high performance index was considered extremely difficult with a heterogeneous semiconductor crystal texture since the Seebeck coefficient was correlated to electrical resistivity under the conventional semiconductor thermoelectric theory.

Accordingly, researchers in recent years have sought a way to increase the Seebeck coefficient and lower electrical resistivity by giving the crystals a super-lattice structure by vacuum vapor deposition, PVD, or another such method, but practical application remains problematic in terms of cost and thermal stability. Another drawback is a lower thermoelectromotive force, since a large temperature gradient cannot be achieved with a thin-film thermoelectric element such as this.

A method in which metal microparticles are grown prismatically in a semiconductor by vacuum vapor deposition, PVD, or another such method so that a metal phase and a semiconductor phase are both present has also been proposed (Japanese Laid-Open Patent Application H5-102535) in an effort to realize a large temperature gradient without sacrificing the high Seebeck coefficient inherent to silicon. However, because the metal phase extends and is linked in the direction of the temperature gradient, the thermoelectromotive force generated in the semiconductor causes the electrons or holes in the metal phase to work so as to cancel out this thermoelectromotive force, the result of which is a marked drop in the performance index ZT.

Specifically, while a silicon semiconductor does have a high Seebeck coefficient, its thermal conductivity and electrical resistivity are both high as well, creating the problem of how to lower the thermal conductivity and electrical resistivity so it can be utilized as a thermoelectric conversion material.

As to thermal conductivity, it is well known that creating a solid solution of different elements greatly lowers the thermal conductivity in a semiconductor based on Si-Ge or InAs-GeAs ("Thermoelectric Semiconductors and Their Applications," by Kinichi Uemura and Isao Nishida).

Meanwhile, as to electrical resistivity, adding a Group 3 element or a Group 5 element to silicon results in a p-type or n-type semiconductor and lowers the electrical resistivity, but the problem is that the Seebeck coefficient decreases at the same time. This phenomenon is an unavoidable problem, no matter which elements are added, as long as the semiconductor is a heterogeneous solid solution.

In view of this, the inventors investigated material textures and manufacturing methods in an effort to achieve better thermoelectric conversion efficiency by realizing lower electrical resistivity and lower thermal conductivity in the silicon-based thermoelectric conversion material of the present invention, and came to the conclusion that the above problems could be solved by creating a metal conduction grain boundary phase that is discontinuous with the very fine semiconductor crystal grain phase in the semiconductor bulk. The term "metal conduction grain boundary phase" as used here is a metal phase or semi-metal phase that undergoes a Mott transition and has a carrier concentration of at least $10^{18}$ ($M/m^3$).

Furthermore, the inventors realized that the semiconductor phase and the metal conduction grain boundary phase are indistinct with a powder metallurgy process because dopants are present in a large quantity in the semiconductor crystal grains after sintering, and that the electrical resistivity of the semiconductor phase decreases and even the Seebeck coefficient of the semiconductor phase is markedly Lowered. They therefore conducted an investigation aimed at allowing the semiconductor crystal grain phase to be separated from the metal conduction grain boundary phase by arc melting.

In order to lower the thermal conductivity of a silicon semiconductor, the inventors added Group 2 and 3 elements to silicon alone with a p-type semiconductor, and added Group 5 and 6 elements to silicon alone with an n-type semiconductor, after which each was arc melted in an argon atmosphere, immediately after which each was quenched by being held down from above with a chiller, which produced thermoelectric conversion materials having fine crystal grains with an average diameter of 0.1 to 5 μm. The thermal conductivity of these materials was examined, which revealed that the thermal conductivity of the quenched thermoelectric conversion material after arc melting was much lower than that of a thermoelectric conversion material that had not been quenched.

The inventors also variously investigated the electrical resistivity of thermoelectric conversion materials that had been quenched after arc melting and to which various elements had been added. As a result, it was learned that there was almost no dopant precipitation at the grain boundary in silicon semiconductor bulk, and the electrical resistivity was therefore high, when the total amount of the various elements added to silicon alone was less than 0.1 at%, but when this amount exceeding 0.1 at%, some of the dopants began to precipitate at the grain boundary, and at 1.0 at% this precipitation effect markedly lowered electrical resistivity.

The inventors investigated various methods for lowering the thermal conductivity of ingots after they were produced, in addition to the improvement resulting from the above-mentioned quenching method, and as a result learned that thermal conductivity can be greatly lowered by making the bulk semiconductor porous, or by further reducing the grain diameter of the semiconductor.

Specifically, lower electrical resistivity and thermal conductivity can be achieved and a thermoelectric conversion material with high thermoelectric conversion efficiency can be obtained by melting a dopant A for making a p-type or n-type semiconductor such that it is contained, either singly or in combination, in an amount of 0.5 to 10 at% in silicon; cooling this melt to obtain an ingot, ribbon, flakes, or other such semiconductor material, pulverizing this product into a powder of the required particle size, and hot-pressing this powder into a porous semiconductor material with a porosity of 5 to 40%.

Also, lower electrical resistivity and thermal conductivity can be achieved and a thermoelectric conversion material with high thermoelectric conversion efficiency and a reduced grain size (average grain diameter of 0.1 to 5.0 μm) can be obtained by melting a dopant for making a p-type or n-type semiconductor such that it is contained, either singly or in combination, in an amount of 0.5 to 10 at% in silicon, cooling this melt to obtain an ingot, ribbon, flakes, or other such semiconductor material, pulverizing this product into a powder of the required particle size, subjecting this powder to microcrystallization by mechanical alloying, and then subjecting it to low-temperature hot pressing to change it into a porous semiconductor material with a porosity of 5 to 40%.

The inventors investigated various doping methods in which silicon was doped with various elements for making a p-type or n-type semiconductor, and tried to keep the added amounts of dopants as close to the specified amounts as possible in order to obtain a highly efficient silicon-based thermoelectric conversion material in which the carrier concentration was from $10^{19}$ to $10^{21}$ ($M/m^3$). As a result, it was found that the melting point of the added compounds can be brought closer to the melting point of silicon, and compositional deviation minimized, by producing a compound of silicon and dopants ahead of time, and adding to silicon alone and melting in the form of a compound.

Furthermore, the inventors learned that the carrier concentration can be controlled more uniformly and more precisely by melting a silicon-based compound such as $Al_4Si$, $B_4Si$, $Mg_2Si$, $Ba_2Si$, SiP, $SiO_2$, $SiS_2$, or $Si_3N_4$ in the doping of Group 3 elements such as B, Al, Ga, In, and Tl and Group 5 elements such as N, P As, Sb, and Bi, or Group 2 elements such as Be, Mg, Ca, Sr, and Ba, Group 2B elements such as Zn, Cd, and Hg, and Group 6 elements such as O, S, Se, Te, and Po, for example, as the dopants used to control the carrier concentration in the silicon semiconductor. The inventors investigated whether a silicon raw material with even lower purity could be used, and as a result found that even a raw material with a purity of 3N could be used satisfactorily, and thereupon perfected the present invention.

BRIEF DESCRIPTION OF THE DRAWINGS

Figs. 1A and 1B are graphs of the relation between thermoelectric conversion characteristics and carrier concentration according to the theory of Ioffe;
Fig. 2 consists of diagrams illustrating the band structure of a semiconductor with few carriers, with Fig. 2A showing a p-type semiconductor and Fig. 2B an n-type semiconductor;
Fig. 3 consists of diagrams illustrating the band structure of a semiconductor with many carriers, with Fig. 3A showing a p-type semiconductor and Fig. 3B an n-type semiconductor;
Figs. 4 and 5 are graphs of the relation between carrier concentration and Seebeck coefficient;
Figs. 6 and 7 are graphs of the relation between carrier concentration and electrical conductivity;
Figs. 8 and 9 are graphs of the relation between carrier concentration and thermal conductivity;
Figs. 10 and 11 are graphs of the relation between carrier concentration and performance index;
Fig. 12A is a diagrammatic representation of the crystal texture in the semiconductor of the present invention, which has been quenched after arc melting, and Fig. 12B is a diagrammatic representation of the crystal texture in a semiconductor not quenched after arc melting;
Fig. 13 is a diagram of an example of the cooling after arc melting;
Fig. 14 consists of sectional XMA analysis photograph drawings (magnified 100 times) illustrating the crystal texture in a semiconductor not quenched after arc melting, where Fig. 14A shows no addition, Fig. 14B shows a p-type semiconductor to which aluminum was added in an amount of 1.0 wt%, and Fig. 14C shows a p-type semiconductor to which aluminum was added in an amount of 3.0 wt%;
Fig. 15 consists of sectional XMA analysis photograph drawings (magnified 100 times) illustrating the crystal texture in the semiconductor of the present invention, which was quenched after arc melting, where Fig. 15A shows no addition, Fig. 15B shows a p-type semiconductor to which aluminum was added in an amount of 1.0 wt%, and Fig. 15C shows a p-type semiconductor to which aluminum was added in an amount of 3.0 wt%;
Fig. 16 consists of sectional XMA analysis photograph drawings (magnified 100 times) illustrating the crystal texture in the semiconductor of the present invention, which was not quenched after arc melting, where Fig. 16A shows no addition, Fig. 16B shows a p-type semiconductor to which aluminum was added in an amount of 1.0 wt%, and Fig. 16C shows a p-type semiconductor to which aluminum was added in an amount of 3.0 wt%; and
Fig. 17 consists of sectional XMA analysis photograph drawings (magnified 100 times) illustrating the crystal texture in the semiconductor of the present invention, which was quenched after arc melting, where Fig. 17A shows no addition, Fig. 17B shows a p-type semiconductor to which phosphorus was added in an amount of 1.0 wt%, and Fig. 17C shows a p-type semiconductor to which phosphorus was added in an amount of 3.0 wt%.

BEST MODE FOR CARRYING OUT THE INVENTION

General composition

In the present invention, the elements added to the p-type semiconductor are dopants A (Be, Mg, Ca, Sr, Ba, Zn, Cd, Hg, B, Al, Ga, In, Tl). The carrier concentration can be adjusted and the Seebeck coefficient increased through the addition of these, either singly or in combination.

When the electrical conductivity is reduced and thermal conductivity is also sufficiently reduced by addition of these elements, either singly or in combination, it is preferable for the carrier concentration to be from $10^{17}$ to $10^{20}$ ($M/m^3$), and a suitable doping amount is 0.001 to 0.5 at%.

In the case of a p-type semiconductor, if the above-mentioned amount in which the elements are added is less than 0.001 at%, the carrier concentration will be less than $10^{17}$ ($M/m^3$) and electrical conductivity will be too low, so the Seebeck coefficient will also be low, and therefore there will be no increase in the performance index. If this doping amount is over 0.5 at%, however, the material will be unsuitable for the intended applications, the dopants will not be partially substituted with silicon atoms in the crystals, and another crystal phase will precipitate, decreasing the Seebeck coefficient. Consequently, to obtain a high Seebeck coefficient, the amount in which these elements are added should be from 0.001 to 0.5 at%.

When the Seebeck coefficient is increased by emphasizing a reduction in electrical conductivity with a p-type semiconductor, it is preferable for the carrier concentration to be from $10^{19}$ to $10^{21}$ ($M/m^3$), and a suitable doping amount is 0.5 to 5.0 at%. If the above-mentioned amount in which the elements are added is less than 0.5 at%, the carrier concentration will be less than $10^{19}$ ($M/m^3$), electrical resistivity will not decrease by much, and the Seebeck coefficient will also be low, so there will be no increase in the performance index. If this doping amount is over 5.0 at%, however, the dopants will not be partially substituted with silicon atoms in the crystals, and another crystal phase will precipitate, decreasing the Seebeck coefficient. Consequently, to obtain a high Seebeck coefficient, the amount in which these elements are added should be from 0.5 to 5.0 at%.

Meanwhile, the elements added to the n-type semiconductor are dopants B (N, P, As, Sb, Bi, O, S, Se, Te). The carrier concentration can be adjusted and the Seebeck coefficient increased though the addition of these, either singly or in combination. When the electrical conductivity is reduced and thermal conductivity is also sufficiently reduced by addition of these elements, either singly or in combination, it is preferable for the carrier concentration to be from $10^{17}$ to $10^{20}$ ($M/m^3$), and a suitable doping amount is 0.001 to 0.5 at%.

In the case of an n-type semiconductor, if the above-mentioned amount in which the elements are added is less than 0.001 at%, the carrier concentration will be less than $10^{17}$ ($M/m^3$), electrical resistivity will not decrease by much, and the Seebeck coefficient will also be low, so there will be no increase in the performance index. If this doping amount is over 0.5 at%, however, the material will be unsuitable for the intended applications, the dopants will not be partially substituted with silicon atoms in the crystals, and another crystal phase will precipitate, decreasing the Seebeck coefficient. Consequently, to obtain a high Seebeck coefficient, the amount in which these elements are added should be from 0.001 to 0.5 at%.

When the Seebeck coefficient is increased by emphasizing a reduction in electrical conductivity with an n-type semiconductor, it is preferable for the carrier concentration to be from $10^{19}$ to $10^{21}$ ($M/m^3$), and a suitable doping amount is 0.5 to 10 at%. If the above-mentioned amount in which the elements are added is less than 0.5 at%, the carrier concentration will be less than $10^{19}$ ($M/m^3$), electrical resistivity will not decrease by much, and the Seebeck coefficient will also be low, so there will be no increase in the performance index. If this doping amount is over 10.0 at%, however, the dopants will not be partially substituted with silicon atoms in the crystals, and another crystal phase will precipitate, decreasing the Seebeck coefficient. Consequently, to obtain a high Seebeck coefficient, the amount in which these elements are added should be from 0.5 to 10.0 at%.

Composition Reduction in thermal conductivity

With the present invention, when the goal is to lower the thermal conductivity of the above-mentioned material to 150 W/m • K or less at room temperature; further increase the performance index ZT, and obtain a highly efficient silicon-based thermoelectric conversion material, it is suitable for the dopants contained in the silicon to be Group 3 elements (B, Al, Ga, In, Tl) and Group 5 elements (N, P, As, Sb, Bi), and for a compound semiconductor to be a Group 3-5 compound semiconductor (AlP, AlAs, AlSb, GaN, GaP, GaAs, GaSb, InP, InAs, InSb, etc.) or a Group 2-6 compound semiconductor (ZnO, ZnS, ZnSe, ZnTe, CdS, CdO, CdSe, CdTe, *etc*.).

When silicon is simultaneously doped with a Group 3 element and a Group 5 element in the present invention, elements from each group can be added singly or in combination, making it possible to adjust the carrier concentration and increase the Seebeck coefficient. The dopants and the doping amounts thereof should be selected so that the carrier concentration is from $10^{19}$ to $10^{21}$ ($M/m^3$), and it is suitable for the total doping amount to be 1 to 20.0 at%.

When silicon is doped with at least one Group 3 element or Group 5 element and a Group 3-5 compound semiconductor or Group 2-6 compound semiconductor in the present invention, the dopants and the doping amounts thereof should be selected so that the carrier concentration is from $10^{19}$ to $10^{21}$ ($M/m^3$), with a suitable doping amount being 1 to 10 at% for the one or more Group 3 elements or Group 5 elements, and 1 to 10 at% for the Group 3-5 compound semiconductor or Group 2-6 compound semiconductor.

When a p-type semiconductor is obtained with the present invention, the doping amount of the Group 3 element should be 1 to 10 at% when used singly, or, when a Group 3 element and a Group 5 element are contained at the same time, the Group 3 element content should be 0.3 to 5 at% higher than that of the Group 5 element. If the Group 3 element content is less than 1 at%, the carrier concentration will be less than $10^{19}$ ($M/m^3$), electrical resistivity will not decrease by much, and the Seebeck coefficient will also be low, so there will be no increase in the performance index. Conversely, if the doping amount exceeds 10.0 at%, the dopant will not be partially substituted with silicon atoms in the crystals, and another crystal phase will precipitate, decreasing the Seebeck coefficient. Consequently, to obtain a high Seebeck coefficient, the amount in which these elements are added should be from 1 to 10.0 at%.

When an n-type semiconductor is obtained with the present invention, the doping amount of the Group 5 element should be 1 to 10 at% when used singly, or, when a Group 3 element and a Group 5 element are contained at the same time, the Group 5 element content should be 0.3 to 10 at% higher than that of the Group 3 element. If the Group 5 element content is less than 1 at%, the carrier concentration will be less than $10^{19}$ ($M/m^3$), electrical resistivity will not decrease by much, and the Seebeck coefficient will also be low, so there will be no increase in the performance index. Conversely, if the doping amount exceeds 10.0 at%, the dopant will not be partially substituted with silicon atoms in the crystals, and another crystal phase will precipitate, decreasing the Seebeck coefficient. Consequently, to obtain a high Seebeck coefficient, the amount in which these elements are added should be from 1 to 10.0 at%.

A suitable amount for a compound semiconductor to be added in the present invention is 1 to 10 at%. At less than 1 at%, the carrier concentration will be too low and electrical conductivity will decrease, but if 10.0 at% is exceeded, the carrier concentration will be too high and the Seebeck coefficient will decrease, and as a result the performance index will decrease if the doping amount is outside the range of 1 to 10 at%.

The method for reducing the thermal conductivity of the material to 150 W/m • K or lower at room temperature in the present invention involves substituting part of the elemental silicon with a Group 4 element having a different atomic weight. A suitable amount for the Group 4 element of Ge, C, or Sn to be contained in the silicon, whether added singly or in combination, is 0.1 to 5.0 at%. Segregation will be a problem and it will be difficult to produce the material uniformly if 5.0 at% is exceeded. A preferable range is 0.5 to 5.0 at%.

A Group 3 element (Sc, Y, La, Ce, Pr, Nd, Pm, Sm, Eu, Gd, Tb, Dy, Ho, Er, Tm, Yb, Lu, B, Al, Ga, In, Tl) can be added, either singly or in combination, as the element added to produce a p-type silicon semiconductor in the present invention, allowing the carrier concentration to be adjusted and the Seebeck coefficient to be increased. In the case of these elements, it is preferable for the carrier concentration to be from $10^{19}$ to $10^{21}$ ($M/m^3$), and a and a suitable doping amount is 0.1 to 5.0 at%.

In the case of a p-type semiconductor, if the amount in which the above-mentioned elements are added, either singly or in combination, is less than 0.1 at%, the carrier concentration will be less than $10^{19}$ ($M/m^3$), electrical resistivity will not decrease by much, and the Seebeck coefficient will also be low, so there will be no increase in the performance index. Conversely, if the doping amount exceeds 5.0 at%, the dopant will not be partially substituted with silicon atoms in the crystals, and another crystal phase will precipitate, decreasing the Seebeck coefficient. Consequently, to obtain a high Seebeck coefficient, the amount in which these elements are added should be from 0.1 to 5.0 at%.

Meanwhile, a Group 5 element (V, Nb, Ta, N, P, As, Sb, Bi) can be added, either singly or in combination, as the element added to produce an n-type silicon semiconductor, allowing the carrier concentration to be adjusted and the Seebeck coefficient to be increased. In the case of these elements, it is preferable for the carrier concentration to be from $10^{19}$ to $10^{21}$ ($M/m^3$), and a suitable doping amount is 0.1 to 10.0 at%.

In the case of an n-type semiconductor, if the amount in which the above-mentioned elements are added, either singly or in combination, is less than 0.5 at%, the carrier concentration will be less than $10^{19}$ ($M/m^3$), electrical resistivity will not decrease by much, and the Seebeck coefficient will also be low, so there will be no increase in the performance index. Conversely, if the doping amount exceeds 10.0 at%, the dopant will not be partially substituted with silicon atoms in the crystals, and another crystal phase will precipitate, decreasing the Seebeck coefficient. Consequently, to obtain a high Seebeck coefficient, the amount in which these elements are added should be from 0.5 to 10.0 at%.

Composition Dopants

With the present invention, in addition to the dopant A added to produce a p-type silicon semiconductor, it is also possible to adjust the carrier concentration by the addition of a transition metal element $M_1$ ($M_1$; Y, Mo, Zr), either singly or in combination. In the case of these elements, either singly or in combination, a suitable doping amount is 0.5 to 10.0 at% in order for the carrier concentration to be $10^{19}$ to $10^{21}$ ($M/m^3$).

In the case of a p-type semiconductor, if the above-mentioned amount in which the elements are added is less than 0.50 at%, the carrier concentration will be less than $10^{19}$ ($M/m^3$), electrical resistance and thermal conductivity will not decrease by much, and the Seebeck coefficient will also be low, so there will be no increase in the performance index. Also, if this doping amount is 0.50 to 10.0 at%, electrical resistance and thermal conductivity will both decrease, with the decrease in thermal conductivity being particularly large ($\kappa$ of silicon at room temperature: 148 (W/mK)), and the resulting performance index Z will be better than that with an Si-Ge system.

If this doping amount exceeds 10.0 at%, electrical resistance and thermal conductivity will decrease, but the Seebeck coefficient will also decrease at the same time, so the result is a lower performance index. This decrease in the Seebeck coefficient occurs because the dopant is not partially substituted with silicon atoms in the silicon crystals, and another crystal phase precipitates. Therefore, to obtain a high Seebeck coefficient, the amount in which these elements are added should be from 0.5 to 10.0 at%.

Meanwhile, in addition to dopant B that is added to produce an n-type silicon semiconductor, it is also possible to adjust the carrier concentration by the addition of a rare earth (La, Ce, Pr, Nd, Pm, Sm, Eu, Gd, Tb, Dy, Ho, Er, Yb, Lu) as the rare earth element RE, or transition metal elements $M_2$ a transition metal element $M_2$ (Ti, V, Cr, Mn, Fe, Co Ni, Cu, Nb, Ru, Rh, Pd, Ag, Hf, Ta, W, Re, Os, Ir, Pt, Au). These elements can be added singly, or a combination of different rare earth elements can be added, or a combination of different rare earth elements and a transition metal element can be added, or a combination of different transition metal elements and a rare earth element can be added.

When these elements are added, either singly or in combination, a doping amount of 0.5 to 10.0 at% is suitable in order for the carrier concentration to be $10^{19}$ to $10^{21}$ ($M/m^3$). In the case of an n-type semiconductor, if the doping amount is less than 0.5 at%, the carrier concentration will be less than $10^{19}$ ($M/m^3$), electrical resistance and thermal conductivity will not decrease by much, and the Seebeck coefficient will also be low, so there will be no increase in the performance index.

Also, if this doping amount is 0.5 to 10.0 at%, electrical resistance and thermal conductivity will both decrease, with the decrease in thermal conductivity being particularly large (κ of silicon at room temperature: 148 (W/mK)), and when a rare earth element (which is a heavy element) is added, there will be a sharp decrease in thermal conductivity as the doping amount increases, and the resulting performance index Z will be considerably higher than with an Si-Ge system.

Furthermore, if this doping amount exceeds 10 at%, electrical resistance and thermal conductivity will decrease, but the Seebeck coefficient will also decrease at the same time, so the result is a lower performance index. This decrease in the Seebeck coefficient occurs because the dopant is not partially substituted with silicon atoms in the silicon crystals, and another crystal phase precipitates. Therefore, to obtain a high Seebeck coefficient, the amount in which these elements are added should be from 0.5 to 10.0 at%.

Manufacturing method Quenching

Quenching is performed by the following method in the present invention, for example. Immediately after arc melting, as shown in Figure 13, a melting crucible 3 is set up for water-cooling by the installation of a cooling water pipe 4 in the thick part of the crucible, and the molten ingot inside this melting crucible 3 is quenched by being sandwiched between the water-cooled melting crucible 3 and a chiller 6 made of a metal with good thermal conductivity. This causes the molten ingot 5 to have a fine crystal diameter.

This thermoelectric conversion material of the present invention, whose main component is silicon, has a fine crystal grain size and has a metal grain boundary phase dispersed in it, and therefore electron or hole carriers move by hopping over this dispersed metal grain boundary phase and decrease the electrical resistivity, but contrary to the diffusion of grouped phonons such as heat, a small crystal grain size and the dispersal of the grain boundary phase cause grain boundary scattering to occur more easily and decrease thermal conductivity.

When there is no quenching after arc melting, however, as shown in Figure 12B, the diameter of the crystal particles increases, the metal or semi-metal crystal grain boundary phase 2 links up, and the carriers in the grain boundary phase 2 move so as to cancel out the thermoelectromotive force of the semiconductor phase generated by the temperature gradient, and this markedly lowers the Seebeck coefficient.

However, as shown in Figure 12A, if crystals are made finer by quenching and the metal or semi-metal crystal grain boundary phase is dispersed, electrical resistivity and thermal conductivity will decrease without the Seebeck coefficient decreasing too much, so a thermoelectric conversion material with good thermoelectric characteristics is obtained.

Figures 14 and 15 consist of sectional XMA analysis photograph drawings (magnified 100 times) illustrating the crystal texture in a semiconductor. Figures 14A and 15A show no addition, while Figures 14B and 15B show a p-type semiconductor to which aluminum was added in an amount of 1.0 wt%, and Figures 14C and 15C show a p-type semiconductor to which aluminum was added in an amount of 3.0 wt%. Quenching was not performed after arc melting in any of Figures 14, whereas quenching was performed after arc melting in Figures 15. Specifically, it can be clearly seen that when the required dopant is added and quenching is performed after arc melting, the crystals become finer and the metal or semi-metal grain boundary phase is dispersed, as shown in Figure 12A, which is a diagrammatic representation of the crystal texture in this semiconductor.

Figures 16 and 17 similarly consist of sectional XMA analysis photograph drawings (magnified 100 times). Figures 16A and 17A show no addition, while Figures 17B and 17B show an n-type semiconductor to which phosphorus was added in an amount of 1.0 wt%, and Figures 17C and 17C show an n-type semiconductor to which phosphorus was added in an amount of 3.0 wt%. Quenching was not performed after arc melting in any of Figures 16, whereas quenching was performed after arc melting in Figures 17. Specifically, it can be clearly seen that when the required dopant is added and quenching is performed after arc melting, the crystals become finer and the metal or semi-metal grain boundary phase is dispersed, as shown in Figure 12A, which is a diagrammatic representation of the crystal texture in this semiconductor.

In the present invention, the metal grain boundary phase will be excessively dispersed and electrical resistivity will rise if the average grain diameter of the thermoelectric conversion material is less than 0.1 μm, but if the average grain diameter is over 5 μm, then thermal conductivity will rise, so the average grain diameter is ideally from 0.1 to 5 μm.

Any known method can be employed for quenching the high-temperature molten ingot as long as the average grain diameter can be kept between 0.1 and 5 μm. The molten ingot may be cooled by rolling, or the melt may be cooled in the farm of a sheet between two rolls. Another method that may he employed is to splat-cool the melt in the form of a thin sheet or ribbon between two rolls to render all or part thereof amorphous, and then perform a heat treatment under conditions suitably selected such that the average grain diameter will be within the above range.

In the present invention, when a semiconductor in the form of a p-or n-type bulk material of silicon is created by a powder metallurgical method, because the silicon fines are extremely active and prone to oxidation, everything from pulverization to sintering must be carried out in a vacuum or an inert gas atmosphere, and this process is prohibitively expensive, so the above-mentioned melt quenching method is preferred.

In short, with the above technique, by quenching a molten ingot comprising various elements added to silicon, the crystal grain phase in the semiconductor bulk is made into p- and n-type semiconductor phases, and the grain boundary phase is made into a metal or semi-metal semiconductor phase, allowing electrical resistivity and thermal conductivity to be lowered without adversely affecting the Seebeck coefficient of the semiconductor phase, and allowing a highly efficient thermoelectric conversion material of a p-type semiconductor or n-type semiconductor to be obtained with markedly enhanced thermoelectric characteristics.

Manufacturing method Porous

Similarly, a method in which a bulk semiconductor is rendered porous or the grain size of the semiconductor is made smaller is a manufacturing method with which low electrical resistance and thermal conductivity are achieved, with the reduction in thermal conductivity being particularly good, and which yields a thermoelectric conversion material with high thermoelectric conversion efficiency.

In order to produce a p-type silicon semiconductor, the inventors melted a transition metal element and Group 2 and 3 elements such that the carrier concentration was $10^{17}$ to $10^{21}$ ($M/m^3$), either singly or in combination, coarsely ground the resulting ingot and subjected it to disk mill grinding and jet mill grinding, and then subjected the resulting powder to a hot press treatment under varying molding temperature and pressure conditions, and measured the thermoelectric conversion characteristics of the p-type semiconductor with controlled porosity produced thus produced.

With a p-type semiconductor doped with 3 at% aluminum, it was found that there is no major change in Seebeck coefficient or electrical resistance due to porosity up to a porosity of 40%, but thermal conductivity decreases greatly as porosity increases from 5%, and at a porosity of 40% thermal conductivity decreases to 44% of that of the hot-pressed article with a porosity of 2%.

With a p-type semiconductor, it was found that the thermal conductivity is almost the same as that of the ingot at a porosity of less than 5%, and when the porosity exceeds 40%, the Seebeck coefficient decreases and electrical resistance increases, the result of which is a decrease in the performance index. The porosity (X%) referred to here was determined from the formula (100 - Y) (%) from the relative density (Y%) of the hot-pressed article, letting the density of the ingot be 100%.

The above-mentioned p-type semiconductor ground powder was mechanically alloyed for an extended period in a ball mill and in an inert gas atmosphere, after which hot pressing was performed at varying molding pressures and temperatures and with the porosity substantially constant, which produced thermoelectric conversion materials of p-type semiconductors with different average grain diameters, and the thermoelectric conversion characteristics thereof were measured.

With a p-type semiconductor doped with 3 at% aluminum, it was found that there is no major change in Seebeck coefficient or electrical resistance due to average grain diameter up to an average grain diameter of less than 5 µm, but thermal conductivity decreases greatly as the average grain diameter becomes smaller, and at an average grain diameter of 0.1 µm, thermal conductivity decreases to 47% of that of an ingot with an average grain diameter of 8.4 µm.

However, it was found that when the average grain diameter of the p-type semiconductor drops below 0.1 µm, there is no change in the Seebeck coefficient, but electrical resistance increases, and this lowers the performance index. Consequently, to obtain a thermoelectric conversion material of a p-type semiconductor with a high performance index, either the porosity of the semiconductor must be from 5 to 40%, or the average grain diameter must be adjusted to between 0.1 and 5 µm.

Meanwhile, in order to produce an n-type silicon semiconductor, the inventors melted a rare earth element and Group 5 and 6 elements such that the carrier concentration was $10^{17}$ to $10^{21}$ ($M/m^3$), either singly or in combination, coarsely ground the resulting ingot and subjected it to disk mill grinding and jet mill grinding, and then subjected the resulting powder to a hot press treatment under varying molding temperature and pressure conditions, and measured the thermoelectric conversion characteristics of the n-type semiconductor with controlled porosity produced thus produced.

With an n-type semiconductor doped with 3 at% phosphorus, just as with the p-type semiconductor, it was found that there is no major change in Seebeck coefficient or electrical resistance due to porosity up to a porosity of 40%, but thermal conductivity decreases greatly as porosity increases from 5%, and at a porosity of 40% thermal conductivity decreases to 44% of that of the hot-pressed article with a porosity of 2%.

With an n-type semiconductor, it was found that the thermal conductivity is almost the same as that of the ingot at a porosity of less than 5%, and when the porosity exceeds 40%, the Seebeck coefficient decreases and electrical resistance increases, the result of which is a decrease in the performance index.

The above-mentioned n-type semiconductor ground powder was mechanically alloyed for an extended period in a ball mill and in an inert gas atmosphere, after which hot pressing was performed at varying molding pressures and temperatures and with the porosity substantially constant, which produced thermoelectric conversion materials of n-type semiconductors with different average grain diameters, and the thermoelectric conversion characteristics thereof were measured.

With an n-type semiconductor doped with 3 at% phosphorus, just as with the p-type semiconductor, it was found that there is no major change in Seebeck coefficient or electrical resistance due to average grain diameter up to an average grain diameter of less than 5 μm, but thermal conductivity decreases greatly as the average grain diameter becomes smaller, and at an average grain diameter of 0.1 μm, thermal conductivity decreases to 64% of that of an ingot with an average grain diameter of 8.6 μm.

However, it was found that when the average grain diameter of the n-type semiconductor drops below 0.1 μm, there is no change in the Seebeck coefficient, but electrical resistance increases, and this lowers the performance index. Consequently, to obtain a thermoelectric conversion material of an n-type semiconductor with a high performance index, either the porosity of the semiconductor must be from 5 to 40%, or the average grain diameter must be adjusted to between 0.1 and 5 μm.

The ground powder used in the present invention is a semiconductor material obtained by any of various methods, such as melting the materials in order to produce a silicon semiconductor and cooling the melt into an ingot, or molding the melt into a ribbon or thin sheet by quenching, or splat-cooling the melt to render all or part of it amorphous and then heat treating it such that the average grain diameter will be within the required range. The average particle size of the ground powder is preferably 1 to 5 μm. A known grinding method can be employed, such as the coarse grinding of an ingot, disk mill grinding, or jet mill grinding.

The hot pressing conditions in the present invention preferably comprise a temperature of 1000 to 1200°C and a pressure of 49 to 245 MP. If the temperature is below 1000°C, the porosity of the sinter will be over 40%, but if the temperature is over 1200°C, the average grain diameter will exceed 5 μm. The pressure should be suitably selected so as to attain the specified porosity and average grain diameter.

The mechanical alloying conditions in the present invention will vary with the mill rotation speed, mill diameter, and amount of balls added, but basically the mechanical alloying should be performed in an inert gas atmosphere; and such that the average grain diameter will be 0.1 μm or less.

Manufacturing method Doping

Silicon is doped with a variety of elements in the present invention to create a p- or n-type semiconductor, and as much as possible the dopants must be added in amounts that will result in the specified component proportions in order to obtain a highly efficient silicon-based thermoelectric conversion material in which the carrier concentration is $10^{17}$ to $10^{21}$ ($M/m^3$). Compositional deviation can be minimized by producing a compound of silicon and dopants ahead of time, and adding to silicon alone and melting in the form of a compound, so that the melting point of the added compound is closer to the melting point of silicon.

The carrier concentration can be controlled more uniformly and more precisely by melting a silicon-based compound such as $Al_4Si$, $B_4Si$, $Mg_2Si$, $Ba_2Si$, SiP, SiO2, $SiS_2$, or $Si_3N_4$ in the doping of Group 3 elements such as B, Al, Ga, In, and Tl and Group 5 elements such as N, P, As, Sb, and Bi, or Group 2 elements such as Be, Mg, Ca, Sr, and Ba, Group 2B elements such as Zn, Cd, and Hg, and Group 6 elements such as O, S, Se, Te, and Po, for example, as the dopants used to control the carrier concentration in the silicon semiconductor. Further investigation was conducted to find into whether a silicon raw material with even lower purity could be used, and as a result even a raw material with a purity of 3N could be used satisfactorily.

To summarize the above manufacturing method, after the above-mentioned composition is melted, the melt is quenched with a chiller, or the melt is splat-cooled with rotating rolls to render all or part of it amorphous, after which a heat treatment is performed, for example, and the melt is quenched. As a result, the crystal grains become finer and the metal grain boundary phase is dispersed. Electron or hole carriers move by hopping over this dispersed metal grain boundary phase and decrease the electrical resistivity, but contrary to the diffusion of grouped phonons such as heat, a small crystal grain size and the dispersal of the grain boundary phase cause grain boundary scattering to occur more easily and decrease thermal conductivity.

When no quenching is performed after arc melting, for example, the size of the crystal grains becomes larger, the metal or semi-metal grain boundary phase partially links up, and the carriers in the grain boundary phase move so as to cancel out the thermoelectromotive force of the semiconductor phase generated by the temperature gradient, and this markedly lowers the Seebeck coefficient.

However, if crystals are made finer by quenching and the metal or semi-metal crystal grain boundary phase is dispersed, electrical resistivity and thermal conductivity will decrease without the Seebeck coefficient decreasing too much, so a thermoelectric conversion material with good thermoelectric characteristics is obtained.

In the present invention, the metal grain boundary phase will be excessively dispersed and electrical resistivity will rise if the average grain diameter of the thermoelectric conversion material is less than 0.1 μm, but if the average grain diameter is over 5 μm, then thermal conductivity will rise, so the average grain diameter is ideally from 0.1 to 5 μm.

Meanwhile, as to the production of a complete solid solution of a thermoelectric conversion material, it is possible to obtain one with stable quality by arc melting and other methods used in the past with a silicon system, but with an Si-Ge system segregation occurs and a uniform material cannot be obtained, and production takes a long time. Powder metallurgy is therefore suitable, but the problem with powder metallurgy is that the powder is susceptible to oxidation, and quality tends to be unstable. This problem is not encountered with the silicon-based present invention.

Embodiments

Embodiment 1

To produce a p-type silicon thermoelectric semiconductor, high-purity silicon (10N) and a Group 3 element were compounded as shown in Table 1-1, after which they were arc melted in an argon gas atmosphere. The button-shaped ingots thus obtained were cut into sizes of 5 × 5 × 5 mm, 10 × 10 × 2 mm, and 10 mm diameter × 2 mm, and the Seebeck coefficient, Hall coefficient (including the carrier concentration and electrical conductivity), and thermal conductivity of each were measured.

The Seebeck coefficient was determined by setting the temperature differential between the high and low temperature portions to 6°C, using a digital multi-meter to measure the thermoelectromotive force of the p-type semiconductor at an average temperature of 200°C for the high and low temperature portions, and dividing this by the temperature differential (6°C).

The Hall coefficient was measured by AC method at 200°C, electrical resistance was measured by the four-terminal method at the same time as the carrier concentration, and electrical conductivity was determined from the inverse thereof. Thermal conductivity was measured at 200°C by laser flash method. These measurement results are given in Table 1-2 and Figures 4, 6, and 8, and the performance indexes calculated from these results are shown in Figure 10.

Embodiment 2

To produce an n-type silicon thermoelectric semiconductor, high-purity silicon (10N) and a Group 4 element were compounded as shown in Table 2-1, after which they were arc melted in an argon gas atmosphere. The button-shaped ingots thus obtained were cut into sizes of 5 × 5 × 5 mm, 10 × 10 × 2 mm, and 10 mm diameter × 2 mm, and the Seebeck coefficient, Hall coefficient (including the carrier concentration and electrical conductivity), and thermal conductivity of each were measured.

The Seebeck coefficient was determined by setting the temperature differential between the high and low temperature portions to 6°C, using a digital multi-meter to measure the thermoelectromotive force of the n-type semiconductor at an average temperature of 200°C for the high and low temperature portions, and dividing this by the temperature differential (6°C).

The Hall coefficient was measured by AC method at 200°C, electrical resistance was measured by the four-terminal method at the same time as the carrier concentration, and electrical conductivity was determined from the inverse thereof. Thermal conductivity was measured at 200°C by laser flash method. These measurement results are given in Table 2-2 and Figures 5, 7, and 9, and the performance indexes calculated from these results are shown in Figure 11.

Table 1-1

| No. | Dopant | Doping amount (at%) | Carrier concentration n ($M/m^3$) | Seebeck coefficient α (mV/K) |
|---|---|---|---|---|
| 1 | B | 0.001 | $3.70\times10^{17}$ | 0.8 |
| 2 | B | 0.003 | $1.40\times10^{18}$ | 0.6 |
| 3 | B | 0.01 | $5.20\times10^{18}$ | 0.4 |
| 4 | B | 0.03 | $1.50\times10^{19}$ | 0.31 |

Table 1-1 (continued)

| No. | Dopant | Doping amount (at%) | Carrier concentration n ($M/m^3$) | Seebeck coefficient α (mV/K) |
|---|---|---|---|---|
| 5 | B | 0.1 | $3.90\times10^{19}$ | 0.48 |
| 6 | B | 0.3 | $8.20\times10^{19}$ | 0.33 |
| 7 | B | 1 | $2.30\times10^{20}$ | 0.21 |
| 8 | Al | 0.001 | $2.96\times10^{17}$ | 0.64 |
| 9 | Al | 0.003 | $1.12\times10^{18}$ | 0.48 |
| 10 | Al | 0.01 | $4.16\times10^{18}$ | 0.32 |
| 11 | Al | 0.03 | $1.20\times10^{19}$ | 0.248 |
| 12 | Al | 0.1 | $3.12\times10^{19}$ | 0.384 |
| 13 | Al | 0.3 | $6.56\times10^{19}$ | 0.264 |
| 14 | Al | 1 | $1.84\times10^{20}$ | 0.168 |
| 15 | Ga | 0.001 | $1.85\times10^{17}$ | 0.96 |
| 16 | Ga | 0.003 | $7.00\times10^{17}$ | 0.72 |
| 17 | Ga | 0.01 | $2.60\times10^{18}$ | 0.48 |
| 18 | Ga | 0.03 | $7.50\times10^{18}$ | 0.372 |
| 19 | Ga | 0.1 | $1.95\times10^{19}$ | 0.576 |
| 20 | Ga | 0.3 | $4.10\times10^{19}$ | 0.396 |
| 21 | Ga | 1 | $1.15\times10^{20}$ | 0.252 |

Table 1-2

| No. | Dopant | Electrical conductivity ρ (S/m) | Thermal conductivity κ (W/m • K) | Performance index Z (l/K) |
|---|---|---|---|---|
| 1 | B | $2.128\times10^{3}$ | 97.6 | $1.40\times10^{-5}$ |
| 2 | B | $7.143\times10^{3}$ | 78.3 | $3.29\times10^{-5}$ |
| 3 | B | $1.282\times10^{4}$ | 59.2 | $3.46\times10^{-5}$ |
| 4 | B | $3.030\times10^{4}$ | 43.8 | $6.64\times10^{-5}$ |
| 5 | B | $7.692\times10^{4}$ | 33.0 | $5.37\times10^{-4}$ |
| 6 | B | $1.389\times10^{5}$ | 31.0 | $4.88\times10^{-4}$ |
| 7 | B | $2.222\times10^{5}$ | 33.0 | $2.97\times10^{-4}$ |
| 8 | Al | $1.064\times10^{3}$ | 119.3 | $3.65\times10^{-6}$ |
| 9 | Al | $3.571\times10^{3}$ | 107.3 | $7.67\times10^{-6}$ |
| 10 | Al | $6.410\times10^{3}$ | 95.4 | $6.88\times10^{-6}$ |
| 11 | Al | $1.515\times10^{4}$ | 85.8 | $1.09\times10^{-5}$ |
| 12 | Al | $3.846\times10^{4}$ | 77.1 | $7.35\times10^{-5}$ |
| 13 | Al | $6.944\times10^{4}$ | 75.0 | $6.45\times10^{-5}$ |
| 14 | Al | $1.111\times10^{5}$ | 77.0 | $4.07\times10^{-5}$ |
| 15 | Ga | $7.092\times10^{2}$ | 112.0 | $5.84\times10^{-6}$ |

Table 1-2 (continued)

| No. | Dopant | Electrical conductivity ρ (S/m) | Thermal conductivity κ (W/m • K) | Performance index Z (l/K) |
|---|---|---|---|---|
| 16 | Ga | $2.381\times10^{3}$ | 94.6 | $1.30\times10^{-5}$ |
| 17 | Ga | $4.274\times10^{3}$ | 77.6 | $1.27\times10^{-5}$ |
| 18 | Ga | $1.010\times10^{4}$ | 63.7 | $2.19\times10^{-5}$ |
| 19 | Ga | $2.564\times10^{4}$ | 51.3 | $1.66\times10^{-4}$ |
| 20 | Ga | $4.630\times10^{4}$ | 45.0 | $1.61\times10^{-4}$ |
| 21 | Ga | $7.407\times10^{4}$ | 43.0 | $1.09\times10^{-4}$ |

Table 2-1

| No. | Dopant | Doping amount (at%) | Carrier concentration n ($M/m^3$) | Seebeck coefficient α (mV/K) |
|---|---|---|---|---|
| 22 | P | 0.001 | $4.70\times10^{17}$ | -0.81 |
| 23 | P | 0.003 | $2.10\times10^{18}$ | -0.67 |
| 24 | P | 0.01 | $5.90\times10^{18}$ | -0.58 |
| 25 | P | 0.03 | $1.50\times10^{19}$ | -0.44 |
| 26 | P | 0.1 | $5.20\times10^{19}$ | -0.55 |
| 27 | P | 0.3 | $9.20\times10^{19}$ | -0.41 |
| 28 | P | 1 | $1.60\times10^{20}$ | -0.28 |
| 29 | Sb | 0.001 | $3.29\times10^{17}$ | -0.972 |
| 30 | Sb | 0.003 | $1.47\times10^{18}$ | -0.804 |
| 31 | Sb | 0.01 | $4.13\times10^{18}$ | -0.696 |
| 32 | Sb | 0.03 | $1.05\times10^{19}$ | -0.528 |
| 33 | Sb | 0.1 | $3.64\times10^{19}$ | -0.66 |
| 34 | Sb | 0.3 | $6.44\times10^{19}$ | -0.492 |
| 35 | Sb | 1 | $1.12\times10^{20}$ | -0.336 |
| 36 | Bi | 0.001 | $2.35\times10^{17}$ | -1.053 |
| 37 | Bi | 0.003 | $1.05\times10^{18}$ | -0.871 |
| 38 | Bi | 0.01 | $2.95\times10^{18}$ | -0.754 |
| 39 | Bi | 0.03 | $7.50\times10^{18}$ | -0.572 |
| 40 | Bi | 0.1 | $2.60\times10^{19}$ | -0.715 |
| 41 | Bi | 0.3 | $4.60\times10^{19}$ | -0.533 |
| 42 | Bi | 1 | $8.00\times10^{19}$ | -0.364 |

Table 2-2

| No. | Dopant | Electrical conductivity ρ (S/m) | Thermal conductivity κ (W/m-K) | Performance index Z (l/K) |
|---|---|---|---|---|
| 22 | P | $4.17\times10^{3}$ | 98.4 | $2.78\times10^{-5}$ |
| 23 | P | $1.03\times10^{4}$ | 78.3 | $5.91\times10^{-5}$ |
| 24 | P | $1.59\times10^{4}$ | 64.5 | $8.28\times10^{-5}$ |
| 25 | P | $3.03\times10^{4}$ | 52.0 | $1.13\times10^{-4}$ |
| 26 | P | $7.14\times10^{4}$ | 42.0 | $5.14\times10^{-4}$ |
| 27 | P | $1.01\times10^{5}$ | 42.0 | $4.04\times10^{-4}$ |
| 28 | P | $1.28\times10^{5}$ | 49.0 | $2.05\times10^{-4}$ |
| 29 | Sb | $2.08\times10^{3}$ | 107.5 | $1.83\times10^{-5}$ |
| 30 | Sb | $5.15\times10^{3}$ | 89.3 | $3.73\times10^{-5}$ |
| 31 | Sb | $7.94\times10^{3}$ | 76.8 | $5.01\times10^{-5}$ |
| 32 | Sb | $1.52\times10^{4}$ | 65.4 | $6.46\times10^{-5}$ |
| 33 | Sb | $3.57\times10^{4}$ | 52.0 | $2.99\times10^{-4}$ |
| 34 | Sb | $5.05\times10^{4}$ | 52.0 | $2.35\times10^{-4}$ |
| 35 | Sb | $6.41\times10^{4}$ | 57.0 | $1.27\times10^{-4}$ |
| 36 | Bi | $1.39\times10^{3}$ | 125.3 | $1.23\times10^{-5}$ |
| 37 | Bi | $3.44\times10^{3}$ | 113.6 | $2.29\times10^{-5}$ |
| 38 | Bi | $5.29\times10^{3}$ | 105.5 | $2.85\times10^{-5}$ |
| 39 | Bi | $1.01\times10^{4}$ | 98.2 | $3.36\times10^{-5}$ |
| 40 | Bi | $2.38\times10^{4}$ | 88.5 | $1.37\times10^{-4}$ |
| 41 | Bi | $3.37\times10^{4}$ | 87.0 | $1.10\times10^{-4}$ |
| 42 | Bi | $4.27\times10^{4}$ | 89.0 | $6.36\times10^{-5}$ |

Embodiment 3

To produce a p-type silicon semiconductor, high-purity single crystal silicon (10N) and the elements shown in Table 3-1 were measured out in the specified proportions and then arc melted in an argon gas atmosphere. The button-shaped ingots thus obtained were cut into sizes of 5 × 5 × 5 mm, 10 × 10 × 2 mm, and 10 mm outside diameter × 2 mm to produce samples for measuring the Seebeck coefficient, Hall coefficient (including the electrical resistance), and thermal conductivity of each.

The Seebeck coefficient was determined by setting the temperature differential between the high and low temperature portions to 6°C, using a digital multi-meter to measure the thermoelectromotive force of the p-type semiconductor at an average temperature of 200°C for the high and low temperature portions, and dividing this by the temperature differential (6°C). The Hall coefficient was measured by AC method at 200°C, and electrical resistance was also measured by the four-terminal method at that time. Thermal conductivity was measured at 200°C by laser flash method. These measurement results are given in Table 3-2.

Embodiment 4

To produce an n-type silicon semiconductor, high-purity single crystal silicon (10N) and the elements shown in Table 4-1 were measured out in the specified proportions and then arc melted in an argon gas atmosphere. The button-shaped ingots thus obtained were cut into sizes of 5 × 5 × 5 mm, 10 × 10 × 2 mm, and 10 mm outside diameter × 2 mm to produce samples for measuring the Seebeck coefficient, Hall coefficient (including the electrical resistance), and thermal conductivity of each. Nitrogen and oxygen were added by adding $Si_3N_4$ and $SiO_2$ before the arc melting.

The Seebeck coefficient was determined by setting the temperature differential between the high and low temperature portions to 6°C, using a digital multi-meter to measure the thermoelectromotive force of the n-type semiconductor at an average temperature of 200°C for the high and low temperature portions, and dividing this by the temperature differential (6°C). The Hall coefficient was measured by AC method at 200°C, and electrical resistance was also measured by the four-terminal method at that time. Thermal conductivity was measured at 200°C by laser flash method. These measurement results are given in Table 4-2.

Comparison

To produce n-type and p-type Si-Ge semiconductors, silicon and polycrystalline germanium (4N) were blended in an atomic ratio of 4:1, the elements shown as Nos. 19, 20, 40, and 41 in Tables 3-1, 3-2, 4-1, and 4-2 were measured out in the specified proportions, and [these components] were arc melted in an argon gas atmosphere. After melting, measurement samples were worked into the same shapes as in Embodiments 3 and 4, and the measurement conditions were also the same as in Embodiments 3 and 4.

As is clear from Tables 3-1, 3-2, 4-1, and 4-2, the performance index Z of the embodiments in which various elements were added to silicon alone (Nos. 1 to 18 and Nos. 21 to 39) was equal to or better than the performance index of the comparisons in which various elements were added to an Si-Ge system (Si:Ge = 4:1) (Nos. 19, 20, 40, and 41).

Furthermore, the performance index of the embodiments in which the added amounts of the dopants in Tables 3-1 and 3-2 were 0.5 to 5.0 at% and the carrier concentration was between $10^{19}$ to $10^{21}$ ($M/m^3$) was markedly higher than the performance index Z of Comparison Nos. 19 and 20. Similarly, it can be seen that the performance index of the embodiments in which the added amounts of the dopants in Tables 4-1 and 4-2 were 0.5 to 10.0 at% and the carrier concentration was between $10^{19}$ to $10^{20}$ ($M/m^3$) was far higher than the performance index of Comparison Not 40 arid 41.

In particular, it can be seen in Tables 3-1, 3-2, 4-1, and 4-2 that the Seebeck coefficient is higher, electrical resistance is lower, and the performance index is markedly higher the greater is the doping amount if the added amount of dopants is within the range of 0.5 to 5.0 at% in Table 3-1 and 0.5 to 10.0 at% in Table 4-1.

Table 3-1

| | No | Matrix | Dopant and added amount | | Carrier concentration (M/m³) |
|---|---|---|---|---|---|
| | | | Dopant | Added amount (at%) | |
| Embodiment 3 | 1 | Si | Zn | 0.10 | $1.1\times10^{19}$ |
| | 2 | Si | Zn | 0.50 | $5.4\times10^{19}$ |
| | 3 | Si | Zn | 1.0 | $7.3\times10^{19}$ |
| | 4 | Si | Zn | 3.0 | $1.6\times10^{21}$ |
| | 5 | Si | Zn | 5.0 | $4.2\times10^{21}$ |
| | 6 | Si | Zn | 7.0 | $8.3\times10^{21}$ |
| | 7 | Si | Cd | 1.0 | $5.3\times10^{19}$ |
| | 8 | Si | B | 3.0 | $8.0\times10^{20}$ |
| | 9 | Si | Al | 0.10 | $5.8\times10^{18}$ |
| | 10 | Si | Al | 0.50 | $2.9\times10^{19}$ |
| | 11 | Si | Al | 1.0 | $3.3\times10^{20}$ |
| | 12 | Si | Al | 5.0 | $2.0\times10^{21}$ |
| | 13 | Si | Al | 7.0 | $4.8\times10^{21}$ |
| | 14 | Si | Ga | 3.0 | $6.3\times10^{20}$ |
| | 15 | Si | In | 3.0 | $4.9\times10^{20}$ |
| | 16 | Si | Zn<br>Cd | 1.0<br>1.0 | $1.3\times10^{21}$ |
| | 17 | Si | Zn<br>Al | 1.0<br>2.0 | $1.8\times10^{21}$ |
| | 18 | Si | Al<br>Ga | 1.5<br>1.5 | $1.0\times10^{21}$ |
| Comparison | 19 | Si-Ge | Zn | 3.0 | $1.2\times10^{21}$ |
| | 20 | Si-Ge | Al | 3.0 | $1.1\times10^{21}$ |

Table 3-2

| | No | Thermoelectric resistance | | | |
|---|---|---|---|---|---|
| | | Seebeck coefficient α (mV/K) | Electrical resistance ρ (Ωm) | Thermal conductivity κ (W/mK) | Performance index Z (1/K) |
| Embodiment 3 | 1 | 0.52 | $3.67\times10^{-4}$ | 52.7 | $1.40\times10^{-5}$ |
| | 2 | 0.335 | $1.20\times10^{-5}$ | 54.3 | $1.72\times10^{-4}$ |
| | 3 | 0.242 | $6.7\times10^{-6}$ | 55.3 | $1.58\times10^{-4}$ |
| | 4 | 0.320 | $1.77\times10^{-6}$ | 57.3 | $1.01\times10^{-3}$ |
| | 5 | 0.293 | $2.06\times10^{-6}$ | 60 | $6.95\times10^{-4}$ |
| | 6 | 0.024 | $4.40\times10^{-7}$ | 65.3 | $2.00\times10^{-5}$ |
| | 7 | 0.253 | $1.27\times10^{-5}$ | 56 | $9.00\times10^{-5}$ |
| | 8 | 0.341 | $2.06\times10^{-6}$ | 58.3 | $9.68\times10^{-4}$ |
| | 9 | 0.493 | $8.33\times10^{-5}$ | 52 | $5.61\times10^{-5}$ |
| | 10 | 0.260 | $1.27\times10^{-5}$ | 54 | $9.86\times10^{-5}$ |
| | 11 | 0.195 | $4.37\times10^{-6}$ | 55.7 | $1.56\times10^{-4}$ |
| | 12 | 0.282 | $3.20\times10^{-6}$ | 62 | $4.01\times10^{-4}$ |
| | 13 | 0.010 | $3.60\times10^{-7}$ | 67.3 | $4.13\times10^{-6}$ |
| | 14 | 0.305 | $2.80\times10^{-6}$ | 61.7 | $5.38\times10^{-4}$ |
| | 15 | 0.314 | $2.36\times10^{-6}$ | 60.7 | $6.88\times10^{-4}$ |
| | 16 | 0.285 | $1.20\times10^{-6}$ | 57.7 | $1.17\times10^{-3}$ |
| | 17 | 0.310 | $3.03\times10^{-6}$ | 59.3 | $5.35\times10^{-4}$ |
| | 18 | 0.308 | $1.71\times10^{-6}$ | 60 | $9.24\times10^{-4}$ |
| Comparison | 19 | 0.213 | $6.2\times10^{-5}$ | 9.0 | $8.13\times10^{-5}$ |
| | 20 | 0.160 | $6.4\times10^{-5}$ | 5.6 | $7.14\times10^{-5}$ |

Table 4-1

| | No | Matrix | Dopant and added amount | | Carrier concentration ($M/m^3$) |
|---|---|---|---|---|---|
| | | | Dopant | Added amount (at%) | |
| Embodiment 4 | 21 | Si | P | 0.10 | $4.8\times10^{18}$ |
| | 22 | Si | P | 0.50 | $3.1\times10^{19}$ |
| | 23 | Si | P | 1.0 | $7.3\times10^{19}$ |
| | 24 | Si | P | 3.0 | $2.8\times10^{20}$ |
| | 25 | Si | P | 5.0 | $1.2\times10^{21}$ |
| | 26 | Si | P | 10.0 | $3.4\times10^{21}$ |
| | 27 | Si | P | 15.0 | $7.9\times10^{21}$ |
| | 28 | Si | Bi | 0.10 | $3.2\times10^{18}$ |
| | 29 | Si | Bi | 0.50 | $2.4\times10^{19}$ |
| | 30 | Si | Bi | 3.0 | $1.8\times10^{20}$ |
| | 31 | Si | Bi | 10.0 | $1.2\times10^{21}$ |
| | 32 | Si | Bi | 15.0 | $3.4\times10^{21}$ |
| | 33 | Si | N | 3.0 | $1.3\times10^{20}$ |
| | 34 | Si | Sb | 3.0 | $2.4\times10^{20}$ |
| | 35 | Si | Bi | 3.0 | $2.7\times10^{20}$ |
| | 36 | Si | O | 3.0 | $1.2\times10^{20}$ |
| | 37 | Si | S | 3.0 | $2.6\times10^{20}$ |
| | 38 | Si | P<br>Sb | 1.5<br>1.5 | $2.7\times10^{20}$ |
| | 39 | Si | P<br>Bi | 1.0<br>2.0 | $2.4\times10^{20}$ |
| Comparison | 40 | Si-Ge | P | 3.0 | $2.3\times10^{20}$ |
| | 41 | Si-Ge | Bi | 3.0 | $1.4\times10^{20}$ |

Table 4-2

| | No | Matrix | Thermoelectric resistance | | | |
|---|---|---|---|---|---|---|
| | | | Seebeck coefficient α (mV/K) | Electrical resistance ρ (Ωm) | Thermal conductivity κ (W/mK) | Performance index Z (1/K) |
| Embodiment 4 | 21 | Si | 0.410 | $1.35\times10^{-4}$ | 51.3 | $2.43\times10^{-5}$ |
| | 22 | Si | 0.550 | $1.42\times10^{-5}$ | 55.7 | $3.80\times10^{-4}$ |
| | 23 | Si | 0.475 | $1.12\times10^{-5}$ | 58.0 | $3.47\times10^{-4}$ |
| | 24 | Si | 0.462 | $3.20\times10^{-6}$ | 61.7 | $1.08\times10^{-3}$ |
| | 25 | Si | 0.444 | $1.83\times10^{-6}$ | 64.0 | $1.68\times10^{-3}$ |
| | 26 | Si | 0.276 | $1.10\times10^{-6}$ | 68.0 | $1.02\times10^{-3}$ |
| | 27 | Si | 0.03 | $9.40\times10^{-7}$ | 77.7 | $1.23\times10^{-5}$ |
| | 28 | Si | 0.22 | $1.24\times10^{-4}$ | 52.7 | $7.41\times10^{-6}$ |
| | 29 | Si | 0.530 | $2.03\times10^{-5}$ | 58.0 | $2.39\times10^{-4}$ |
| | 30 | Si | 0.496 | $4.84\times10^{-6}$ | 61 | $8.33\times10^{-4}$ |
| | 31 | Si | 0.406 | $2.03\times10^{-6}$ | 67 | $1.21\times10^{-3}$ |
| | 32 | Si | 0.048 | $1.20\times10^{-6}$ | 74.7 | $2.57\times10^{-5}$ |
| | 33 | Si | 0.422 | $2.95\times10^{-6}$ | 62 | $9.74\times10^{-4}$ |
| | 34 | Si | 0.556 | $2.34\times10^{-6}$ | 63 | $2.10\times10^{-3}$ |
| | 35 | Si | 0.576 | $2.18\times10^{-6}$ | 60.7 | $2.51\times10^{-3}$ |
| | 36 | Si | 0.490 | $5.42\times10^{-6}$ | 58 | $7.64\times10^{-4}$ |
| | 37 | Si | 0.538 | $3.04\times10^{-6}$ | 61.7 | $1.54\times10^{-3}$ |
| | 38 | Si | 0.610 | $2.82\times10^{-6}$ | 63 | $2.09\times10^{-3}$ |
| | 39 | Si | 0.548 | $3.56\times10^{-6}$ | 59.3 | $1.42\times10^{-3}$ |
| Comparison | 40 | Si-Ge | 0.16 | $2.05\times10^{-5}$ | 5.2 | $2.40\times10^{-4}$ |
| | 41 | Si-Ge | 0.233 | $3.41\times10^{-5}$ | 9.0 | $1.77\times10^{-4}$ |

Embodiment 5

To produce a p-type silicon semiconductor, high-purity silicon (10N) and Group 3 and 5 elements were compounded as shown in Table 5-1, after which they were arc melted in an argon gas atmosphere. The amounts of dopants in the melting were adjusted such that there was slightly more p-type element so that the p-type carrier concentration would be $10^{19}$ to $10^{20}$ (M/m$^3$).

The button-shaped ingots thus obtained were cut into sizes of 5 × 5 × 5 mm, 10 × 10 × 2 mm, and 10 mm diameter × 2 mm,and the Seebeck coefficient, Hall coefficient (including the carrier concentration and electrical resistance), and thermal conductivity of each were measured.

The Seebeck coefficient was determined by setting the temperature differential between the high and low temperature portions to 6°C, using a digital multi-meter to measure the thermoelectromotive force of the p-type semiconductor at an average temperature of 200°C for the high and low temperature portions, and dividing this by the temperature differential (6°C).

The Hall coefficient was measured by AC method at 200°C, and electrical resistance was measured by the four-terminal method at the same time as the carrier concentration. Thermal conductivity was measured at 200°C by laser flash method. These measurement results are given in Table 5-2.

Embodiment 6

To produce an n-type silicon thermoelectric semiconductor, high-purity silicon (10N) and Group 3 and 5 elements were compounded as shown in Table 6-1, after which they were arc melted in an argon gas atmosphere. The amounts of dopants in the melting were adjusted such that there was slightly more n-type element so that the n-type carrier concentration would be $10^{19}$ to $10^{20}$ ($M/m^3$).

The button-shaped ingots thus obtained were cut into sizes of 5 × 5 × 5 mm, 10 × 10 × 2 mm, and 10 mm diameter × 2 mm, and the Seebeck coefficient, Hall coefficient (including the carrier concentration and electrical resistance), and thermal conductivity of each were measured. The Seebeck coefficient, Hall coefficient, electrical resistance, and thermal conductivity were measured in the same manner as in Embodiment 5. These measurement results are given in Table 6-2.

Embodiment 7

To produce n-type and p-type silicon semiconductors, a 2-6 compound semiconductor or a 3-5 compound semiconductor, high-purity silicon (10N), and a Group 3 or 5 dopant were compounded as shown in Table 7-1, after which they were arc melted in an argon gas atmosphere. The doping amount of the Group 3 or 5 element in the melting was adjusted such that the p-type and n-type carrier concentrations would be $10^{19}$ to $10^{20}$ ($M/m^3$).

The button-shaped ingots thus obtained were cut into sizes of 5 × 5 × 5 mm, 10 × 10 × 2 mm, and 10 mm diameter × 2 mm, and the Seebeck coefficient, Hall coefficient (including the carrier concentration and electrical resistance), and thermal conductivity of each were measured. The Seebeck coefficient, Hall coefficient, electrical resistance, and thermal conductivity were measured in the same manner as in Embodiment 5. These measurement results are given in Table 7-2.

As is clear from Tables 5-1 to 7-2, the performance index Z of the embodiments in which at least one type of Group 3 or 5 element was contained in silicon in an amount of 1 to 20 at% (Nos. 1 to 28 and Nos. 31 to 58), and that of the embodiments in which a 2-6 compound semiconductor or a 3-5 compound semiconductor was contained in an amount of 1 to 10 at% (Nos. 61 to 90) were equal to or better than the performance index of the comparisons in which various elements were added to an Si-Ge system (Si:Ge = 4:1) (Nos. 29, 30, 59, and 60).

Table 5-1

| | No | Matrix | Dopant | | Dopant | | Carrier concentration |
|---|---|---|---|---|---|---|---|
| | | | Element name | Added amount (at%) | Element name | Added amount (at%) | n (M/m3) |
| Embodiment 5 | 1 | Si | B | 2.2 | P | 2.0 | 5.20×10+18 |
| | 2 | Si | B | 3.0 | P | 2.0 | 1.02×10+19 |
| | 3 | Si | B | 5.0 | P | 2.0 | 7.30×10+20 |
| | 4 | Si | B | 8.0 | P | 2.0 | 2.70×10+21 |
| | 5 | Si | B | 3.2 | Sb | 3.0 | 4.20×10+18 |
| | 6 | Si | B | 4.0 | Sb | 3.0 | 6.80×10+19 |
| | 7 | Si | B | 6.0 | Sb | 3.0 | 5.90×10+20 |
| | 8 | Si | B | 9.0 | Sb | 3.0 | 1.80×10+21 |
| | 9 | Si | Al | 2.2 | P | 2.0 | 3.30×10+18 |
| | 10 | Si | Al | 3.0 | P | 2.0 | 7.80×10+19 |
| | 11 | Si | Al | 5.0 | P | 2.0 | 3.80×10+20 |
| | 12 | Si | Al | 8.0 | P | 2.0 | 1.40×10+21 |
| | 13 | Si | Al | 3.2 | Bi | 3.0 | 2.10×10+18 |
| | 14 | Si | Al | 4.0 | Bi | 3.0 | 6.70×10+19 |
| | 15 | Si | Al | 6.0 | Bi | 3.0 | 3.60×10+20 |
| | 16 | Si | Al | 9.0 | Bi | 3.0 | 1.30×10+21 |
| | 17 | Si | Ga | 2.2 | P | 2.0 | 2.30×10+18 |
| | 18 | Si | Ga | 3.0 | P | 2.0 | 5.20×10+19 |
| | 19 | Si | Ga | 5.0 | P | 2.0 | 3.70×10+20 |
| | 20 | Si | Ga | 8.0 | P | 2.0 | 1.90×10+21 |
| | 21 | Si | Ga | 3.2 | Sb | 3.0 | 2.60×10+18 |
| | 22 | Si | Ga | 4.0 | Sb | 3.0 | 4.30×10+19 |
| | 23 | Si | Ga | 6.0 | Sb | 3.0 | 3.80×10+20 |
| | 24 | Si | Ga | 9.0 | Sb | 3.0 | 1.20×10+21 |
| | 25 | Si | In | 2.2 | P | 2.0 | 3.70×10+18 |
| | 26 | Si | In | 3.0 | P | 2.0 | 6.80×10+19 |
| | 27 | Si | In | 5.0 | P | 2.0 | 4.70×10+20 |
| | 28 | Si | In | 8.0 | P | 2.0 | 1.60×10+21 |
| Comparison | 29 | Si-Ge | B | 3.0 | | | 4.50×10+19 |
| | 30 | Si-Ge | Ga | 3.0 | | | 3.70×10+19 |

Table 5-2

| | No | Thermoelectric characteristics | | | |
|---|---|---|---|---|---|
| | | Seebeck coefficient α (mV/K) | Electrical resistance ρ (Ωm) | Thermal conductivity κ (W/m·K) | Performance index Z (1/K) |
| Embodiment 5 | 1 | 0.8 | $7.80\times10^{-3}$ | 25 | $3.28\times10^{-6}$ |
| | 2 | 0.6 | $3.60\times10^{-5}$ | 19 | $5.26\times10^{-4}$ |
| | 3 | 0.9 | $6.90\times10^{-6}$ | 15 | $7.83\times10^{-3}$ |
| | 4 | 0.05 | $2.40\times10^{-6}$ | 13 | $8.01\times10^{-5}$ |
| | 5 | 0.8 | $7.60\times10^{-3}$ | 33 | $2.55\times10^{-6}$ |
| | 6 | 0.5 | $4.10\times10^{-5}$ | 24 | $2.54\times10^{-4}$ |
| | 7 | 0.9 | $7.80\times10^{-6}$ | 18 | $5.77\times10^{-3}$ |
| | 8 | 0.07 | $3.40\times10^{-6}$ | 15 | $9.61\times10^{-5}$ |
| | 9 | 0.8 | $8.50\times10^{-3}$ | 28 | $2.69\times10^{-6}$ |
| | 10 | 0.5 | $6.30\times10^{-5}$ | 20 | $1.98\times10^{-4}$ |
| | 11 | 0.7 | $2.10\times10^{-5}$ | 18 | $1.30\times10^{-3}$ |
| | 12 | 0.1 | $7.80\times10^{-6}$ | 16 | $8.01\times10^{-5}$ |
| | 13 | 0.8 | $8.20\times10^{-3}$ | 41 | $1.90\times10^{-6}$ |
| | 14 | 0.5 | $5.90\times10^{-5}$ | 26 | $1.63\times10^{-4}$ |
| | 15 | 0.7 | $1.80\times10^{-5}$ | 24 | $1.13\times10^{-3}$ |
| | 16 | 0.1 | $7.20\times10^{-6}$ | 22 | $6.31\times10^{-5}$ |
| | 17 | 0.9 | $9.80\times10^{-3}$ | 21 | $3.94\times10^{-6}$ |
| | 18 | 0.5 | $7.20\times10^{-5}$ | 17 | $2.04\times10^{-4}$ |
| | 19 | 0.9 | $3.60\times10^{-5}$ | 13 | $1.73\times10^{-3}$ |
| | 20 | 0.1 | $9.30\times10^{-6}$ | 11 | $9.78\times10^{-5}$ |
| | 21 | 0.8 | $9.20\times10^{-3}$ | 26 | $2.68\times10^{-6}$ |
| | 22 | 0.5 | $6.80\times10^{-5}$ | 20 | $1.84\times10^{-4}$ |
| | 23 | 0.8 | $3.20\times10^{-5}$ | 16 | $1.25\times10^{-3}$ |
| | 24 | 0.1 | $8.90\times10^{-6}$ | 13 | $8.64\times10^{-5}$ |
| | 25 | 0.7 | $9.40\times10^{-3}$ | 23 | $2.27\times10^{-6}$ |
| | 26 | 0.5 | $6.70\times10^{-5}$ | 18 | $2.07\times10^{-4}$ |
| | 27 | 0.8 | $2.90\times10^{-5}$ | 15 | $1.47\times10^{-3}$ |
| | 28 | 0.08 | $7.70\times10^{-6}$ | 13 | $6.39\times10^{-5}$ |
| Comparison | 29 | 0.7 | $2.80\times10^{-4}$ | 15 | $1.17\times10^{-4}$ |
| | 30 | 0.6 | $3.40\times10^{-4}$ | 9 | $1.18\times10^{-4}$ |

Table 6-1

| | No | Matrix | Dopant | | Dopant | | Carrier concentration |
|---|---|---|---|---|---|---|---|
| | | | Element name | Added amount (at%) | Element name | Added amount (at%) | n (M/m3) |
| Embodiment 6 | 31 | Si | B | 2.0 | P | 2.2 | $4.30\times10^{+18}$ |
| | 32 | Si | B | 2.0 | P | 3.0 | $3.70\times10^{+19}$ |
| | 33 | Si | B | 2.0 | P | 8.0 | $5.70\times10^{+20}$ |
| | 34 | Si | B | 2.0 | P | 13.0 | $1.80\times10^{+21}$ |
| | 35 | Si | B | 3.0 | Sb | 3.2 | $3.50\times10^{+18}$ |
| | 36 | Si | B | 3.0 | Sb | 4.0 | $3.20\times10^{+19}$ |
| | 37 | Si | B | 3.0 | Sb | 9.0 | $5.20\times10^{+20}$ |
| | 38 | Si | B | 3.0 | Sb | 14.0 | $1.60\times10^{+21}$ |
| | 39 | Si | Al | 2.0 | P | 2.2 | $3.60\times10^{+18}$ |
| | 40 | Si | Al | 2.0 | P | 3.0 | $3.40\times10^{+19}$ |
| | 41 | Si | Al | 2.0 | P | 8.0 | $4.40\times10^{+20}$ |
| | 42 | Si | Al | 2.0 | P | 13.0 | $1.20\times10^{+21}$ |
| | 43 | Si | Al | 3.0 | Bi | 3.2 | $2.90\times10^{+18}$ |
| | 44 | Si | Al | 3.0 | Bi | 4.0 | $3.10\times10^{+19}$ |
| | 45 | Si | Al | 3.0 | Bi | 9.0 | $3.70\times10^{+20}$ |
| | 46 | Si | Al | 3.0 | Bi | 14.0 | $1.10\times10^{+21}$ |
| | 47 | Si | Ga | 2.0 | P | 2.2 | $3.80\times10^{+18}$ |
| | 48 | Si | Ga | 2.0 | P | 3.0 | $3.60\times10^{+19}$ |
| | 49 | Si | Ga | 2.0 | P | 8.0 | $4.70\times10^{+20}$ |
| | 50 | Si | Ga | 2.0 | P | 13.0 | $1.40\times10^{+21}$ |
| | 51 | Si | Ga | 3.0 | Sb | 3.2 | $3.60\times10^{+18}$ |
| | 52 | Si | Ga | 3.0 | Sb | 4.0 | $3.40\times10^{+19}$ |
| | 53 | Si | Ga | 3.0 | Sb | 9.0 | $4.10\times10^{+20}$ |
| | 54 | Si | Ga | 3.0 | Sb | 14.0 | $1.30\times10^{+21}$ |
| | 55 | Si | In | 2.0 | P | 2.2 | $4.20\times10^{+18}$ |
| | 56 | Si | In | 2.0 | P | 3.0 | $3.90\times10^{+19}$ |
| | 57 | Si | In | 2.0 | P | 8.0 | $6.90\times10^{+20}$ |
| | 58 | Si | In | 2.0 | P | 13.0 | $2.00\times10^{+21}$ |
| Comparison | 59 | Si-Ge | P | 3.0 | - | - | $1.02\times10^{+20}$ |
| | 60 | Si-Ge | Bi | 3.0 | - | - | $9.70\times10^{+18}$ |

Table 6-2

| | No | Thermoelectric characteristics | | | |
|---|---|---|---|---|---|
| | | Seebeck coefficient α (mV/K) | Electrical resistance ρ (Ωm) | Thermal conductivity κ (W/m·K) | Performance index Z (1/K) |
| Embodiment 6 | 31 | -0.6 | $7.20 \times 10^{-3}$ | 48 | $1.04 \times 10^{-6}$ |
| | 32 | -0.5 | $3.60 \times 10^{-5}$ | 24 | $2.89 \times 10^{-4}$ |
| | 33 | -0.7 | $9.60 \times 10^{-6}$ | 15 | $3.40 \times 10^{-3}$ |
| | 34 | -0.08 | $5.20 \times 10^{-6}$ | 13 | $9.47 \times 10^{-5}$ |
| | 35 | -0.7 | $8.40 \times 10^{-3}$ | 52 | $1.12 \times 10^{-6}$ |
| | 36 | -0.5 | $4.20 \times 10^{-5}$ | 36 | $1.65 \times 10^{-4}$ |
| | 37 | -0.6 | $1.04 \times 10^{-5}$ | 24 | $1.44 \times 10^{-3}$ |
| | 38 | -0.1 | $5.80 \times 10^{-6}$ | 21 | $8.21 \times 10^{-5}$ |
| | 39 | -0.6 | $5.60 \times 10^{-3}$ | 51 | $1.26 \times 10^{-6}$ |
| | 40 | -0.5 | $4.20 \times 10^{-5}$ | 27 | $2.20 \times 10^{-4}$ |
| | 41 | -0.7 | $9.80 \times 10^{-6}$ | 19 | $2.63 \times 10^{-3}$ |
| | 42 | -0.07 | $5.60 \times 10^{-6}$ | 14 | $6.25 \times 10^{-5}$ |
| | 43 | -0.5 | $8.40 \times 10^{-3}$ | 59 | $5.04 \times 10^{-7}$ |
| | 44 | -0.5 | $4.60 \times 10^{-5}$ | 41 | $1.33 \times 10^{-4}$ |
| | 45 | -0.7 | $1.04 \times 10^{-5}$ | 28 | $1.68 \times 10^{-3}$ |
| | 46 | -0.1 | $5.60 \times 10^{-6}$ | 24 | $7.44 \times 10^{-5}$ |
| | 47 | -0.5 | $7.40 \times 10^{-3}$ | 33 | $1.02 \times 10^{-6}$ |
| | 48 | -0.5 | $4.00 \times 10^{-5}$ | 19 | $3.29 \times 10^{-4}$ |
| | 49 | -0.6 | $1.02 \times 10^{-5}$ | 10 | $3.53 \times 10^{-3}$ |
| | 50 | -0.06 | $5.40 \times 10^{-6}$ | 7 | $9.52 \times 10^{-5}$ |
| | 51 | -0.4 | $8.60 \times 10^{-3}$ | 36 | $5.17 \times 10^{-7}$ |
| | 52 | -0.5 | $5.20 \times 10^{-5}$ | 26 | $1.85 \times 10^{-4}$ |
| | 53 | -0.6 | $1.10 \times 10^{-5}$ | 20 | $1.64 \times 10^{-3}$ |
| | 54 | -0.09 | $6.40 \times 10^{-6}$ | 15 | $8.44 \times 10^{-5}$ |
| | 55 | -0.6 | $7.20 \times 10^{-3}$ | 44 | $1.14 \times 10^{-6}$ |
| | 56 | -0.5 | $3.80 \times 10^{-5}$ | 23 | $2.86 \times 10^{-4}$ |
| | 57 | -0.7 | $9.80 \times 10^{-6}$ | 16 | $3.13 \times 10^{-3}$ |
| | 58 | -0.08 | $5.00 \times 10^{-6}$ | 13 | $9.85 \times 10^{-5}$ |
| Comparison | 59 | -0.6 | $3.80 \times 10^{-4}$ | 8 | $1.18 \times 10^{-4}$ |
| | 60 | -0.6 | $2.60 \times 10^{-4}$ | 13 | $1.07 \times 10^{-4}$ |

Table 7-1

| | No | Matrix | Dopant | | Dopant | | Carrier concentration |
|---|---|---|---|---|---|---|---|
| | | | Compound name | Added amount (at%) | Element name | Added amount (at%) | n (M/m3) |
| Embodiment 7 | 61 | Si | AlP | 1.0 | B | 1.0 | $4.50\times10^{+20}$ |
| | 62 | Si | AlP | 3.0 | B | 1.0 | $4.20\times10^{+20}$ |
| | 63 | Si | AlP | 10.0 | B | 1.0 | $4.10\times10^{+20}$ |
| | 64 | Si | AlP | 1.0 | P | 1.0 | $5.30\times10^{+20}$ |
| | 65 | Si | AlP | 3.0 | P | 1.0 | $5.10\times10^{+20}$ |
| | 66 | Si | AlP | 10.0 | P | 1.0 | $4.90\times10^{+20}$ |
| | 67 | Si | GaP | 1.0 | B | 1.0 | $4.80\times10^{+20}$ |
| | 68 | Si | GaP | 3.0 | B | 1.0 | $4.60\times10^{+20}$ |
| | 69 | Si | GaP | 10.0 | B | 1.0 | $4.40\times10^{+20}$ |
| | 70 | Si | GaP | 1.0 | As | 1.0 | $4.70\times10^{+20}$ |
| | 71 | Si | GaP | 3.0 | As | 1.0 | $4.40\times10^{+20}$ |
| | 72 | Si | GaP | 10.0 | As | 1.0 | $4.30\times10^{+20}$ |
| | 73 | Si | GaAs | 1.0 | Al | 1.0 | $3.90\times10^{+20}$ |
| | 74 | Si | GaAs | 3.0 | Al | 1.0 | $3.70\times10^{+20}$ |
| | 75 | Si | GaAs | 10.0 | Al | 1.0 | $3.80\times10^{+20}$ |
| | 76 | Si | GaAs | 1.0 | P | 1.0 | $4.90\times10^{+20}$ |
| | 77 | Si | GaAs | 3.0 | P | 1.0 | $4.70\times10^{+20}$ |
| | 78 | Si | GaAs | 10.0 | P | 1.0 | $5.00\times10^{+20}$ |
| | 79 | Si | ZnO | 1.0 | B | 1.0 | $4.70\times10^{+20}$ |
| | 80 | Si | ZnO | 3.0 | B | 1.0 | $4.30\times10^{+20}$ |
| | 81 | Si | ZnO | 10.0 | B | 1.0 | $4.40\times10^{+20}$ |
| | 82 | Si | ZnO | 1.0 | P | 1.0 | $4.30\times10^{+20}$ |
| | 83 | Si | ZnO | 3.0 | P | 1.0 | $4.30\times10^{+20}$ |
| | 84 | Si | ZnO | 10.0 | P | 1.0 | $4.10\times10^{+20}$ |
| | 85 | Si | CdS | 1.0 | B | 1.0 | $4.50\times10^{+20}$ |
| | 86 | Si | CdS | 3.0 | B | 1.0 | $4.10\times10^{+20}$ |
| | 87 | Si | CdS | 10.0 | B | 1.0 | $4.20\times10^{+20}$ |
| | 88 | Si | CdS | 1.0 | Sb | 1.0 | $3.70\times10^{+20}$ |
| | 89 | Si | CdS | 3.0 | Sb | 1.0 | $3.80\times10^{+20}$ |
| | 90 | Si | CdS | 10.0 | Sb | 1.0 | $3.40\times10^{+20}$ |
| Comparison | 29 | Si-Ge | B | 3.0 | - | - | $4.50\times10^{+19}$ |
| | 59 | Si-Ge | P | 3.0 | - | - | $1.02\times10^{+20}$ |

Table 7-2

| | No | Thermoelectric characteristics | | | |
|---|---|---|---|---|---|
| | | Seebeck coefficient α (mV/K) | Electrical resistance ρ (Ωm) | Thermal conductivity κ (W/m·K) | Performance index Z (1/K) |
| Embodiment 7 | 61 | 0.4 | $6.40\times10^{-6}$ | 109 | $2.29\times10^{-4}$ |
| | 62 | 0.5 | $7.20\times10^{-6}$ | 19 | $1.83\times10^{-3}$ |
| | 63 | 0.5 | $7.40\times10^{-6}$ | 15 | $2.25\times10^{-3}$ |
| | 64 | -0.4 | $9.00\times10^{-6}$ | 102 | $1.74\times10^{-4}$ |
| | 65 | -0.5 | $9.20\times10^{-6}$ | 20 | $1.36\times10^{-3}$ |
| | 66 | -0.5 | $9.40\times10^{-6}$ | 16 | $1.66\times10^{-3}$ |
| | 67 | 0.5 | $7.00\times10^{-6}$ | 107 | $3.34\times10^{-4}$ |
| | 68 | 0.6 | $7.40\times10^{-6}$ | 16 | $3.04\times10^{-3}$ |
| | 69 | 0.6 | $7.60\times10^{-6}$ | 13 | $3.64\times10^{-3}$ |
| | 70 | -0.5 | $1.06\times10^{-5}$ | 108 | $2.18\times10^{-4}$ |
| | 71 | -0.5 | $1.12\times10^{-5}$ | 18 | $1.24\times10^{-3}$ |
| | 72 | -0.5 | $1.12\times10^{-5}$ | 14 | $1.59\times10^{-3}$ |
| | 73 | 0.4 | $1.24\times10^{-5}$ | 92 | $1.40\times10^{-4}$ |
| | 74 | 0.5 | $1.34\times10^{-5}$ | 17 | $1.10\times10^{-3}$ |
| | 75 | 0.5 | $1.32\times10^{-5}$ | 13 | $1.46\times10^{-3}$ |
| | 76 | -0.4 | $8.80\times10^{-6}$ | 103 | $1.77\times10^{-4}$ |
| | 77 | -0.5 | $9.20\times10^{-6}$ | 18 | $1.51\times10^{-3}$ |
| | 78 | -0.5 | $9.40\times10^{-6}$ | 15 | $1.77\times10^{-3}$ |
| | 79 | 0.5 | $7.40\times10^{-6}$ | 105 | $3.22\times10^{-4}$ |
| | 80 | 0.6 | $7.60\times10^{-6}$ | 16 | $2.96\times10^{-3}$ |
| | 81 | 0.6 | $7.80\times10^{-6}$ | 11 | $4.20\times10^{-3}$ |
| | 82 | -0.4 | $1.00\times10^{-5}$ | 107 | $1.50\times10^{-4}$ |
| | 83 | -0.6 | $1.04\times10^{-5}$ | 17 | $2.04\times10^{-3}$ |
| | 84 | -0.6 | $1.06\times10^{-5}$ | 13 | $2.61\times10^{-3}$ |
| | 85 | 0.5 | $7.20\times10^{-6}$ | 107 | $3.25\times10^{-4}$ |
| | 86 | 0.6 | $7.40\times10^{-6}$ | 18 | $2.70\times10^{-3}$ |
| | 87 | 0.6 | $7.40\times10^{-6}$ | 14 | $3.47\times10^{-3}$ |
| | 88 | -0.4 | $1.16\times10^{-5}$ | 109 | $1.27\times10^{-4}$ |
| | 89 | -0.6 | $1.18\times10^{-5}$ | 15 | $2.03\times10^{-3}$ |
| | 90 | -0.6 | $1.20\times10^{-5}$ | 13 | $2.31\times10^{-3}$ |
| Comparison | 29 | 0.7 | $2.80\times10^{-4}$ | 15 | $1.17\times10^{-4}$ |
| | 59 | -0.6 | $3.80\times10^{-4}$ | 8 | $1.18\times10^{-4}$ |

Embodiment 8

To produce a p-type silicon semiconductor, high-purity silicon (10N) and Group 3 and 4 elements were compounded as shown in Table 8-1, after which they were arc melted in an argon gas atmosphere. The button-shaped ingots thus obtained were cut into sizes of 5 × 5 × 5 mm, 10 × 10 × 2 mm, and 10 mm diameter × 2 mm, and the Seebeck coefficient, Hall coefficient (including the carrier concentration and electrical resistance), and thermal conductivity of each were measured.

The Seebeck coefficient was determined by setting the temperature differential between the high and low temperature portions to 6°C, using a digital multi-meter to measure the thermoelectromotive force of the p-type semiconductor at an average temperature of 200°C for the high and low temperature portions, and dividing this by the temperature differential (6°C). The Hall coefficient was measured by AC method at 200°C, and electrical resistance was measured by the four-terminal method at the same time as the carrier concentration. Thermal conductivity was measured at 200°C by laser flash method. These measurement results are given in Table 8-2.

Embodiment 9

To produce an n-type silicon semiconductor, high-purity silicon (10N) and Group 5 and 4 elements were compounded as shown in Table 9-1, after which they were arc melted in an argon gas atmosphere. The button-shaped ingots thus obtained were cut into sizes of 5 × 5 × 5 mm, 10 × 10 × 2 mm, and 10 mm diameter × 2 mm, and the Seebeck coefficient, Hall coefficient (including the carrier concentration and electrical resistance), and thermal conductivity of each were measured.

The Seebeck coefficient was determined by setting the temperature differential between the high and low temperature portions to 6°C, using a digital multi-meter to measure the thermoelectromotive force of the n-type semiconductor at an average temperature of 200°C for the high and low temperature portions, and dividing this by the temperature differential (6°C). The Hall coefficient was measured by AC method at 200°C, and electrical resistance was measured by the four-terminal method at the same time as the carrier concentration. Thermal conductivity was measured at 200°C by laser flash method. These measurement results are given in Table 8-2.

As is clear from Tables 8-1 to 9-2, the performance index Z of the embodiments in which a Group 4 element of germanium, carbon, or tin was contained in silicon in an amount of 0.05 to 5 at% (preferably 0.1 to 5 at%; Nos. 1 to 1 to 9 and Nos. 21 to 29) was equal to or better than the performance index of the comparisons in which various elements were added to silicon alone (Nos. 10, 11, 30, and 31) and that of the comparisons in which various elements were added to an Si-Ge system (Si:Ge = 4:1) (Nos. 12, 13, 32, and 33).

Table 8-1

| | No. | Matrix | Dopant | | Dopant | | Carrier concentration |
|---|---|---|---|---|---|---|---|
| | | | Element name | Added amount (at%) | Element name | Added amount (at%) | n ($M/m^3$) |
| Embodiment 8 | 1 | Si | C | 0.05 | B | 1.0 | $3.20\times10^{+20}$ |
| | 2 | Si | C | 3.0 | B | 1.0 | $3.10\times10^{+20}$ |
| | 3 | Si | C | 5.0 | B | 1.0 | $3.05\times10^{+20}$ |
| | 4 | Si | Ge | 0.05 | B | 1.0 | $3.40\times10^{+20}$ |
| | 5 | Si | Ge | 3.0 | B | 1.0 | $3.30\times10^{+20}$ |
| | 6 | Si | Ge | 5.0 | B | 1.0 | $3.20\times10^{+20}$ |
| | 7 | Si | Sn | 0.05 | Al | 1.0 | $2.50\times10^{+20}$ |
| | 8 | Si | Sn | 3.0 | Al | 1.0 | $2.60\times10^{+20}$ |
| | 9 | Si | Sn | 5.0 | Al | 1.0 | $2.40\times10^{+20}$ |
| Comparison | 10 | Si | B | 3.0 | - | - | $4.50\times10^{+20}$ |
| | 11 | Si | Ga | 3.0 | - | - | $3.70\times10^{+20}$ |
| | 12 | Si-Ge | Ge | 20.0 | B | 3.0 | $4.50\times10^{+19}$ |
| | 13 | Si-Ge | Ge | 20.0 | Ga | 3.0 | $3.70\times10^{+19}$ |

Table 8-2

| | No. | Thermoelectric characteristics | | | |
|---|---|---|---|---|---|
| | | Seebeck coefficient α (mV/K) | Electrical resistance ρ (Ωm) | Thermal conductivity κ (W/m·K) | Performance index Z (1/K) |
| Embodiment 8 | 1 | 0.4 | $5.40\times10^{-6}$ | 92 | $3.22\times10^{-4}$ |
| | 2 | 0.5 | $5.80\times10^{-6}$ | 22 | $1.96\times10^{-3}$ |
| | 3 | 0.5 | $5.90\times10^{-6}$ | 18 | $2.35\times10^{-3}$ |
| | 4 | 0.5 | $5.70\times10^{-6}$ | 83 | $5.28\times10^{-4}$ |
| | 5 | 0.6 | $5.90\times10^{-6}$ | 18 | $3.39\times10^{-3}$ |
| | 6 | 0.6 | $6.10\times10^{-6}$ | 15 | $3.93\times10^{-3}$ |
| | 7 | 0.3 | $7.60\times10^{-6}$ | 86 | $1.38\times10^{-4}$ |
| | 8 | 0.5 | $7.80\times10^{-5}$ | 20 | $1.60\times10^{-4}$ |
| | 9 | 0.5 | $7.90\times10^{-5}$ | 16 | $1.98\times10^{-4}$ |
| Comparison | 10 | 0.15 | $5.30\times10^{-6}$ | 32 | $1.33\times10^{-4}$ |
| | 11 | 0.17 | $6.70\times10^{-6}$ | 36 | $1.20\times10^{-4}$ |
| | 12 | 0.7 | $2.80\times10^{-4}$ | 15 | $1.17\times10^{-4}$ |
| | 13 | 0.6 | $3.40\times10^{-4}$ | 9 | $1.18\times10^{-4}$ |

Table 9-1

| | No. | Matrix | Dopant | | Dopant | | Carrier concentration |
|---|---|---|---|---|---|---|---|
| | | | Element name | Added amount (at%) | Element name | Added amount (at%) | n (M/m$^3$) |
| Embodiment 9 | 21 | Si | C | 0.05 | P | 1.0 | $4.30\times10^{+20}$ |
| | 22 | Si | C | 3.0 | P | 1.0 | $4.10\times10^{+20}$ |
| | 23 | Si | C | 5.0 | P | 1.0 | $4.05\times10^{+20}$ |
| | 24 | Si | Ge | 0.05 | Sb | 1.0 | $3.50\times10^{+20}$ |
| | 25 | Si | Ge | 3.0 | Sb | 1.0 | $3.40\times10^{+20}$ |
| | 26 | Si | Ge | 5.0 | Sb | 1.0 | $3.30\times10^{+20}$ |
| | 27 | Si | Sn | 0.05 | P | 1.0 | $3.10\times10^{+20}$ |
| | 28 | Si | Sn | 3.0 | P | 1.0 | $2.90\times10^{+20}$ |
| | 29 | Si | Sn | 5.0 | P | 1.0 | $2.80\times10^{+20}$ |
| Comparison | 30 | Si | P | 3.0 | - | - | $1.02\times10^{+20}$ |
| | 31 | Si | Bi | 3.0 | - | - | $9.70\times10^{+19}$ |
| | 32 | Si-Ge | Ge | 20.0 | P | 3.0 | $1.02\times10^{+20}$ |
| | 33 | Si-Ge | Ge | 20.0 | Ga | 3.0 | $9.70\times10^{+19}$ |

Table 9-2

| | No. | Thermoelectric characteristics | | | |
|---|---|---|---|---|---|
| | | Seebeck coefficient α (mV/K) | Electrical resistance ρ (Ωm) | Thermal conductivity κ (W/m·K) | Performance index Z (1/K) |
| Embodiment 9 | 21 | -0.4 | $6.70 \times 10^{-6}$ | 102 | $2.35 \times 10^{-4}$ |
| | 22 | -0.5 | $6.80 \times 10^{-6}$ | 25 | $1.47 \times 10^{-3}$ |
| | 23 | -0.5 | $7.00 \times 10^{-6}$ | 18 | $1.98 \times 10^{-3}$ |
| | 24 | -0.5 | $7.30 \times 10^{-6}$ | 97 | $3.53 \times 10^{-4}$ |
| | 25 | -0.6 | $7.50 \times 10^{-6}$ | 22 | $2.18 \times 10^{-3}$ |
| | 26 | -0.6 | $7.70 \times 10^{-6}$ | 15 | $3.12 \times 10^{-3}$ |
| | 27 | -0.4 | $6.80 \times 10^{-6}$ | 99 | $2.37 \times 10^{-4}$ |
| | 28 | -0.5 | $7.10 \times 10^{-6}$ | 23 | $1.53 \times 10^{-3}$ |
| | 29 | -0.5 | $7.20 \times 10^{-6}$ | 18 | $1.93 \times 10^{-3}$ |
| Comparison | 30 | -0.3 | $6.80 \times 10^{-6}$ | 52 | $2.54 \times 10^{-4}$ |
| | 31 | -0.35 | $7.40 \times 10^{-6}$ | 78 | $2.12 \times 10^{-4}$ |
| | 32 | -0.6 | $3.80 \times 10^{-4}$ | 8 | $1.18 \times 10^{-4}$ |
| | 33 | -0.6 | $2.60 \times 10^{-4}$ | 13 | $1.07 \times 10^{-4}$ |

Embodiment 10

To produce a p-type silicon semiconductor, high-purity single crystal silicon (10N) and the elements shown in Tables 10-1, 10-2, 10-3, and 10-4 were measured out in the specified proportions and then arc melted in an argon gas atmosphere in the standard way to produce a first type of sample, and a second type of sample was produced by holding down the melt with a chiller from above immediately after the arc melting. For the sake of comparison, the sample arc melted in the standard way was heat treated at about 1000°C to grow crystal grains and produce a comparative sample.

The arc melting crucible was in the shape of an inverted and truncated cone, as shown in Figure 13. The inside diameter at the top was 60 mm, the inside diameter at the bottom was 40 mm, and the depth was 30 mm. The chiller was made of copper and was designed to fit perfectly into this crucible. In order to boost the cooling efficiency, the chiller was machined to a thickness of 50 mm so that its thermal capacity would be larger.

The dimensions of the button-shaped ingots thus obtained were 40 mm outside diameter × 4 mm. These ingots were cut into sizes of 5 × 5 × 3 mm, 10 × 10 × 2 mm, and 10 mm outside diameter × 2 mm to produce samples for measuring the Seebeck coefficient, Hall coefficient (including the electrical resistance), and thermal conductivity of each.

The Seebeck coefficient was determined by using silver for the electrode of the high temperature portion and copper for the electrode of the low temperature portion, setting the temperature differential thereof to 6°C, using a digital multi-meter to measure the thermoelectromotive force of the p-type semiconductor at an average temperature of 200°C for the high and low temperature portions, and dividing this thermoelectromotive force by 6°C.

The Hall coefficient was measured by AC method at 200°C and electrical resistance was also measured by the four-terminal method at that time. Thermal conductivity was measured at 200°C by laser flash method. These measurement results are given in Tables 10-1, 10-2, 10-3, and 10-4.

The average grain diameter was measured after first polishing and then chemically etching the sample. The average grain diameter of a sample arc melted in the standard way was about 10 to 20 μm. The state of precipitation of the dopant inside the crystal grains and at the grain boundary was observed by EPMA, and as a result the dopant was seen to be dispersed along the grain boundary with a quenched sample, but was locally present in bands substantially continuously along the grain boundary with the two types of sample not quenched.

Embodiment 11

To produce an n-type silicon semiconductor, high-purity single crystal silicon (10N) and the elements shown in Tables 11-1, 11-2, 11-3, and 11-4 were measured out in the specified proportions and then arc melted in an argon gas atmosphere in the standard way to produce a first type of sample, and a second type of sample was produced by holding down the melt with a chiller from above immediately after the arc melting. For the sake of comparison, the sample arc melted in the standard way was heat treated at about 1000°C to grow crystal grains and produce a comparative sample. The quenching method after arc melting was the same as in Embodiment 10.

The dimensions of the button-shaped ingots thus obtained were 40 mm outside diameter × 4 mm. These ingots were cut into sizes of 5 × 5 × 3 mm, 10 × 10 × 2 mm, and 10 mm outside diameter × 2 mm to produce samples for measuring the Seebeck coefficient, Hall coefficient (including the electrical resistance), and thermal conductivity of each. The Seebeck coefficient, Hall coefficient) electrical resistance, and thermal conductivity were measured by the same methods as in Embodiment 1. These measurement results are given in Tables 11-1, 11-2, 11-3, and 11-4.

The average grain diameter was measured after first polishing and then chemically etching the sample. The average grain diameter of a sample arc melted in the standard way was about 10 to 20 μm. The state of precipitation of the dopant inside the crystal grains and at the grain boundary was observed by EPMA, and as a result the dopant was seen to be dispersed along the grain boundary with a quenched sample, just as in Embodiment 1, but was locally present in bands substantially continuously along the grain boundary with the two types of sample not quenched.

Table 10-1

| | | No | Matrix | Dopant Added amount | | Average grain diameter (μm) |
|---|---|---|---|---|---|---|
| | | | | Dopant | Added amount (at%) | |
| Embodiment 10 | Quenching | 1 | Si | Al | 0.10 | 4.5 |
| | | 2 | Si | Al | 1.0 | 3.4 |
| | | 3 | Si | Al | 3.0 | 2.8 |
| | | 4 | Si | Al | 5.0 | 2.2 |
| | | 5 | Si | Ga | 3.0 | 3.1 |
| | | 6 | Si | In | 3.0 | 2.5 |
| | | 7 | Si | Zn | 1.5 | 3.2 |
| | | 8 | Si | Al | 1.5 | 2.7 |
| | | | | Y | 0.5 | |
| | | 9 | Si | Y | 3.0 | 4.8 |
| | | 10 | Si | Mo | 3.0 | 2.2 |
| | | 11 | Si | Zr | 3.0 | 3.5 |
| | | 12 | Si | Be | 3.0 | 2.8 |
| | | 13 | Si | Mg | 3.0 | 4.3 |

Table 10-2

| | | No | Thermoelectric characteristics | | | |
|---|---|---|---|---|---|---|
| | | | Seebeck coefficient α (mV/K) | Electrical resistance ρ (Ωm) | Thermal conductivity κ (W/mK) | Performance index Z (1/K) |
| Embodiment 10 | Quenching | 1 | 0.491 | $5.0\times10^{-5}$ | 37.7 | $1.28\times10^{-4}$ |
| | | 2 | 0.381 | $8.4\times10^{-6}$ | 33.7 | $5.13\times10^{-4}$ |
| | | 3 | 0.334 | $7.4\times10^{-6}$ | 29.3 | $5.15\times10^{-4}$ |
| | | 4 | 0.234 | $3.0\times10^{-6}$ | 26 | $7.02\times10^{-4}$ |
| | | 5 | 0.344 | $6.4\times10^{-6}$ | 21.7 | $8.52\times10^{-4}$ |
| | | 6 | 0.311 | $6.8\times10^{-6}$ | 18 | $7.90\times10^{-4}$ |
| | | 7 | 0.280 | $4.6\times10^{-6}$ | 20 | $8.52\times10^{-4}$ |
| | | 8 | 0.349 | $7.8\times10^{-6}$ | 17 | $9.19\times10^{-4}$ |
| | | 9 | 0.316 | $6.4\times10^{-6}$ | 19 | $8.21\times10^{-4}$ |
| | | 10 | 0.293 | $8.6\times10^{-6}$ | 17.3 | $5.77\times10^{-4}$ |
| | | 11 | 0.207 | $6.0\times10^{-6}$ | 17.7 | $4.03\times10^{-4}$ |
| | | 12 | 0.344 | $4.6\times10^{-6}$ | 32 | $8.04\times10^{-4}$ |
| | | 13 | 0.304 | $5.2\times10^{-6}$ | 27 | $6.58\times10^{-4}$ |

Table 10-3

| | | No | Matrix | Dopant Added amount | | Average grain diameter (μm) |
|---|---|---|---|---|---|---|
| | | | | Dopant | Added amount (at%) | |
| Comparison 10 | No quenching (heat treated) | 16 | Si | Al | 3.0 | 15 |
| | | 17 | Si | Ga | 3.0 | 18 |
| | | 18 | Si | Al | 1.5 | 11 |
| | | | | Y | 0.5 | |
| | | 19 | Si | Mo | 3.0 | 17 |
| | | 20 | Si | Be | 3.0 | 19 |
| | | 21 | Si | Al | 3.0 | 46 |
| | | 22 | Si | Ga | 3.0 | 53 |
| | | 23 | Si | Al | 1.5 | 35 |
| | | | | Y | 0.5 | |
| | | 24 | Si | Mo | 3.0 | 56 |
| | | 25 | Si | Be | 3.0 | 68 |

Table 10-4

| | | No | Thermoelectric characteristics | | | |
|---|---|---|---|---|---|---|
| | | | Seebeck coefficient α (mV/K) | Electrical resistance ρ (Ωm) | Thermal conductivity κ (W/mK) | Performance index Z (1/K) |
| Comparison 10 | No quenching (heat treated) | 16 | 0.254 | $9.3\times10^{-6}$ | 48 | $1.45\times10^{-4}$ |
| | | 17 | 0.223 | $7.0\times10^{-6}$ | 37 | $1.92\times10^{-4}$ |
| | | 18 | 0.233 | $9.7\times10^{-6}$ | 32 | $1.75\times10^{-4}$ |
| | | 19 | 0.263 | $1.6\times10^{-5}$ | 30 | $1.44\times10^{-4}$ |
| | | 20 | 0.236 | $9.3\times10^{-6}$ | 45 | $1.38\times10^{-4}$ |
| | | 21 | 0.236 | $1.97\times10^{-5}$ | 67 | $7.77\times10^{-5}$ |
| | | 22 | 0.189 | $8.3\times10^{-6}$ | 63 | $6.83\times10^{-5}$ |
| | | 23 | 0.209 | $1.07\times10^{-5}$ | 57 | $7.16\times10^{-5}$ |
| | | 24 | 0.199 | $1.8\times10^{-5}$ | 48 | $4.58\times10^{-5}$ |
| | | 25 | 0.163 | $1.2\times10^{-5}$ | 51 | $4.34\times10^{-5}$ |

Table 11-1

| | | No | Matrix | Dopant Added amount | | Average grain diameter (µm) |
|---|---|---|---|---|---|---|
| | | | | Dopant | Added amount (at%) | |
| Embodiment 11 | Quenching | 26 | Si | P | 0.10 | 4.8 |
| | | 27 | Si | P | 1.0 | 3.6 |
| | | 28 | Si | P | 3.0 | 2.9 |
| | | 29 | Si | P | 5.0 | 1.5 |
| | | 30 | Si | Sb | 3.0 | 3.4 |
| | | 31 | Si | Bi | 3.0 | 2.3 |
| | | 32 | Si | P | 1.5 | 2.5 |
| | | | | Nd | 0.5 | |
| | | 33 | Si | Bi | 1.5 | 2.8 |
| | | | | Dy | 0.5 | |
| | | 34 | Si | Cr | 3.0 | 3.1 |
| | | 35 | Si | Fe | 3.0 | 2.5 |
| | | 36 | Si | Nb | 3.0 | 4.3 |
| | | 37 | Si | Ag | 3.0 | 4.8 |
| | | 38 | Si | Nd | 3.0 | 1.2 |
| | | 39 | Si | La | 3.0 | 1.5 |
| | | 40 | Si | Fe | 1.5 | 2.0 |
| | | | Si | La | 1.5 | |

Table 11-2

| | | No | Thermoelectric characteristics | | | |
|---|---|---|---|---|---|---|
| | | | Seebeck coefficient α (mV/K) | Electrical resistance ρ (Ωm) | Thermal conductivity κ (W/mK) | Performance index Z (1/K) |
| Embodiment 11 | Quenching | 26 | 0.228 | $2.6\times10^{-5}$ | 43 | $4.65\times10^{-5}$ |
| | | 27 | 0.430 | $7.2\times10^{-6}$ | 37 | $6.94\times10^{-4}$ |
| | | 28 | 0.462 | $4.8\times10^{-6}$ | 30 | $1.48\times10^{-3}$ |
| | | 29 | 0.408 | $3.6\times10^{-6}$ | 26 | $1.78\times10^{-3}$ |
| | | 30 | 0.370 | $4.8\times10^{-6}$ | 21 | $1.36\times10^{-3}$ |
| | | 31 | 0.326 | $3.4\times10^{-6}$ | 16 | $1.95\times10^{-3}$ |
| | | 32 | 0.394 | $6.4\times10^{-6}$ | 15 | $1.62\times10^{-3}$ |
| | | 33 | 0.306 | $4.2\times10^{-6}$ | 13 | $1.71\times10^{-3}$ |
| | | 34 | 0.270 | $7.2\times10^{-6}$ | 25 | $4.05\times10^{-4}$ |
| | | 35 | 0.368 | $4.2\times10^{-6}$ | 24 | $1.34\times10^{-3}$ |
| | | 36 | 0.286 | $5.0\times10^{-6}$ | 23 | $7.11\times10^{-4}$ |
| | | 37 | 0.41 | $2.8\times10^{-6}$ | 21 | $2.86\times10^{-3}$ |
| | | 38 | 0.492 | $7.2\times10^{-6}$ | 17 | $1.98\times10^{-3}$ |
| | | 39 | 0.422 | $8.4\times10^{-6}$ | 18 | $1.29\times10^{-3}$ |
| | | 40 | 0.426 | $6.4\times10^{-6}$ | 25 | $1.13\times10^{-3}$ |

Table 11-3

| | | No | Matrix | Dopant. Added amount | | Average grain diameter (µm) |
|---|---|---|---|---|---|---|
| | | | | Dopant | Added amount (at%) | |
| Comparison 11 | No quenching (heat treated) | 41 | Si | P | 3.0 | 14 |
| | | 42 | Si | Bi | 3.0 | 17 |
| | | 43 | Si | P | 1.5 | 12 |
| | | | | Nd | 0.5 | |
| | | 44 | Si | Fe | 3.0 | 15 |
| | | 45 | Si | La | 3.0 | 12 |
| | | 46 | Si | P | 3.0 | 36 |
| | | 47 | Si | Bi | 3.0 | 58 |
| | | 48 | Si | P | 1.5 | 27 |
| | | | | Nd | 0.5 | |
| | | 49 | Si | Fe | 3.0 | 39 |
| | | 50 | Si | Nd | 3.0 | 46 |

Table 11-4

| | | No | Thermoelectric characteristics | | | |
|---|---|---|---|---|---|---|
| | | | Seebeck coefficient α (mV/K) | Electrical resistance ρ (Ωm) | Thermal conductivity κ (W/mK) | Performance index Z (1/K) |
| Comparison 11 | No quenching (heat treated) | 41 | 0.370 | $6.5 \times 10^{-6}$ | 48 | $4.39 \times 10^{-4}$ |
| | | 42 | 0.286 | $4.5 \times 10^{-6}$ | 37 | $4.91 \times 10^{-4}$ |
| | | 43 | 0.308 | $7.0 \times 10^{-6}$ | 27 | $5.02 \times 10^{-4}$ |
| | | 44 | 0.306 | $5.8 \times 10^{-6}$ | 34 | $4.75 \times 10^{-4}$ |
| | | 45 | 0.368 | $1.1 \times 10^{-5}$ | 28 | $4.40 \times 10^{-4}$ |
| | | 46 | 0.348 | $7.0 \times 10^{-6}$ | 63 | $2.75 \times 10^{-4}$ |
| | | 47 | 0.25 | $4.3 \times 10^{-6}$ | 52 | $3.00 \times 10^{-4}$ |
| | | 48 | 0.272 | $6.5 \times 10^{-6}$ | 47 | $2.42 \times 10^{-4}$ |
| | | 49 | 0.21 | $8.8 \times 10^{-6}$ | 42 | $1.19 \times 10^{-4}$ |
| | | 50 | 0.246 | $1.3 \times 10^{-5}$ | 37 | $1.26 \times 10^{-4}$ |

Embodiment 12

To produce a p-type silicon semiconductor, high-purity single crystal silicon (10N) and the elements shown in Table 12-1 were measured out in the specified proportions and then arc melted in an argon gas atmosphere. The button-shaped ingots thus obtained were cut into sizes of 5 × 5 × 5 mm, 10 × 10 × 2 mm, and 10 mm diameter × 2 mm to produce samples for measuring the Seebeck coefficient, Hall coefficient (including the electrical resistance), and thermal conductivity of each.

The Seebeck coefficient was determined by using silver for the electrode of the high temperature portion and copper for the electrode of the low temperature portion, setting the temperature differential thereof to 6°C, using a digital multi-meter to measure the thermoelectromotive force of the p-type semiconductor at an average temperature of 200°C for the high and low temperature portions, and dividing this thermoelectromotive force by 6°C.

The Hall coefficient was measured by AC method at 200°C, and electrical resistance was also measured by the four-terminal method at that time. Thermal conductivity was measured at 200°C by laser flash method. These measurement results are given in Table 12-2. All the samples exhibited a higher performance index than a conventional Fe-Si system, but it can be seen that a material whose performance index was equal to or better than that of an Si-Ge system was obtained by keeping the amount of dopant within the range of 0.5 to 10.0 at%.

Embodiment 13

To produce an n-type silicon semiconductor, high-purity single crystal silicon (10N) and the elements shown in Table 13-1 were measured out in the specified proportions and then arc melted in an argon gas atmosphere. The button-shaped ingots thus obtained were cut into sizes of 5 × 5 × 5 mm, 10 × 10 × 2 mm, and 10 mm diameter × 2 mm to produce samples for measuring the Seebeck coefficient, Hall coefficient (including the electrical resistance), and thermal conductivity of each.

The Seebeck coefficient, Hall coefficient, electrical resistance, and thermal conductivity were measured by the same methods as in Embodiment 12. These measurement results axe given in Tables 13-1, 13-2, 13-3, and 13-4. All the samples exhibited a higher performance index than a conventional Fe-Si system, but it can be seen that a material whose performance index was equal to or better than that of an Si-Ge system was obtained by keeping the amount of dopant within the range of 0.5 to 10.0 at%.

Table 12-1

| | No | Matrix | Dopant Added amount | | Carrier concentration (M/m³) |
|---|---|---|---|---|---|
| | | | Dopant | Added amount (at%) | |
| Embodiment 12 | 1 | Si | Y | 0.10 | $1.7\times10^{19}$ |
| | 2 | Si | Y | 0.50 | $8.1\times10^{19}$ |
| | 3 | Si | Y | 1.0 | $1.1\times10^{20}$ |
| | 4 | Si | Y | 5.0 | $2.4\times10^{21}$ |
| | 5 | Si | Y | 10.0 | $6.3\times10^{21}$ |
| | 6 | Si | Y | 15.0 | $1.2\times10^{22}$ |
| | 7 | Si | Mo | 0.10 | $2.4\times10^{19}$ |
| | 8 | Si | Mo | 0.50 | $1.1\times10^{20}$ |
| | 9 | Si | Mo | 5.0 | $1.2\times10^{21}$ |
| | 10 | Si | Mo | 10.0 | $2.2\times10^{21}$ |
| | 11 | Si | Mo | 15.0 | $3.4\times10^{21}$ |
| | 12 | Si | Y | 1.5 | $2.4\times10^{20}$ |
| | | | Mo | 1.5 | |
| | 13 | Si | Zr | 5.0 | $1.6\times10^{20}$ |

Table 12-2

| | No | Thermoelectric characteristics | | | |
|---|---|---|---|---|---|
| | | Seebeck coefficient α (mV/K) | Electrical resistance ρ (Ωm) | Thermal conductivity κ (W/mK) | Performance index Z (1/K) |
| Embodiment 12 | 1 | 0.71 | $8.4\times10^{-4}$ | 62 | $9.7\times10^{-6}$ |
| | 2 | 0.60 | $3.6\times10^{-5}$ | 57 | $1.75\times10^{-4}$ |
| | 3 | 0.43 | $2.1\times10^{-5}$ | 47 | $1.87\times10^{-4}$ |
| | 4 | 0.33 | $6.6\times10^{-6}$ | 33 | $5.0\times10^{-4}$ |
| | 5 | 0.20 | $3.8\times10^{-6}$ | 26 | $4.05\times10^{-4}$ |
| | 6 | 0.03 | $1.6\times10^{-6}$ | 19 | $2.96\times10^{-5}$ |
| | 7 | 0.55 | $3.2\times10^{-4}$ | 63 | $1.50\times10^{-5}$ |
| | 8 | 0.37 | $1.8\times10^{-5}$ | 48 | $1.58\times10^{-4}$ |
| | 9 | 0.26 | $5.1\times10^{-6}$ | 28 | $4.73\times10^{-4}$ |
| | 10 | 0.16 | $3.2\times10^{-6}$ | 22 | $3.64\times10^{-4}$ |
| | 11 | 0.03 | $1.8\times10^{-6}$ | 18 | $2.78\times10^{-5}$ |
| | 12 | 0.33 | $1.1\times10^{-5}$ | 38 | $2.61\times10^{-4}$ |
| | 13 | 0.25 | $4.0\times10^{-6}$ | 27 | $5.79\times10^{-4}$ |

Table 13-1

| | No | Matrix | Dopant Added amount | | Carrier concentration |
|---|---|---|---|---|---|
| | | | Dopant | Added amount (at%) | ($M/m^3$) |
| Embodiment 13 | 14 | Si | Nd | 0.10 | $1.8\times10^{19}$ |
| | 15 | Si | Nd | 0.50 | $7.5\times10^{18}$ |
| | 16 | Si | Nd | 1.0 | $1.2\times10^{20}$ |
| | 17 | Si | Nd | 5.0 | $5.3\times10^{20}$ |
| | 18 | Si | Nd | 10.0 | $1.3\times10^{21}$ |
| | 19 | Si | Nd | 15.0 | $2.8\times10^{21}$ |
| | 20 | Si | Fe | 0.10 | $1.3\times10^{19}$ |
| | 21 | Si | Fe | 0.50 | $3.4\times10^{19}$ |
| | 22 | Si | Fe | 3.0 | $1.8\times10^{20}$ |
| | 23 | Si | Fe | 10.0 | $8.3\times10^{20}$ |
| | 24 | Si | Fe | 15.0 | $1.7\times10^{21}$ |
| | 25 | Si | La | 3.0 | $3.4\times10^{20}$ |
| | 26 | Si | Ce | 3.0 | $3.1\times10^{20}$ |
| | 27 | Si | Pr | 3.0 | $3.5\times10^{20}$ |
| | 28 | Si | Sm | 3.0 | $2.5\times10^{20}$ |
| | 29 | Si | Dy | 3.0 | $3.7\times10^{20}$ |
| | 30 | Si | Ti | 3.0 | $3.2\times10^{20}$ |
| | 31 | Si | V | 3.0 | $3.6\times10^{20}$ |
| | 32 | Si | Cr | 3.0 | $1.8\times10^{20}$ |
| | 33 | Si | Mn | 3.0 | $1.4\times10^{20}$ |

Table 13-2

| | No | Thermoelectric characteristics | | | |
|---|---|---|---|---|---|
| | | Seebeck coefficient α (mV/K) | Electrical resistance ρ (Ωm) | Thermal conductivity κ (W/mK) | Performance index Z (1/K) |
| Embodiment 13 | 14 | 0.72 | $3.5\times10^{-4}$ | 112 | $1.32\times10^{-5}$ |
| | 15 | 0.68 | $3.2\times10^{-5}$ | 98 | $1.47\times10^{-4}$ |
| | 16 | 0.47 | $1.7\times10^{-5}$ | 72 | $1.80\times10^{-4}$ |
| | 17 | 0.40 | $6.0\times10^{-6}$ | 48 | $5.56\times10^{-4}$ |
| | 18 | 0.31 | $3.0\times10^{-6}$ | 35 | $9.15\times10^{-4}$ |
| | 19 | 0.03 | $8.3\times10^{-7}$ | 25 | $4.34\times10^{-5}$ |
| | 20 | 0.68 | $4.3\times10^{-4}$ | 134 | $8.02\times10^{-6}$ |
| | 21 | 0.61 | $2.1\times10^{-5}$ | 105 | $1.69\times10^{-4}$ |
| | 22 | 0.38 | $6.2\times10^{-6}$ | 74 | $3.15\times10^{-4}$ |
| | 23 | 0.31 | $3.4\times10^{-6}$ | 55 | $4.85\times10^{-4}$ |
| | 24 | 0.05 | $1.5\times10^{-6}$ | 42 | $3.97\times10^{-5}$ |
| | 25 | 0.41 | $6.8\times10^{-6}$ | 54 | $4.58\times10^{-4}$ |
| | 26 | 0.36 | $6.4\times10^{-6}$ | 54 | $3.75\times10^{-4}$ |
| | 27 | 0.37 | $6.5\times10^{-6}$ | 52 | $4.05\times10^{-4}$ |
| | 28 | 0.21 | $6.6\times10^{-6}$ | 52 | $1.28\times10^{-4}$ |
| | 29 | 0.44 | $6.2\times10^{-6}$ | 51 | $6.12\times10^{-4}$ |
| | 30 | 0.19 | $3.2\times10^{-6}$ | 83 | $1.36\times10^{-4}$ |
| | 31 | 0.46 | $7.7\times10^{-6}$ | 80 | $3.44\times10^{-4}$ |
| | 32 | 0.44 | $8.4\times10^{-6}$ | 77 | $2.99\times10^{-4}$ |
| | 33 | 0.45 | $8.7\times10^{-6}$ | 76 | $3.06\times10^{-4}$ |

Table 13-3

| | No | Matrix | Dopant Added amount | | Carrier concentration |
|---|---|---|---|---|---|
| | | | Dopant | Added amount (at%) | ($M/m^3$) |
| Embodiment 13 | 34 | Si | Co | 3.0 | $1.6\times10^{20}$ |
| | 35 | Si | Ni | 3.0 | $1.3\times10^{20}$ |
| | 36 | Si | Cu | 3.0 | $1.4\times10^{20}$ |
| | 37 | Si | Nb | 3.0 | $2.6\times10^{20}$ |
| | 38 | Si | Ag | 3.0 | $2.8\times10^{20}$ |
| | 39 | Si | Ce | 1.0 | $3.3\times10^{20}$ |
| | | | Nd | 2.0 | |
| | 40 | Si | Dy | 1.0 | $3.1\times10^{20}$ |
| | | | Zr | 2.0 | |
| | 41 | Si | Nd | 1.0 | $2.2\times10^{20}$ |
| | | | Nb | 2.0 | |
| | | | Fe | 1.0 | |
| | 42 | Si | La | 1.0 | $2.6\times10^{20}$ |
| | | | Dy | 2.0 | |
| | | | Nb | 1.0 | |
| | 43 | Si | La | 1.0 | $1.8\times10^{20}$ |
| | | | Fe | 2.0 | |
| | | | NI | 1.0 | |

Table 13-4

| | No | Thermoelectric characteristics | | | |
|---|---|---|---|---|---|
| | | Seebeck coefficient α (mV/K) | Electrical resistance ρ (Ωm) | Thermal conductivity κ (W/mK) | Performance index Z (1/K) |
| Embodiment 13 | 34 | 0.18 | $3.4\times10^{-6}$ | 74 | $1.29\times10^{-4}$ |
| | 35 | 0.48 | $6.9\times10^{-6}$ | 72 | $4.64\times10^{-4}$ |
| | 36 | 0.43 | $7.3\times10^{-6}$ | 71 | $3.57\times10^{-4}$ |
| | 37 | 0.20 | $3.7\times10^{-6}$ | 63 | $1.72\times10^{-4}$ |
| | 38 | 0.34 | $6.0\times10^{-6}$ | 60 | $3.21\times10^{-4}$ |
| | 39 | 0.38 | $5.9\times10^{-6}$ | 58 | $4.22\times10^{-4}$ |
| | 40 | 0.28 | $6.7\times10^{-6}$ | 58 | $2.02\times10^{-4}$ |
| | 41 | 0.29 | $5.6\times10^{-6}$ | 63 | $2.38\times10^{-4}$ |
| | 42 | 0.38 | $6.9\times10^{-6}$ | 56 | $3.74\times10^{-4}$ |
| | 43 | 0.45 | $9.2\times10^{-6}$ | 60 | $3.67\times10^{-4}$ |

Embodiment 14

To produce a p-type silicon semiconductor, high-purity single crystal silicon (10N) and the elements shown in Table 14-1 were measured out in the specified proportions and then arc melted in an argon gas atmosphere. The button-shaped ingots thus obtained were cut into sizes of 5 × 5 × 5 mm, 10 × 10 × 2 mm, , and 10 mm diameter × 2 mm to produce samples for measuring the Seebeck coefficient, Hall coefficient (including the electrical resistance), and thermal conductivity of each.

The Seebeck coefficient was determined by using silver for the electrode of the high temperature portion and copper for the electrode of the low temperature portion, setting the temperature differential thereof to 5°C, using a digital multi-meter to measure the thermoelectromotive force of the p-type semiconductor at an average temperature of 200°C for the high and low temperature portions, and dividing this thermoelectromotive force by 5°C.

The Hall coefficient was measured by AC method at 200°C, and electrical resistance was also measured by the four-terminal method at that time. Thermal conductivity was measured at 200°C by laser flash method. These measurement results are given in Table 14-2.

All the samples exhibited a higher performance index than a conventional Fe-Si system, but it can be seen that a material whose performance index was equal to or better than that of an Si-Ge system was obtained by keeping the amount of dopant within the range of 0.5 to 10.0 at%.

Embodiment 15

To produce an n-type silicon semiconductor, high-purity single crystal silicon (10N) and the elements shown in Table 15-1 were measured out in the specified proportions and then arc melted in an argon gas atmosphere. The button-shaped ingots thus obtained were cut into sizes of 5 × 5 × 5 mm, 10 × 10 × 2 mm, and 10 mm diameter × 2 mm to produce samples for measuring the Seebeck coefficient, Hall coefficient (including the electrical resistance), and thermal conductivity of each. Doping with nitrogen and oxygen was performed by adding $Si_3N_4$ and $SiO_2$ during the arc melting.

The Seebeck coefficient, Hall coefficient, electrical resistance, and thermal conductivity were measured by the same methods as in Embodiment 1. These measurement results are given in Table 15-2. All the samples exhibited a higher performance index than a conventional Fe-Si system, but it can be seen that a material whose performance index was equal to or better than that of an Si-Ge system was obtained by keeping the amount of dopant within the range of 0.5 to 10.0 at%.

Comparison

To produce n-type and p-type Si-Ge semiconductors, silicon and polycrystalline germanium (4N) were blended in an atomic ratio of 4:1, the elements shown 'in Tables 14-1 and 15-1 Nos. 29, 30, 59, and 60 were measured out in the specified proportions and these components were arc melted in an argon gas atmosphere. After melting, measurement samples were worked into the same shapes as in Embodiment 14, and the measurement conditions were the same as in Embodiment 1.

As is clear from Tables 14-2 and 15-2, the performance index Z of the embodiments in which various elements were added to silicon alone (Nos. 1 to 28 and Nos. 31 to 58) was equal to or better than the performance index of the comparisons in which various elements were added to an Si-Ge system (Si:Ge = 4:1) (Nos. 29, 30, 59, and 60).

Furthermore, the performance index of the embodiments in which the added amounts of the dopants in Table 14-1 were 0.5 to 5.0 at% and the carrier concentration was between $10^{19}$ to $10^{21}$ ($M/m^3$) was markedly higher than the performance index Z of Comparison Nos. 29 and 30. Similarly, it can be seen that the performance index of the embodiments in which the added amounts of the dopants in Table 15-2 were 0.5 to 10.0 at% and the carrier concentration was between $10^{19}$ to $10^{21}$ ($M/m^3$) was far higher than the performance index of Comparison Nos. 59 and 60.

In particular, it can be seen in Tables 14-2 and 15-2 that the Seebeck coefficient is higher, electrical resistance is lower, and the performance index is markedly higher the greater is the doping amount if the added amount of dopants is within the range of 0.5 to 10.0 at% in Table 1 and 0.5 to 10.0 at% in Table 4.

Table 14-1

| | No | Matrix | Dopant | | Dopant | |
|---|---|---|---|---|---|---|
| | | | Element name | Added amount (at%) | Element name | Added amount (at%) |
| Embodiment 14 | 1 | Si | Al | 0.1 | Y | 0.1 |
| | 2 | Si | Al | 0.3 | Y | 0.2 |
| | 3 | Si | Al | 1.5 | Y | 1.5 |
| | 4 | Si | Al | 4 | Y | 2 |
| | 5 | Si | Al | 8 | Y | 3 |
| | 6 | Si | Al | 1.5 | Mo | 1.5 |
| | 7 | Si | Al | 0.1 | Zr | 0.1 |
| | 8 | Si | Al | 0.3 | Zr | 0.2 |
| | 9 | Si | Al | 1.5 | Zr | 1.5 |
| | 10 | Si | Al | 3 | Zr | 2 |
| | 11 | Si | Al | 8 | Zr | 3 |
| | 12 | Si | Al | 0.1 | La | 0.1 |
| | 13 | Si | Al | 0.3 | La | 0.2 |
| | 14 | Si | Al | 1.5 | La | 1.5 |
| | 15 | Si | Al | 3 | La | 2 |
| | 16 | Si | Al | 8 | La | 3 |
| | 17 | Si | Al | 1.5 | Ce | 1.5 |
| | 18 | Si | Al | 1.5 | Pr | 1.5 |
| | 19 | Si | Al | 1.5 | Nd | 1.5 |
| | 20 | Si | Al | 1.5 | Sm | 1.5 |
| | 21 | Si | Al | 1.5 | Dy | 1.5 |
| | 22 | Si | Ga | 0.1 | Zr | 0.1 |
| | 23 | Si | Ga | 0.3 | Zr | 0.2 |
| | 24 | Si | Ga | 1.5 | Zr | 1.5 |
| | 25 | Si | Ga | 3 | Zr | 2 |
| | 26 | Si | Ga | 8 | Zr | 3 |
| | 27 | Si | In | 1.5 | Zr | 1.5 |
| | 28 | Si | Be | 1.5 | Zr | 1.5 |
| Comparison | 29 | Si-Ge | Al | 3 | | |
| | 30 | Si-Ge | Ga | 3 | | |

Table 14-2

| | No | Carrier concentration n (M/m³) | Thermoelectric characteristics Seebeck coefficient α (mV/K) | Electrical resistance ρ (Ωm) | Thermal conductivity κ (W/m·K) | Performance index Z (1/K) |
|---|---|---|---|---|---|---|
| Embodiment 14 | 1 | $4.30\times10^{17}$ | 0.45 | $7.80\times10^{-4}$ | 106 | $2.5\times10^{-6}$ |
| | 2 | $1.02\times10^{19}$ | 0.39 | $7.20\times10^{-6}$ | 89 | $2.4\times10^{-4}$ |
| | 3 | $5.60\times10^{19}$ | 0.46 | $5.40\times10^{-6}$ | 78 | $5.0\times10^{-4}$ |
| | 4 | $7.30\times10^{20}$ | 0.26 | $1.10\times10^{-6}$ | 65 | $9.5\times10^{-4}$ |
| | 5 | $2.60\times10^{21}$ | 0.07 | $7.60\times10^{-7}$ | 59 | $1.0\times10^{-4}$ |
| | 6 | $6.80\times10^{19}$ | 0.34 | $6.20\times10^{-6}$ | 64 | $2.9\times10^{-4}$ |
| | 7 | $6.20\times10^{17}$ | 0.19 | $4.80\times10^{-5}$ | 95 | $7.9\times10^{-6}$ |
| | 8 | $2.10\times10^{19}$ | 0.34 | $6.90\times10^{-6}$ | 79 | $2.1\times10^{-4}$ |
| | 9 | $5.70\times10^{20}$ | 0.37 | $4.90\times10^{-6}$ | 72 | $3.9\times10^{-4}$ |
| | 10 | $6.40\times10^{20}$ | 0.20 | $1.30\times10^{-6}$ | 66 | $4.7\times10^{-4}$ |
| | 11 | $1.90\times10^{21}$ | 0.04 | $7.60\times10^{-7}$ | 61 | $3.5\times10^{-5}$ |
| | 12 | $6.30\times10^{18}$ | 0.21 | $1.4\times10^{-4}$ | 67 | $4.9\times10^{-6}$ |
| | 13 | $3.10\times10^{19}$ | 0.33 | $9.4\times10^{-6}$ | 41 | $2.9\times10^{-4}$ |
| | 14 | $8.90\times10^{19}$ | 0.40 | $4.6\times10^{-6}$ | 32 | $1.1\times10^{-3}$ |
| | 15 | $3.60\times10^{20}$ | 0.31 | $2.4\times10^{-6}$ | 29 | $1.4\times10^{-3}$ |
| | 16 | $1.00\times10^{21}$ | 0.04 | $1.7\times10^{-6}$ | 25 | $3.7\times10^{-5}$ |
| | 17 | $1.02\times10^{20}$ | 0.41 | $2.4\times10^{-6}$ | 35 | $2.0\times10^{-3}$ |
| | 18 | $4.90\times10^{20}$ | 0.36 | $1.9\times10^{-6}$ | 45 | $1.5\times10^{-3}$ |
| | 19 | $9.20\times10^{19}$ | 0.44 | $2.6\times10^{-6}$ | 38 | $2.0\times10^{-3}$ |
| | 20 | $1.80\times10^{20}$ | 0.49 | $2.0\times10^{-6}$ | 36 | $3.4\times10^{-3}$ |
| | 21 | $7.40\times10^{20}$ | 0.31 | $1.6\times10^{-6}$ | 42 | $1.4\times10^{-3}$ |
| | 22 | $6.70\times10^{17}$ | 0.19 | $9.60\times10^{-5}$ | 94 | $4.0\times10^{-6}$ |
| | 23 | $4.90\times10^{19}$ | 0.33 | $1.30\times10^{-5}$ | 88 | $9.5\times10^{-5}$ |
| | 24 | $3.70\times10^{20}$ | 0.44 | $7.90\times10^{-6}$ | 67 | $3.7\times10^{-4}$ |
| | 25 | $9.80\times10^{20}$ | 0.23 | $3.30\times10^{-6}$ | 46 | $3.5\times10^{-4}$ |
| | 26 | $2.40\times10^{21}$ | 0.06 | $9.60\times10^{-7}$ | 45 | $8.3\times10^{-6}$ |
| | 27 | $2.80\times10^{20}$ | 0.34 | $8.30\times10^{-6}$ | 54 | $2.6\times10^{-4}$ |
| | 28 | $1.80\times10^{20}$ | 0.30 | $6.70\times10^{-6}$ | 58 | $2.3\times10^{-4}$ |
| Comparison | 29 | $4.50\times10^{19}$ | 0.30 | $2.80\times10^{-5}$ | 15 | $1.1\times10^{-4}$ |
| | 30 | $3.70\times10^{19}$ | 0.26 | $3.40\times10^{-5}$ | 9 | $7.4\times10^{-5}$ |

Table 15-1

| | No | Matrix | Dopant | | Dopant | |
|---|---|---|---|---|---|---|
| | | | Element name | Added amount (at%) | Element name | Added amount (at%) |
| Embodiment 15 | 31 | Si | Bi | 0.1 | Ti | 0.1 |
| | 32 | Si | Bi | 0.5 | Ti | 0.5 |
| | 33 | Si | Bi | 1.5 | Ti | 1.5 |
| | 34 | Si | Bi | 3 | Ti | 3 |
| | 35 | Si | Bi | 6 | Ti | 6 |
| | 36 | Si | Bi | 1.5 | V | 1.5 |
| | 37 | Si | Bi | 1.5 | Mn | 1.5 |
| | 38 | Si | Bi | 1.5 | Fe | 1.5 |
| | 39 | Si | Bi | 1.5 | Co | 1.5 |
| | 40 | Si | Bi | 0.1 | Ni | 0.1 |
| | 41 | Si | Bi | 0.5 | Ni | 0.5 |
| | 42 | Si | Bi | 1.5 | Ni | 1.5 |
| | 43 | Si | Bi | 3 | Ni | 3 |
| | 44 | Si | Bi | 6 | Ni | 6 |
| | 45 | Si | Bi | 1.5 | Cu | 1.5 |
| | 46 | Si | Bi | 0.1 | La | 0.1 |
| | 47 | Si | Bi | 0.5 | La | 0.5 |
| | 48 | Si | Bi | 1.5 | La | 1.5 |
| | 49 | Si | Bi | 3 | La | 3 |
| | 50 | Si | Bi | 6 | La | 6 |
| | 51 | Si | Bi | 1.5 | Ce | 1.5 |
| | 52 | Si | Bi | 1.5 | Pr | 1.5 |
| | 53 | Si | Bi | 1.5 | Nd | 1.5 |
| | 54 | Si | Bi | 1.5 | Sm | 1.5 |
| | 55 | Si | Bi | 1.5 | Dy | 1.5 |
| | 56 | Si | P | 1.5 | Ni | 1.5 |
| | 57 | Si | O | 0.75 | Ni | 1.5 |
| | 58 | Si | N | 1.5 | Ni | 1.5 |
| Comparison | 59 | Si-Ge | P | 3 | | |
| | 60 | Si-Ge | Bi | 3 | | |

Table 15-2

| | No | Carrier concentration n (M/m³) | Thermoelectric characteristics | | | |
|---|---|---|---|---|---|---|
| | | | Seebeck coefficient α (mV/K) | Electrical resistance ρ (Ωm) | Thermal conductivity κ (W/m·K) | Performance index Z (1/K) |
| Embodiment 15 | 31 | $7.90\times10^{17}$ | 0.40 | $3.60\times10^{-4}$ | 93 | $4.8\times10^{-6}$ |
| | 32 | $3.70\times10^{19}$ | 0.30 | $2.60\times10^{-5}$ | 68 | $5.1\times10^{-5}$ |
| | 33 | $2.40\times10^{20}$ | 0.38 | $4.80\times10^{-6}$ | 45 | $6.7\times10^{-4}$ |
| | 34 | $5.70\times10^{20}$ | 0.28 | $2.4\times10^{-6}$ | 37 | $9.0\times10^{-4}$ |
| | 35 | $1.60\times10^{21}$ | 0.02 | $8.20\times10^{-7}$ | 32 | $1.5\times10^{-5}$ |
| | 36 | $6.30\times10^{19}$ | 0.34 | $6.20\times10^{-6}$ | 41 | $4.5\times10^{-4}$ |
| | 37 | $7.20\times10^{19}$ | 0.36 | $6.50\times10^{-6}$ | 39 | $5.1\times10^{-4}$ |
| | 38 | $7.20\times10^{19}$ | 0.36 | $6.50\times10^{-6}$ | 39 | $5.1\times10^{-4}$ |
| | 39 | $7.80\times10^{19}$ | 0.32 | $8.60\times10^{-6}$ | 34 | $3.5\times10^{-4}$ |
| | 40 | $4.10\times10^{18}$ | 0.40 | $7.90\times10^{-4}$ | 42 | $4.8\times10^{-6}$ |
| | 41 | $8.60\times10^{19}$ | 0.22 | $4.70\times10^{-6}$ | 42 | $2.5\times10^{-4}$ |
| | 42 | $7.40\times10^{20}$ | 0.28 | $2.0\times10^{-6}$ | 42 | $9.5\times10^{-4}$ |
| | 43 | $7.40\times10^{20}$ | 0.26 | $1.3\times10^{-6}$ | 38 | $1.4\times10^{-3}$ |
| | 44 | $7.40\times10^{20}$ | 0.02 | $1.1\times10^{-6}$ | 33 | $1.1\times10^{-5}$ |
| | 45 | $4.60\times10^{20}$ | 0.30 | $3.40\times10^{-6}$ | 48 | $5.5\times10^{-4}$ |
| | 46 | $2.70\times10^{18}$ | 0.35 | $4.20\times10^{-4}$ | 68 | $4.3\times10^{-6}$ |
| | 47 | $6.90\times10^{19}$ | 0.42 | $9.40\times10^{-5}$ | 34 | $5.5\times10^{-5}$ |
| | 48 | $3.50\times10^{20}$ | 0.36 | $7.4\times10^{-6}$ | 31 | $5.6\times10^{-4}$ |
| | 49 | $6.70\times10^{20}$ | 0.32 | $5.2\times10^{-6}$ | 29 | $7.0\times10^{-4}$ |
| | 50 | $1.40\times10^{21}$ | 0.02 | $2.6\times10^{-6}$ | 27 | $5.7\times10^{-6}$ |
| | 51 | $3.90\times10^{20}$ | 0.38 | $6.8\times10^{-6}$ | 29 | $7.3\times10^{-4}$ |
| | 52 | $4.60\times10^{20}$ | 0.34 | $5.6\times10^{-6}$ | 27 | $7.6\times10^{-4}$ |
| | 53 | $4.10\times10^{20}$ | 0.36 | $6.2\times10^{-6}$ | 33 | $6.3\times10^{-4}$ |
| | 54 | $4.70\times10^{20}$ | 0.34 | $5.8\times10^{-6}$ | 30 | $6.6\times10^{-4}$ |
| | 55 | $5.30\times10^{20}$ | 0.30 | $5.0\times10^{-6}$ | 34 | $5.3\times10^{-4}$ |
| | 56 | $8.90\times10^{20}$ | 0.33 | $4.0\times10^{-6}$ | 41 | $6.6\times10^{-4}$ |
| | 57 | $6.90\times10^{20}$ | 0.32 | $4.8\times10^{-6}$ | 45 | $4.7\times10^{-4}$ |
| | 58 | $6.50\times10^{20}$ | 0.29 | $5.4\times10^{-6}$ | 44 | $3.5\times10^{-4}$ |
| Comparison | 59 | $1.02\times10^{20}$ | 0.27 | $3.80\times10^{-5}$ | 8 | $8.0\times10^{-5}$ |
| | 60 | $9.70\times10^{19}$ | 0.24 | $2.60\times10^{-5}$ | 13 | $8.5\times10^{-5}$ |

Embodiment 16

To produce a p-type silicon semiconductor, high-purity single crystal silicon (10N) and the various elements shown in Table 16-1 were measured out in the specified proportions and then arc melted in an argon gas atmosphere. The button-shaped ingots thus obtained were coarsely ground and ground in a disk mill, after which they were ground in a jet mill to produce powders with the average particle diameters shown in Table 16-1 Each powder was then held for 3 hours under the hot pressing conditions shown in Tables 16-2 and 16-3 to produce sinters having various porosities as shown in Table 16-2.

The button-shaped ingots thus obtained were mechanically alloyed for 50 hours in an argon atmosphere, after which they were held for 3 hours under the hot pressing conditions shown in Tables 16-4 and 16-5 to produce sinters having various average grain diameters shown in Table 16-4.

The sinters thus obtained were cut into sizes of 5 × 5 × 5 mm, 10 × 10 × 2 mm, and 10 mm outside diameter × 2 mm to produce samples for measuring the Seebeck coefficient, Hall coefficient (including the electrical resistance), and thermal conductivity of each.

The Seebeck coefficient was determined by using silver for the electrode of the high temperature portion and copper for the electrode of the low temperature portion, setting the temperature differential thereof to 6°C, using a digital multi-meter to measure the thermoelectromotive force of the p-type semiconductor at an average temperature of 200°C for the high and low temperature portions, and dividing this thermoelectromotive force by 6°C.

The Hall coefficient was measured by AC method at 200°C, and electrical resistance was also measured by the four-terminal method at that time. Thermal conductivity was measured at 200°C by laser flash method. These measurement results are given in Tables 16-3 and 16-5.

Embodiment 17

To produce an n-type silicon semiconductor, high-purity single crystal silicon (10N) and the various elements shown in Table 17-1 were measured out in the specified proportions and then arc melted in an argon gas atmosphere. The button-shaped ingots thus obtained were coarsely ground and ground in a disk mill, after which they were ground in a jet mill to produce powders with the average particle diameters shown in Table 17-1. Each powder was then held for 3 hours under the hot pressing conditions shown in Table 17-2 to produce sinters having various porosities as shown in Table 17-3.

The button-shaped ingots thus obtained were mechanically alloyed for 50 hours in an argon atmosphere, after which they were held for 3 hours under the hot pressing conditions shown in Table 17-4 to produce sinters having various average grain diameters shown in Table 17-5. The measurement conditions for thermoelectric characteristics were the same as in Embodiment 1. These measurement results are given in Tables 17-3 and 17-5.

Table 16-1

| | Sample No | Matrix | Dopant Added amount: Dopant | Dopant Added amount: Added amount (at%) | Carrier concentration ($M/m^3$) | Average ground particle diameter μm |
|---|---|---|---|---|---|---|
| Embodiment 16 | 1 | Si | Al | 3.0 | $1.1 \times 10^{21}$ | 2.7 |
| | 2 | Si | Ga | 3.0 | $1.2 \times 10^{21}$ | 3.0 |
| | 3 | Si | Zn | 3.0 | $1.8 \times 10^{21}$ | 2.8 |
| | 4 | Si | Be | 3.0 | $1.0 \times 10^{21}$ | 3.2 |
| | 5 | Si | Mo | 3.0 | $0.9 \times 10^{21}$ | 2.9 |
| | 6 | Si | Al | 1.5 | $1.0 \times 10^{21}$ | 3.0 |
| | | | Mo | 1.5 | | |

Table 16-2

| | No | Sample No | Hot pressing conditions | | Porosity % | Average grain diameter µm |
|---|---|---|---|---|---|---|
| | | | Temperature ℃ | Pressure MP | | |
| Embodiment 16 | 1 | 1 | ---- | ---- | 0 | 15 |
| | 2 | 1 | 1000 | 49 | 47 | 3 |
| | 3 | 1 | 1000 | 98 | 40 | 4 |
| | 4 | 1 | 1000 | 196 | 32 | 5 |
| | 5 | 1 | 1000 | 294 | 26 | 5 |
| | 6 | 1 | 1200 | 49 | 15 | 8 |
| | 7 | 1 | 1200 | 98 | 11 | 9 |
| | 8 | 1 | 1200 | 147 | 8 | 10 |
| | 9 | 1 | 1200 | 196 | 6 | 12 |
| | 10 | 1 | 1200 | 245 | 5 | 13 |
| | 11 | 1 | 1250 | 245 | 2 | 15 |
| | 12 | 2 | 1000 | 196 | 28 | 6 |
| | 13 | 3 | 1000 | 196 | 31 | 6 |

Table 16-3

| | No | Sample No | Thermoelectric resistance | | | |
|---|---|---|---|---|---|---|
| | | | Seebeck coefficient α (mV/K) | Electrical resistance ρ (Ωm) | Thermal conductivity κ (W/mK) | Performance index Z (1/K) |
| Embodiment 16 | 1 | 1 | 0.40 | $1.2\times10^{-5}$ | 56 | $2.3\times10^{-4}$ |
| | 2 | 1 | 0.30 | $2.8\times10^{-5}$ | 19 | $1.7\times10^{-4}$ |
| | 3 | 1 | 0.36 | $1.5\times10^{-5}$ | 24 | $3.7\times10^{-4}$ |
| | 4 | 1 | 0.37 | $1.4\times10^{-5}$ | 33 | $3.1\times10^{-4}$ |
| | 5 | 1 | 0.39 | $1.3\times10^{-5}$ | 37 | $3.1\times10^{-4}$ |
| | 6 | 1 | 0.40 | $1.3\times10^{-5}$ | 42 | $2.8\times10^{-4}$ |
| | 7 | 1 | 0.40 | $1.3\times10^{-5}$ | 44 | $2.8\times10^{-4}$ |
| | 8 | 1 | 0.40 | $1.3\times10^{-5}$ | 46 | $2.7\times10^{-4}$ |
| | 9 | 1 | 0.40 | $1.2\times10^{-5}$ | 47 | $2.6\times10^{-4}$ |
| | 10 | 1 | 0.40 | $1.2\times10^{-5}$ | 50 | $2.6\times10^{-4}$ |
| | 11 | 1 | 0.40 | $1.2\times10^{-5}$ | 55 | $2.4\times10^{-4}$ |
| | 12 | 2 | 0.49 | $1.4\times10^{-5}$ | 36 | $4.8\times10^{-4}$ |
| | 13 | 3 | 0.46 | $1.4\times10^{-5}$ | 34 | $4.3\times10^{-4}$ |

Table 16-4

| | No | Sample No | Hot pressing conditions | | Porosity % | Average grain diameter µm |
|---|---|---|---|---|---|---|
| | | | Temperature °C | Pressure MP | | |
| Embodiment 16 | 14 | 1 | 800 | 294 | 12 | 0.05 |
| | 15 | 1 | 900 | 245 | 10 | 0.10 |
| | 16 | 1 | 1000 | 196 | 10 | 0.90 |
| | 17 | 1 | 1100 | 98 | 9 | 2.4 |
| | 18 | 1 | 1200 | 49 | 8 | 5.0 |
| | 19 | 1 | 1250 | 24 | 7 | 8.4 |
| | 20 | 2 | 1100 | 98 | 8 | 3.1 |
| | 21 | 3 | 1100 | 98 | 8 | 2.8 |
| | 22 | 4 | 800 | 294 | 15 | 0.11 |
| | 23 | 4 | 900 | 294 | 8 | 0.35 |
| | 24 | 5 | 800 | 294 | 19 | 0.12 |
| | 25 | 5 | 900 | 294 | 11 | 0.31 |
| | 26 | 6 | 800 | 294 | 9 | 0.14 |

Table 16-5

| | No | Sample No | Thermoelectric resistance | | | |
|---|---|---|---|---|---|---|
| | | | Seebeck coefficient α (mV/K) | Electrical resistance ρ (Ωm) | Thermal conductivity κ (W/mK) | Performance index Z (1/K) |
| Embodiment 16 | 14 | 1 | 0.37 | $3.3\times10^{-5}$ | 19 | $2.2\times10^{-4}$ |
| | 15 | 1 | 0.40 | $2.1\times10^{-5}$ | 21 | $3.6\times10^{-4}$ |
| | 16 | 1 | 0.40 | $1.6\times10^{-5}$ | 24 | $4.2\times10^{-4}$ |
| | 17 | 1 | 0.40 | $1.4\times10^{-5}$ | 27 | $4.2\times10^{-4}$ |
| | 18 | 1 | 0.40 | $1.3\times10^{-5}$ | 32 | $3.9\times10^{-4}$ |
| | 19 | 1 | 0.40 | $1.2\times10^{-5}$ | 45 | $3.0\times10^{-4}$ |
| | 20 | 2 | 0.47 | $1.4\times10^{-5}$ | 29 | $5.4\times10^{-4}$ |
| | 21 | 3 | 0.49 | $1.5\times10^{-5}$ | 27 | $5.9\times10^{-4}$ |
| | 22 | 4 | 0.31 | $3.6\times10^{-5}$ | 20 | $1.3\times10^{-4}$ |
| | 23 | 4 | 0.37 | $2.6\times10^{-5}$ | 22 | $2.4\times10^{-4}$ |
| | 24 | 5 | 0.36 | $3.7\times10^{-5}$ | 21 | $1.7\times10^{-4}$ |
| | 25 | 5 | 0.39 | $3.0\times10^{-5}$ | 24 | $2.1\times10^{-4}$ |
| | 26 | 6 | 0.34 | $3.4\times10^{-5}$ | 23 | $1.5\times10^{-4}$ |

Table 17-1

| | Sample No | Matrix | Dopant Added amount | | Carrier concentration (M/m³) | Average ground particle diameter µm |
|---|---|---|---|---|---|---|
| | | | Dopant | Added amount (at%) | | |
| Embodiment 17 | 7 | Si | P | 3.0 | $2.8\times10^{20}$ | 2.6 |
| | 8 | Si | Sb | 3.0 | $2.8\times10^{20}$ | 2.8 |
| | 9 | Si | Bi | 3.0 | $3.5\times10^{20}$ | 2.8 |
| | 10 | Si | Cr | 3.0 | $3.4\times10^{20}$ | 3.5 |
| | 11 | Si | La | 3.0 | $3.5\times10^{20}$ | 2.9 |
| | 12 | Si | P | 1.5 | $3.0\times10^{20}$ | 3.4 |
| | | | Cr | 1.5 | | |
| | 13 | Si | P | 1.0 | $3.2\times10^{20}$ | 3.1 |
| | | | Cr | 1.0 | | |
| | | | La | 1.0 | | |

Table 17-2

| | No | Sample No | Hot pressing conditions Temperature ℃ | Pressure MP | Porosity % | Average grain diameter µm |
|---|---|---|---|---|---|---|
| Embodiment 17 | 27 | 7 | ---- | ---- | 0 | 14 |
| | 28 | 7 | 1000 | 49 | 45 | 3 |
| | 29 | 7 | 1000 | 98 | 40 | 4 |
| | 30 | 7 | 1000 | 196 | 31 | 5 |
| | 31 | 7 | 1000 | 294 | 24 | 6 |
| | 32 | 7 | 1200 | 49 | 17 | 8 |
| | 33 | 7 | 1200 | 98 | 13 | 9 |
| | 34 | 7 | 1200 | 147 | 9 | 10 |
| | 35 | 7 | 1200 | 196 | 7 | 12 |
| | 36 | 7 | 1200 | 245 | 5 | 13 |
| | 37 | 7 | 1250 | 245 | 2 | 14 |
| | 38 | 8 | 1000 | 196 | 27 | 6 |
| | 39 | 9 | 1000 | 196 | 30 | 6 |

Table 17-3

| | No | Sample No | Thermoelectric resistance | | | |
|---|---|---|---|---|---|---|
| | | | Seebeck coefficient α (mV/K) | Electrical resistance ρ (Ωm) | Thermal conductivity κ (W/mK) | Performance index Z (1/K) |
| Embodiment 17 | 27 | 7 | 0.33 | $1.3\times10^{-5}$ | 30 | $2.8\times10^{-4}$ |
| | 28 | 7 | 0.17 | $2.9\times10^{-5}$ | 9 | $1.1\times10^{-4}$ |
| | 29 | 7 | 0.29 | $1.9\times10^{-5}$ | 13 | $3.4\times10^{-4}$ |
| | 30 | 7 | 0.30 | $1.7\times10^{-5}$ | 15 | $3.5\times10^{-4}$ |
| | 31 | 7 | 0.31 | $1.6\times10^{-5}$ | 17 | $3.5\times10^{-4}$ |
| | 32 | 7 | 0.33 | $1.4\times10^{-5}$ | 19 | $4.1\times10^{-4}$ |
| | 33 | 7 | 0.33 | $1.4\times10^{-5}$ | 21 | $3.7\times10^{-4}$ |
| | 34 | 7 | 0.33 | $1.4\times10^{-5}$ | 22 | $3.5\times10^{-4}$ |
| | 35 | 7 | 0.33 | $1.4\times10^{-5}$ | 23 | $3.4\times10^{-4}$ |
| | 36 | 7 | 0.33 | $1.3\times10^{-5}$ | 25 | $3.4\times10^{-4}$ |
| | 37 | 7 | 0.33 | $1.3\times10^{-5}$ | 29 | $2.9\times10^{-4}$ |
| | 38 | 8 | 0.36 | $1.6\times10^{-5}$ | 18 | $4.5\times10^{-4}$ |
| | 39 | 9 | 0.37 | $1.7\times10^{-5}$ | 17 | $4.7\times10^{-4}$ |

Table 17-4

| | No | Sample No | Hot pressing conditions | | Porosity % | Average grain diameter µm |
|---|---|---|---|---|---|---|
| | | | Temperature ℃ | Pressure MP | | |
| Embodiment 17 | 40 | 7 | 800 | 294 | 9 | 0.06 |
| | 41 | 7 | 900 | 245 | 8 | 0.10 |
| | 42 | 7 | 1000 | 196 | 7 | 1.0 |
| | 43 | 7 | 1100 | 98 | 7 | 2.3 |
| | 44 | 7 | 1200 | 49 | 5 | 5.0 |
| | 45 | 7 | 1250 | 24 | 4 | 8.6 |
| | 46 | 8 | 1100 | 98 | 5 | 3.4 |
| | 47 | 9 | 1100 | 98 | 5 | 3.5 |
| | 48 | 10 | 1000 | 196 | 11 | 1.4 |
| | 49 | 11 | 1000 | 196 | 9 | 1.8 |
| | 50 | 12 | 1000 | 196 | 9 | 1.5 |
| | 51 | 12 | 1100 | 98 | 8 | 2.4 |
| | 52 | 13 | 1000 | 196 | 8 | 1.2 |

Table 17-5

| | No | Sample No | Thermoelectric resistance | | | |
|---|---|---|---|---|---|---|
| | | | Seebeck coefficient α (mV/K) | Electrical resistance ρ (Ωm) | Thermal conductivity κ (W/mK) | Performance index Z (1/K) |
| Embodiment 17 | 40 | 7 | 0.30 | $2.9\times10^{-5}$ | 13 | $2.4\times10^{-4}$ |
| | 41 | 7 | 0.33 | $1.7\times10^{-5}$ | 16 | $4.0\times10^{-4}$ |
| | 42 | 7 | 0.33 | $1.6\times10^{-5}$ | 19 | $3.6\times10^{-4}$ |
| | 43 | 7 | 0.33 | $1.5\times10^{-5}$ | 21 | $3.5\times10^{-4}$ |
| | 44 | 7 | 0.33 | $1.4\times10^{-5}$ | 24 | $3.2\times10^{-4}$ |
| | 45 | 7 | 0.33 | $1.4\times10^{-5}$ | 26 | $3.0\times10^{-4}$ |
| | 46 | 8 | 0.37 | $1.5\times10^{-5}$ | 24 | $3.8\times10^{-4}$ |
| | 47 | 9 | 0.39 | $1.6\times10^{-5}$ | 23 | $4.1\times10^{-4}$ |
| | 48 | 10 | 0.29 | $2.5\times10^{-5}$ | 25 | $1.3\times10^{-4}$ |
| | 49 | 11 | 0.34 | $1.6\times10^{-5}$ | 17 | $4.3\times10^{-4}$ |
| | 50 | 12 | 0.30 | $1.8\times10^{-5}$ | 24 | $2.1\times10^{-4}$ |
| | 51 | 12 | 0.33 | $1.6\times10^{-5}$ | 27 | $2.5\times10^{-4}$ |
| | 52 | 13 | 0.31 | $1.1\times10^{-5}$ | 21 | $4.2\times10^{-4}$ |

Embodiment 18

To produce a p-type silicon semiconductor, high-purity silicon (10N) or low-purity silicon (3N) and the silicon-based compounds shown in Table 18-1 were compounded in the specified proportions, after which they were arc melted in an argon gas atmosphere. The added amounts in the melting were adjusted such that the carrier concentration would be $10^{20}$ (M/m$^3$).

The button-shaped ingots thus obtained were cut into sizes of 5 × 5 × 5 mm, 10 × 10 × 2 mm, and 10 mm outside diameter × 2 mm, and the Seebeck coefficient, Hall coefficient (including the carrier concentration and electrical resistance), and thermal conductivity of each were measured.

The Seebeck coefficient was determined by using silver for the electrode of the high temperature portion and copper for the electrode of the low temperature portion, setting the temperature differential thereof to 6°C, using a digital multi-meter to measure the thermoelectromotive force of the p-type semiconductor at an average temperature of 200°C for the high and low temperature portions, and dividing this thermoelectromotive force by 6°C.

The Hall coefficient was measured by AC method at 200°C, and electrical resistance was also measured by the four-terminal method at that time. Thermal conductivity was measured at 200°C by laser flash method. These measurement results are given in Tables 18-1 and 18-2.

As is clear from Tables 18-1 and 18-2, when the dopant is a silicon compound, very little of the molten dopant evaporates and scatters, as indicated by the analysis values after melting, with at least 95% of the dopant remaining. This makes it possible to control the added amount more accurately, which results in a better performance index.

Embodiment 19

To produce an n-type silicon semiconductor, high-purity silicon (10N) or low-purity silicon (3N) and the silicon-based compounds shown in Table 19-1 were compounded in the specified proportions, after which they were arc melted in an argon gas atmosphere. The added amounts in the melting were adjusted such that the carder concentration would be $10^{20}$ ($M/m^3$).

The button-shaped ingots thus obtained were cut into sizes of 5 × 5 × 5 mm, 10 × 10 × 2 mm, and 10 mm outside diameter × 2 mm, and the Seebeck coefficient, Hall coefficient (including the carrier concentration and electrical resistance), and thermal conductivity of each were measured. These measurement results are given in Tables 19-1 and 19-2.

As is clear from Tables 19-1 and 19-2, when the dopant is a silicon compound, very little of the molten dopant evaporates and scatters, as indicated by the analysis values after melting, with at least 95% of the dopant remaining. This makes it possible to control the added amount more accurately, which results in a better performance index.

Table 18-1

| No | Purity of matrix silicon | Dopant | | | Analysis value after melting (at%) | Carrier concentration n($M/m^3$) |
|---|---|---|---|---|---|---|
| | | Element name | Added substance | Added amount of dopant (at%) | | |
| 1 | 10N | Al | $Al_4Si$ | 3.00 | 2.95 | $1.6\times10^{20}$ |
| 2 | 10N | B | $B_4Si$ | 3.00 | 2.82 | $1.0\times10^{20}$ |
| 3 | 10N | Mg | $Mg_2Si$ | 3.00 | 2.89 | $3.2\times10^{20}$ |
| 4 | 10N | Ba | $Ba_2Si$ | 3.00 | 2.91 | $2.5\times10^{20}$ |
| 5 | 3N | Al | $Al_4Si$ | 3.00 | 2.94 | $1.5\times10^{20}$ |
| 6 | 10N | B | $B_4Si$ | 3.00 | 2.95 | $1.0\times10^{20}$ |
| 7 | 10N | Y | $Y_3Si_5$ | 3.00 | 2.85 | $1.2\times10^{20}$ |
| 8 | 10N | Mo | $Mo_3Si$ | 3.00 | 2.91 | $1.8\times10^{20}$ |
| 9 | 10N | Al,B | $AlB_2$ | 3.00 | 2.65 | $8.7\times10^{19}$ |
| 10 | 3N | Al | Al | 3.00 | 2.35 | $9.9\times10^{19}$ |

Table 18-2

| No | Purity of matrix silicon | Thermoelectric resistance | | | |
|---|---|---|---|---|---|
| | | Seebeck coefficient $\alpha$ (mV/K) | Electrical resistance $\rho$ ($\Omega$m) | Thermal conductivity $\kappa$ (W/mK) | Performance index Z (1/K) |
| 1 | 10N | 0.37 | $4.0\times10^{-6}$ | 51 | $6.7\times10^{-4}$ |
| 2 | 10N | 0.24 | $6.4\times10^{-6}$ | 43 | $2.1\times10^{-4}$ |

Table 18-2 (continued)

| No | Purity of matrix silicon | Thermoelectric resistance | | | |
|---|---|---|---|---|---|
| | | Seebeck coefficient α (mV/K) | Electrical resistance ρ (Ωm) | Thermal conductivity κ (W/mK) | Performance index Z (1/K) |
| 3 | 10N | 0.25 | $5.6\times10^{-6}$ | 53 | $2.1\times10^{-4}$ |
| 4 | 10N | 0.35 | $1.4\times10^{-5}$ | 39 | $2.2\times10^{-4}$ |
| 5 | 3N | 0.36 | $4.0\times10^{-6}$ | 51 | $6.4\times10^{-4}$ |
| 6 | 10N | 0.27 | $4.4\times10^{-6}$ | 42 | $3.9\times10^{-4}$ |
| 7 | 10N | 0.38 | $8.4\times10^{-6}$ | 49 | $3.5\times10^{-4}$ |
| 8 | 10N | 0.31 | $6.2\times10^{-6}$ | 19 | $8.2\times10^{-4}$ |
| 9 | 10N | 0.19 | $9.2\times10^{-6}$ | 48 | $8.2\times10^{-5}$ |
| 10 | 3N | 0.24 | $7.2\times10^{-6}$ | 55 | $1.5\times10^{-4}$ |

Table 19-1

| No | Purity of matrix silicon | Dopant | | | Analysis value after melting (at%) | Carrier concentration n (M/m$^3$) |
|---|---|---|---|---|---|---|
| | | Element name | Added substance | Added amount of dopant (mol%) | | |
| 11 | 10N | P | SiP | 3.00 | 2.91 | $1.3\times10^{20}$ |
| 12 | 10N | S | $SiS_2$ | 3.00 | 2.92 | $1.9\times10^{20}$ |
| 13 | 10N | O | $SiO_2$ | 3.00 | 2.95 | $1.8\times10^{20}$ |
| 14 | 10N | As | $SiAs_2$ | 3.00 | 2.86 | $1.0\times10^{20}$ |
| 15 | 3N | N | $Si_3N_4$ | 3.00 | 2.95 | $1.8\times10^{20}$ |
| 16 | 3N | P | SiP | 3.00 | 2.92 | $1.4\times10^{20}$ |
| 17 | 10N | Co | CoSi | 3.00 | 2.92 | $2.1\times10^{20}$ |
| 18 | 10N | Ce | $CeSi_2$ | 3.00 | 2.86 | $1.6\times10^{20}$ |
| 19 | 10N | P,O | $P_2O_5$ | 3.00 | 1.95 | $6.3\times10^{19}$ |
| 20 | 10N | P,S | $P_2S_5$ | 3.00 | 2.13 | $7.5\times10^{19}$ |
| 21 | 10N | P | P | 3.00 | 2.32 | $7.3\times10^{19}$ |

Table 19-2

| No | Purity of matrix silicon | Thermoelectric resistance | | | |
|---|---|---|---|---|---|
| | | Seebeck coefficient α (mV/K) | Electrical resistance ρ (Ωm) | Thermal conductivity κ (W/mK) | Performance index Z (1/K) |
| 11 | 10N | 0.29 | $6.9\times10^{-6}$ | 42 | $2.9\times10^{-4}$ |

Table 19-2 (continued)

| No | Purity of matrix silicon | Thermoelectric resistance | | | |
|---|---|---|---|---|---|
| | | Seebeck coefficient α (mV/K) | Electrical resistance ρ (Ωm) | Thermal conductivity κ (W/mK) | Performance index Z (1/K) |
| 12 | 10N | 0.27 | $1.0\times10^{-5}$ | 68 | $1.1\times10^{-4}$ |
| 13 | 10N | 0.29 | $9.8\times10^{-6}$ | 75 | $1.1\times10^{-4}$ |
| 14 | 10N | 0.25 | $1.2\times10^{-6}$ | 82 | $6.4\times10^{-4}$ |
| 15 | 3N | 0.26 | $4.3\times10^{-6}$ | 56 | $2.8\times10^{-4}$ |
| 16 | 3N | 0.29 | $7.1\times10^{-6}$ | 41 | $2.9\times10^{-4}$ |
| 17 | 10N | 0.28 | $8.2x10^{-6}$ | 45 | $2.1\times10^{-4}$ |
| 18 | 10N | 0.22 | $9.3\times10^{-6}$ | 36 | $1.4\times10^{-4}$ |
| 19 | 10N | 0.17 | $7.8\times10^{-6}$ | 62 | $6.0\times10^{-5}$ |
| 20 | 10N | 0.20 | $8.7\times10^{-6}$ | 85 | $5.4\times10^{-5}$ |
| 21 | 10N | 0.21 | $4.8\times10^{-5}$ | 62 | $1.5\times10^{-4}$ |

INDUSTRIAL APPLICABILITY

The novel silicon-based thermoelectric conversion material of the present invention is such that electrical resistance can be lowered and the Seebeck coefficient increased by adjusting the carrier concentration of silicon in the p-type semiconductor and n-type semiconductor by varying the amount of dopant, and this method does not sacrifice the high Seebeck coefficient inherent to silicon. Also, because the Seebeck coefficient is larger where the carrier concentration is high, this method is an effective way to obtain a material with low electrical resistance and a high performance index. Another advantage is that the properties of the material can be controlled by means of the type and amount of dopant.

With the thermoelectric conversion material of the present invention, by adding at least one type of Group 3 element and at least one type of Group 5 element to silicon and adjusting the added amount of Group 3 or 5 element in order to create a p-type semiconductor or n-type semiconductor and controlling the carrier concentration to a range of $10^{19}$ to $10^{21}$ ($M/m^3$), or by adding a Group 3-5 compound semiconductor or a Group 2-6 compound semiconductor, or by having a Group 4 element of germanium, carbon, or tin contained in silicon in an amount of 0.1 to 5 at%, with part of the elemental silicon substituted with a Group 4 element with a different atomic weight, and further adding a Group 3 or 5 dopant, either singly or in combination, for creating a p-type semiconductor and an n-type semiconductor, and suitably selecting the type and added amount of dopant, the electrical resistance is lowered and the Seebeck coefficient raised, and at the same time, the thermal conductivity is kept low, which yields a thermoelectric conversion material with a high performance index and increased thermoelectric conversion efficiency.

Furthermore, with the thermoelectric conversion material of the present invention, it is possible to lower the thermal conductivity by the addition of various elements heavier than silicon. Also, quenching results in an average grain diameter of 0.1 to 5 μm, which means that the average grain diameter of the semiconductor is finer, and since a grain boundary phase exhibiting metal or semi-metal conduction is dispersed in the material, the resulting thermoelectric conversion material has low thermal conductivity and electrical resistivity, and a high Seebeck coefficient.

In addition, porosity can be raised by subjecting this thermoelectric conversion material powder to a hot pressing treatment, or this powder can be mechanically alloyed, which results in an average grain diameter of 0.1 to 5 μm, which means that the average grain diameter of the semiconductor is finer, and since a grain boundary phase exhibiting metal or semi-metal conduction is dispersed in the material, the resulting thermoelectric conversion material has a high Seebeck coefficient and low thermal conductivity, and also has low electrical resistivity.

Because its main component is silicon, the thermoelectric conversion material of the present invention is less expensive than an Si-Ge system containing a large quantity of costly germanium, and a performance index higher than that of an Fe-Si system is obtained. Moreover, the silicon used in the present invention is far lower in purity than that used for semiconductor devices, so the raw material is available at relatively low cost, productivity is good, and an inexpensive thermoelectric conversion material with stable quality is obtained.

Another advantage of the thermoelectric conversion material of the present invention is that its main component, silicon, is outstanding in terms of its safety, impact on the global environment, and usage of global resources, and furthermore has a low specific gravity is therefore lightweight, which is an extremely desirable quality in automotive thermoelectric conversion elements. Also, because bulk silicon has excellent corrosion resistance, another advantage is that a surface treatment or the like is unnecessary.

## Claims

**1.** A thermoelectric conversion material composed of a p-type semiconductor in which the dopants used to make a p-type semiconductor are contained, either singly or in combination, in an amount of 0.001 to 20 at% in silicon.

**2.** A thermoelectric conversion material composed of an n-type semiconductor in which the dopants used to make an n-type semiconductor are contained, either singly or in combination, in an amount of 0.001 to 20 at% in silicon.

**3.** A thermoelectric conversion material composed of a p-type semiconductor containing at least one dopant used to make a p-type semiconductor (dopant $\alpha$) and at least one dopant used to make an n-type semiconductor (dopant $\beta$) in a total amount of 0.002 to 20 at% in silicon, with the total amount of dopants $\alpha$ exceeding that of the dopants $\beta$ and contained in just the amount required to produce a p-type semiconductor.

**4.** A thermoelectric conversion material composed of an n-type semiconductor containing at least one dopant used to make a p-type semiconductor (dopant $\alpha$) and at least one dopant used to make an n-type semiconductor (dopant $\beta$) in a total amount of 0.002 to 20 at% in silicon, with the total amount of dopants $\alpha$ exceeding that of the dopants $\beta$ and contained in just the amount required to produce an n-type semiconductor.

**5.** A thermoelectric conversion material composed of a p-type semiconductor or an n-type semiconductor as defined in any of Claims 1 to 4, wherein the dopant used to make a p-type semiconductor (dopants $\alpha$) is one or more types selected from the group consisting of:

dopants A (Be, Mg, Ca, Sr, Ba, Zn, Cd, Hg, B, Al, Ga, In, Tl) and transition metal elements $M_1$ ($M_1$; Y, Mo, Zr), and the dopant used to make an n-type semiconductor is one or more types selected from the group consisting of:
dopants B (N, P, As, Sb, Bi, O, S, Se, Te),
transition metal elements $M_2$ ($M_2$; Ti, V, Cr, Mn, Fe, Co, Ni, Cu, Nb, Ru, Rh, Pd, Ag, Hf, Ta, W, Re, Os, Ir, Pt, Au; where Fe accounts for 10 at% or less), and
rare earth elements RE (RE; La, Ce, Pr, Nd, Pm, Sm, Eu, Gd, Tb, Dy, Ho, Er, Yb, Lu).

**6.** A thermoelectric conversion material as defined in any of Claims 1 to 5, wherein the average crystal grain size is 0.1 to 5 $\mu$m.

**7.** A thermoelectric conversion material as defined in any of Claims 1 to 6, wherein the semiconductor texture is composed of a semiconductor crystal grain phase and a conductor crystal grain boundary phase of a metal or semimetal dispersed in bulk.

**8.** A thermoelectric conversion material as defined in any of Claims 1 to 7, wherein the carrier concentration is $10^{17}$ to $10^{21}$ ($M/m^3$).

**9.** A thermoelectric conversion material as defined in any of Claims 1 to 8, wherein the porosity is 5 to 40%.

**10.** A thermoelectric conversion material composed of a p-type semiconductor in which the dopants A (Be, Mg, Ca, Sr, Ba, Zn, Cd, Hg, B, Al, Ga, In, Tl) are contained, either singly or in combination, in an amount of 0.001 to 0.5 at% in silicon, and the carrier concentration is $10^{17}$ to $10^{20}$ ($M/m^3$).

**11.** A thermoelectric conversion material composed of a p-type semiconductor in which the dopants A (Be, Mg, Ca, Sr, Ba, Zn, Cd, Hg, B, Al, Ga, In, Tl) are contained, either singly or in combination, in an amount of 0.5 to 5.0 at% in silicon, and the carrier concentration is $10^{19}$ to $10^{21}$ ($M/m^3$).

**12.** A thermoelectric conversion material composed of an n-type semiconductor in which the dopants B (N, P, As, Sb, Bi, O, S, Se, Te) are contained, either singly or in combination, in an amount of 0.001 to 0.5 at% in silicon, and the carrier concentration is $10^{17}$ to $10^{20}$ ($M/m^3$).

13. A thermoelectric conversion material composed of an n-type semiconductor in which the dopants B (N, P, As, Sb, Bi, O, S, Se, Te) are contained, either singly or in combination, in an amount of 0.5 to 10 at% in silicon, and the carrier concentration is $10^{19}$ to $10^{21}$ ($M/m^3$).

14. A thermoelectric conversion material composed of a high-efficiency p-type semiconductor containing at least one dopant A (Be, Mg, Ca, Sr, Ba, Zn, Cd, Hg, B, Al, Ga, In, Tl) and at least one dopant B (N, P, As, Sb, Bi, O, S, Se, Te), in a total amount of 1 to 20 at%, wherein the dopant A is contained in an amount of 0.3 to 5 at% greater than the dopant B, the carrier concentration is $10^{19}$ to $10^{21}$ ($M/m^3$), and the thermal conductivity at room temperature is no more than 150 W/m • K.

15. A thermoelectric conversion material composed of a high-efficiency n-type semiconductor containing at least one dopant A (Be, Mg, Ca, Sr, Ba, Zn, Cd, Hg, B, Al, Ga, In, Tl) and at least one dopant B (N, P, As, Sb, Bi, O, S, Se, Te), in a total amount of 1 to 20 at%, wherein the dopant B is contained in an amount of 0.3 to 10 at% greater than the dopant A, the carrier concentration is $10^{19}$ to $10^{21}$ ($M/m^3$), and the thermal conductivity at room temperature is no more than 150 W/m • K.

16. A thermoelectric conversion material composed of a high-efficiency p-type semiconductor containing a Group 3-5 compound semiconductor or Group 2-6 compound semiconductor in an amount of 1 to 10 at% and further containing at least one type of dopant A (Be, Mg, Ca, Sr, Ba, Zn, Cd, Hg, B, Al, Ga, In, Tl) in an amount of 1 to 10 at%, wherein the carrier concentration is $10^{19}$ to $10^{21}$ ($M/m^3$) and the thermal conductivity at room temperature is no more than 150 W/m • K.

17. A thermoelectric conversion material composed of a high-efficiency n-type semiconductor containing a Group 3-5 compound semiconductor or Group 2-6 compound semiconductor in an amount of 1 to 10 at% and further containing at least one type of dopant B (N, P, As, Sb, Bi, O, S, Se, Te) in an amount of 1 to 10 at%, wherein the carrier concentration is $10^{19}$ to $10^{21}$ ($M/m^3$) and the thermal conductivity at room temperature is no more than 150 W/m • K.

18. A thermoelectric conversion material composed of a high-efficiency p-type semiconductor containing at least one of Ge, C and Sn in an amount of 0.1 to 5 at%,and an dopant A (Be, Mg, Ca, Sr, Ba, Zn, Cd, Hg, B, Al, Ga, In, Tl), either singly or in combination, in an amount of at least 0.001 at% in silicon, wherein the thermal conductivity at room temperature is no more than 150 W/m • K.

19. A thermoelectric conversion material as defined in Claim 18, wherein the content of dopant A, either singly or in combination, is 0.5 to 5.0 at%, and the carrier concentration is $10^{19}$ to $10^{21}$ ($M/m^3$).

20. A thermoelectric conversion material composed of a high-efficiency n-type semiconductor containing at least one of Ge, C, and Sn in an amount of 0.1 to 5 at% and an dopant B (N, P, As, Sb, Bi, O, S, Se, Te), either singly or in combination, in an amount of at least 0.001 at% in silicon, wherein the thermal conductivity at room temperature is no more than 150 W/m • K.

21. A thermoelectric conversion material as defined in Claim 20, wherein the content of dopant B, either singly or in combination, is 0.5 to 10 at%, and the carrier concentration is $10^{19}$ to $10^{21}$ ($M/m^3$).

22. A thermoelectric conversion material composed of a p-type semiconductor containing a transition metal element $M_1$ ($M_1$; Y, Mo, Zr), either singly or in combination, in an amount of 0.5 to 10 at% in silicon, wherein the carrier concentration is $10^{19}$ to $10^{21}$ ($M/m^3$).

23. A thermoelectric conversion material composed of an n-type semiconductor containing a rare earth element RE (La, Ce, Pr, Nd, Pm, Sm, Eu, Gd, Tb, Dy, Ho, Er, Yb, Lu), either singly or in combination, in an amount of 0.5 to 10 at% in silicon, wherein the carrier concentration is $10^{19}$ to $10^{21}$ ($M/m^3$).

24. A thermoelectric conversion material composed of an n-type semiconductor containing a transition metal element $M_2$ ($M_2$; Ti, V, Cr, Mn, Fe, Co, Ni, Cu, Nb, Ru, Rh, Pd, Ag, Hf, Ta, W, Re, Os, Ir, Pt, Au; where Fe accounts for 10 at% or less), either singly or in combination, in an amount of 0.5 to 10 at% in silicon, wherein the carrier concentration is $10^{19}$ to $10^{21}$ ($M/m^3$).

25. A thermoelectric conversion material composed of an n-type semiconductor containing at least one transition metal

element $M_2$ ($M_2$; Ti, V, Cr, Mn, Fe, Co, Ni, Cu, Nb, Ru, Rh, Pd, Ag, Hf, Ta, W, Re, Os, Ir, Pt Au; where Fe accounts for 10 at% or less) and at least one rare earth element RE (RE; La, Ce, Pr, Nd, Pm, Sm, Eu, Gd, Tb, Dy, Ho, Er, Yb, Lu) in a total amount of 0.5 to 10 at% in silicon, wherein the carrier concentration is $10^{19}$ to $10^{21}$ ($M/m^3$).

**26.** A thermoelectric conversion material composed of a p-type semiconductor containing at least one dopant A (Be, Mg, Ca, Sr, Ba, Zn, Cd, Hg, B, Al, Ga, In, Tl) and at least one transition metal element $M_1$ ($M_1$; Y, Mo, Zr) in a total amount of 1 to 10 at% in silicon, wherein the carrier concentration is $10^{19}$ to $10^{21}$ ($M/m^3$).

**27.** A thermoelectric conversion material composed of a p-type semiconductor containing at least one dopant A (Be, Mg, Ca, Sr, Ba, Zn, Cd, Hg, B, Al, Ga, In, Tl), at least one transition metal element $M_1$ ($M_1$; Y, Mo, Zr), and at least one rare earth element RE (RE; La, Ce, Pr, Nd, Pm, Sm, Eu, Gd, Tb, Dy, Ho, Er, Yb, Lu) in a total amount of 1 to 10 at% in silicon, wherein the carrier concentration is $10^{19}$ to $10^{21}$ ($M/m^3$).

**28.** A thermoelectric conversion material composed of an n-type semiconductor containing at least one dopant B (N, P, As, Sb, Bi, O, S, Se, Te) and at least one transition metal element $M_2$ ($M_2$; Ti, V, Cr, Mn, Fe, Co, Ni, Cu, Nb, Ru, Rh, Pd, Ag, Hf, Ta, W, Re, Os, Ir, Pt, Au; where Fe accounts for 10 at% or less) in a total amount of 1 to 10 at% in silicon, wherein the carrier concentration is $10^{19}$ to $10^{21}$ ($M/m^3$).

**29.** A thermoelectric conversion material composed of an n-type semiconductor containing at least one dopant B (N, P, As, Sb, Bi, O, S, Se, Te) and at least one rare earth element RE (RE; La, Ce, Pr) Nd, Pm, Sm, Eu, Gd, Tb, Dy, Ho, Er, Yb, Lu) in a total amount of 1 to 10 at% in silicon, wherein the carrier concentration is $10^{19}$ to $10^{21}$ ($M/m^3$).

**30.** A thermoelectric conversion material composed of an n-type semiconductor containing at least one dopant B (N, P, As, Sb, Bi, O, S, Se, Te), at least one transition metal element $M_2$ ($M_2$; Ti, V, Cr, Mn, Fe, Co, Ni, Cu, Nb, Ru, Rh, Pd, Ag, Hf, Ta, W, Re, Os, Ir, Pt, Au; where Fe accounts for 10 at% or less), and at least one rare earth element RE (RE; La, Ce, Pr, Nd, Pm, Sm, Eu, Gd, Tb, Dy, Ho, Er, Yb, Lu) in a total amount of 1 to 10 at% in silicon, wherein the carrier concentration is $10^{19}$ to $10^{21}$ ($M/m^3$).

**31.** A thermoelectric conversion material as defined in any of Claims 10 to 30, wherein the average crystal grain size is 0.1 to 5 $\mu$m.

**32.** A thermoelectric conversion material as defined in any of Claims 10 to 31, wherein the semiconductor texture is composed of a semiconductor crystal grain phase and a conductor crystal grain boundary phase of a metal or semi-metal dispersed in bulk.

**33.** A thermoelectric conversion material as defined in any of Claims 10 to 32, wherein the carrier concentration is $10^{17}$ to $10^{21}$ ($M/m^3$).

**34.** A thermoelectric conversion material as defined in any of Claims 10 to 33, wherein the porosity is 5 to 40%.

**35.** A method for manufacturing a thermoelectric conversion material that yields a p-type semiconductor or an n-type semiconductor composed of a semiconductor crystal grain phase and a conductor crystal grain boundary phase of a metal or semi-metal dispersed in bulk, in which a dopant used to make a p-type or n-type semiconductor is melted, either singly or in combination, such that the content is 0.001 to 20 at%, and the melt is quenched so as to achieve an average crystal rain size of 0.1 to 5 $\mu$m.

**36.** A method for manufacturing a thermoelectric conversion material that yields a p-type semiconductor or an n-type semiconductor composed of a semiconductor crystal grain phase and a conductor crystal grain boundary phase of a metal or semi-metal dispersed in bulk, in which a dopant used to make a p-type or n-type semiconductor is melted, either singly or in combination, such that the content is 0.001 to 20 at%, and the melt is splat-cooled so that all or most becomes amorphous, after which a heat treatment is performed to achieve an average crystal grain size of 0.1 to 5 $\mu$m.

**37.** A method for manufacturing a thermoelectric conversion material in which a dopant used to make a p-type or n-type semiconductor is melted, either singly or in combination, so as to be contained in an amount of 0.001 to 20 at% in silicon, the semiconductor material obtained by cooling this melt is made into a pulverized powder with the required particle diameter, and this powder is hot-pressed into a semiconductor material with a porosity of 5 to 40%.

**38.** A method for manufacturing a thermoelectric conversion material in which a dopant used to make a p-type or n-type semiconductor is melted, either singly or in combination, so as to be contained in an amount of 0.001 to 20 at% in silicon, the semiconductor material obtained by cooling this melt is made into a pulverized powder, and this powder is finely crystallized by mechanical alloying, after which it is made into a semiconductor material with a porosity of 5 to 40% by low-temperature hot-pressing.

**39.** A method for manufacturing a thermoelectric conversion material in which a compound of silicon and a dopant used to make a p-type or n-type semiconductor is doped and melted so that said dopant is contained, either singly or in combination, in an amount of 0.001 to 20 at% in silicon, thereby preventing the evaporation and scattering of the dopant.

**40.** A method for manufacturing a thermoelectric conversion material as defined in Claim 39, wherein a raw material with a purity of at least 3N is used as the matrix silicon raw material.

**41.** A method for manufacturing a thermoelectric conversion material composed of a p-type or n-type semiconductor as defined in any of Claims 35 to 40, the dopant used to make a p-type semiconductor is one or more types selected from the group consisting of:

dopants A (Be, Mg, Ca, Sr, Ba, Zn, Cd, Hg, B, Al, Ga, In, Tl) and transition metal elements $M_1$ ($M_1$; Y, Mo, Zr), and the dopant used to make an n-type semiconductor is one or more types selected from the group consisting of:
dopants B (N, P, As, Sb, Bi, O, S, Se, Te),
transition metal elements $M_2$ ($M_2$; Ti, V, Cr, Mn, Fe, Co, Ni, Cu, Nb, Ru, Rh, Pd, Ag, Hf, Ta, W, Re, Os, Ir, Pt, Au; where Fe accounts for 10 at% or less), and
rare earth elements RE (RE; La, Ce, Pr, Nd, Pm, Sm, Eu, Gd, Tb, Dy, Ho, Er, Yb, Lu).

Fig. 1A

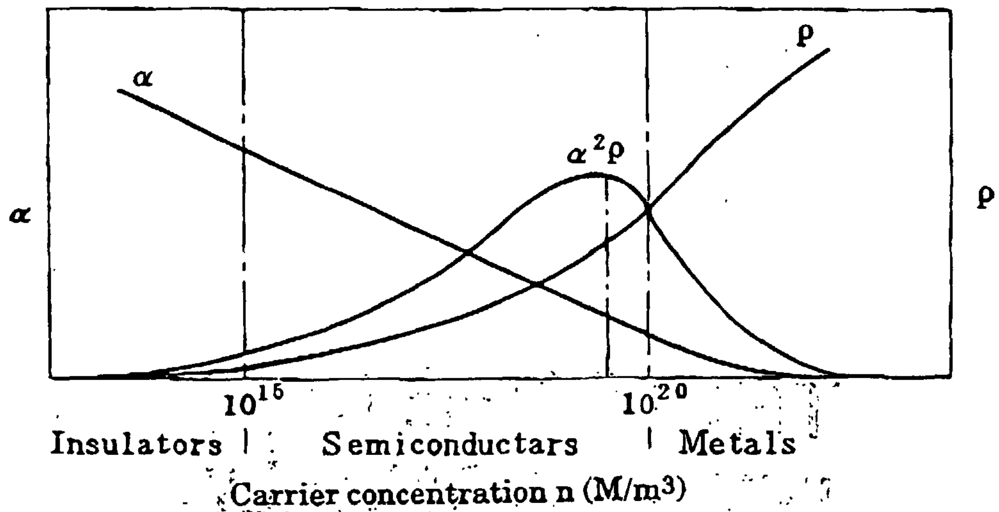
α
ρ
α²ρ
α
ρ
10¹⁵
10²⁰
Insulators
Semiconductars
Metals
Carrier concentration n (M/m³)

Fig. 1B

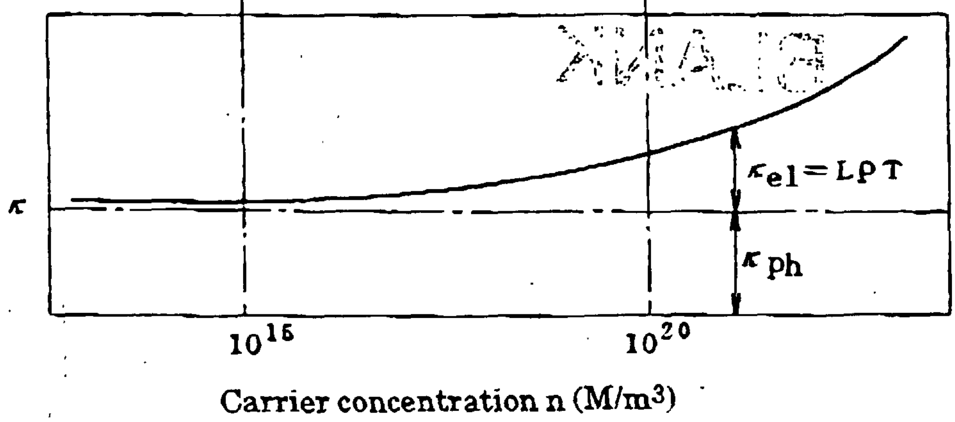
κ
κel = LρT
κph
10¹⁵
10²⁰
Carrier concentration n (M/m³)

Fig,2A

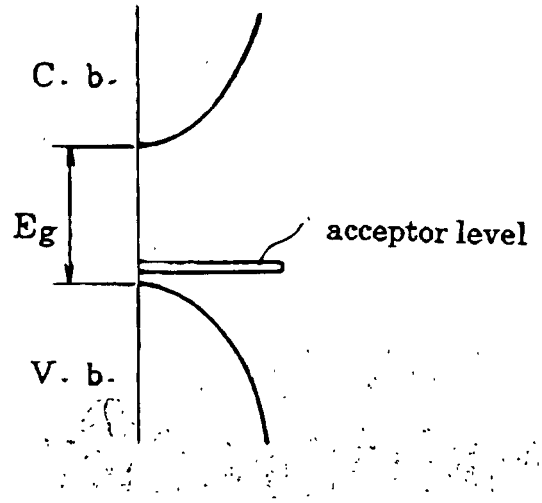


Fig, 2B

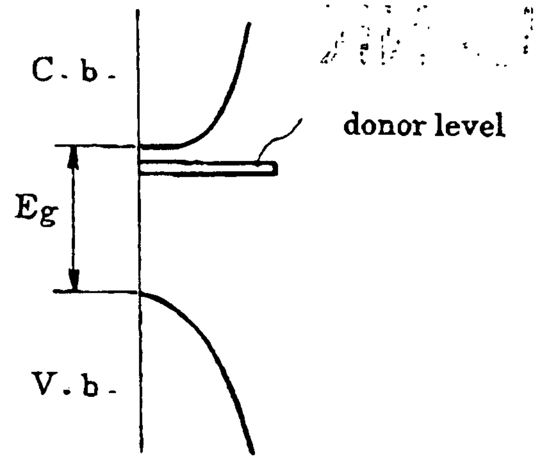

Fig, 3A

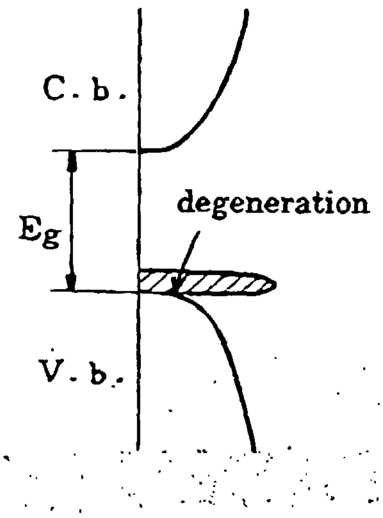


Fig, 3B

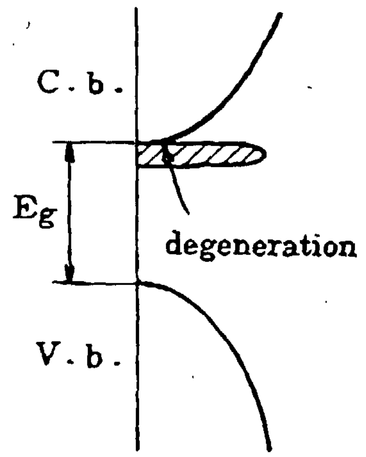

Fig.4

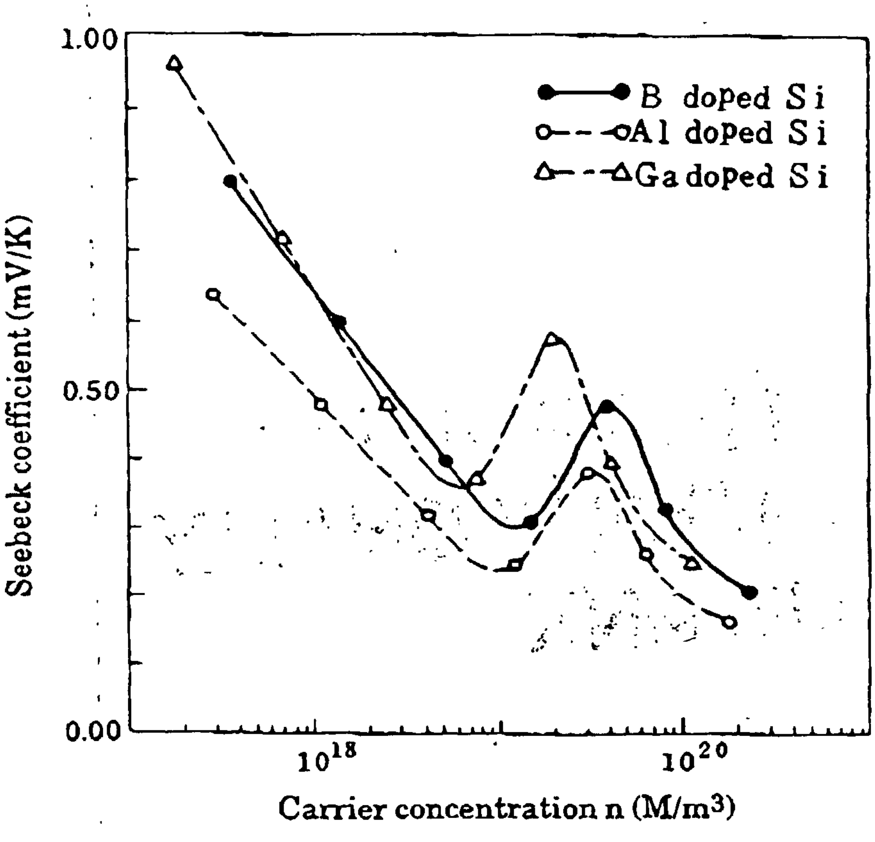
1.00
0.50
0.00
Seebeck coefficient (mV/K)
B doped Si
Al doped Si
Ga doped Si
$10^{18}$
$10^{20}$
Carrier concentration n (M/m$^3$)

Fig,5

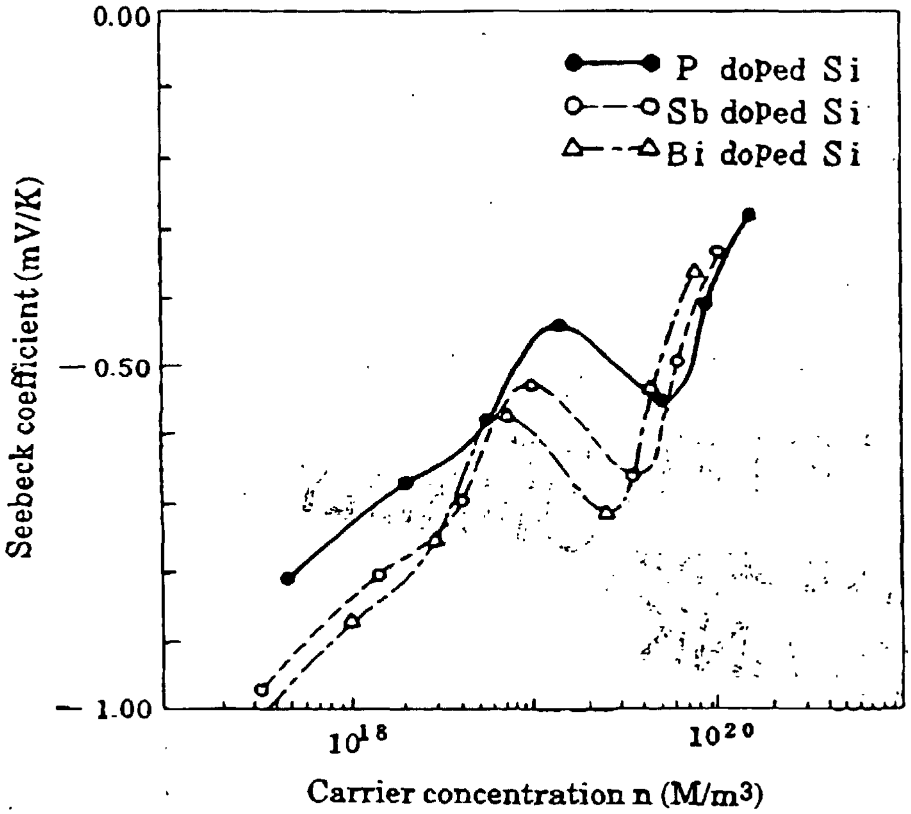
P doped Si
Sb doped Si
Bi doped Si
0.00
0.50
1.00
Seebeck coefficient (mV/K)
$10^{18}$
$10^{20}$
Carrier concentration n (M/m3)

Fig,6

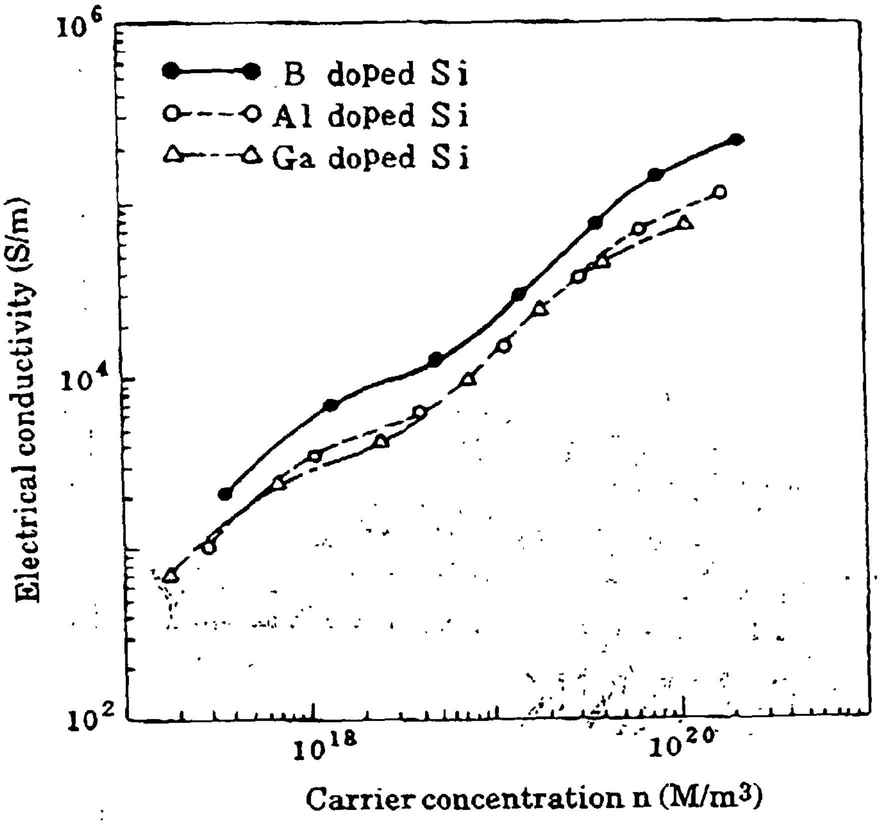
B doped Si
Al doped Si
Ga doped Si
$10^6$
$10^4$
$10^2$
$10^{18}$
$10^{20}$
Electrical conductivity (S/m)
Carrier concentration n (M/m3)

Fig.7

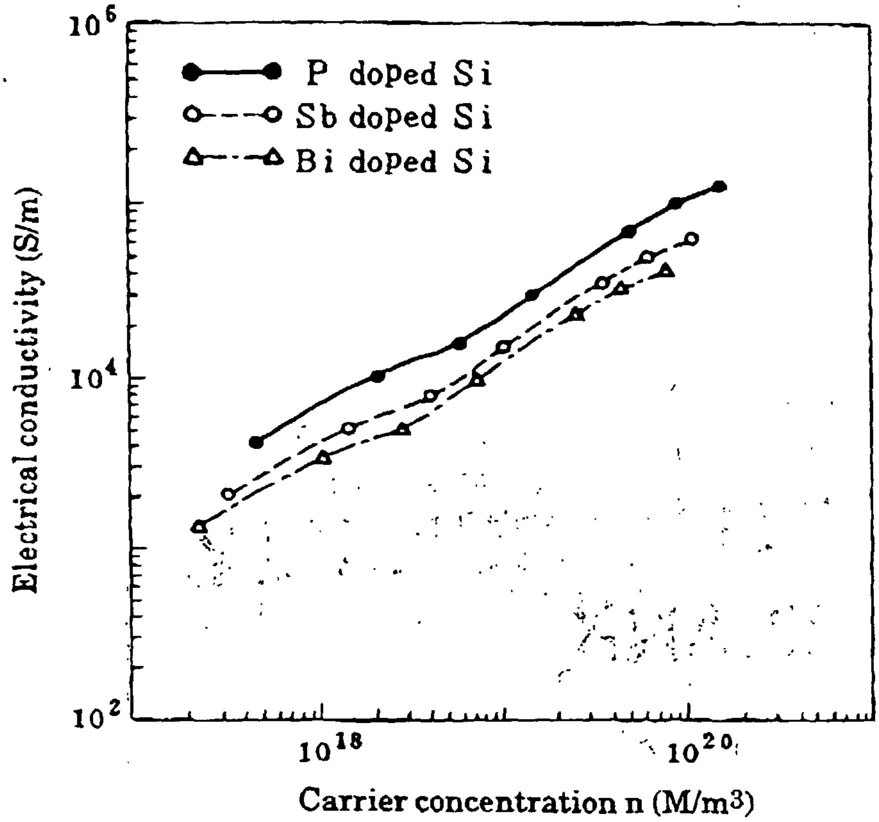
P doped Si
Sb doped Si
Bi doped Si
10^6
10^4
10^2
Electrical conductivity (S/m)
10^18
10^20
Carrier concentration n (M/m3)

Fig.8

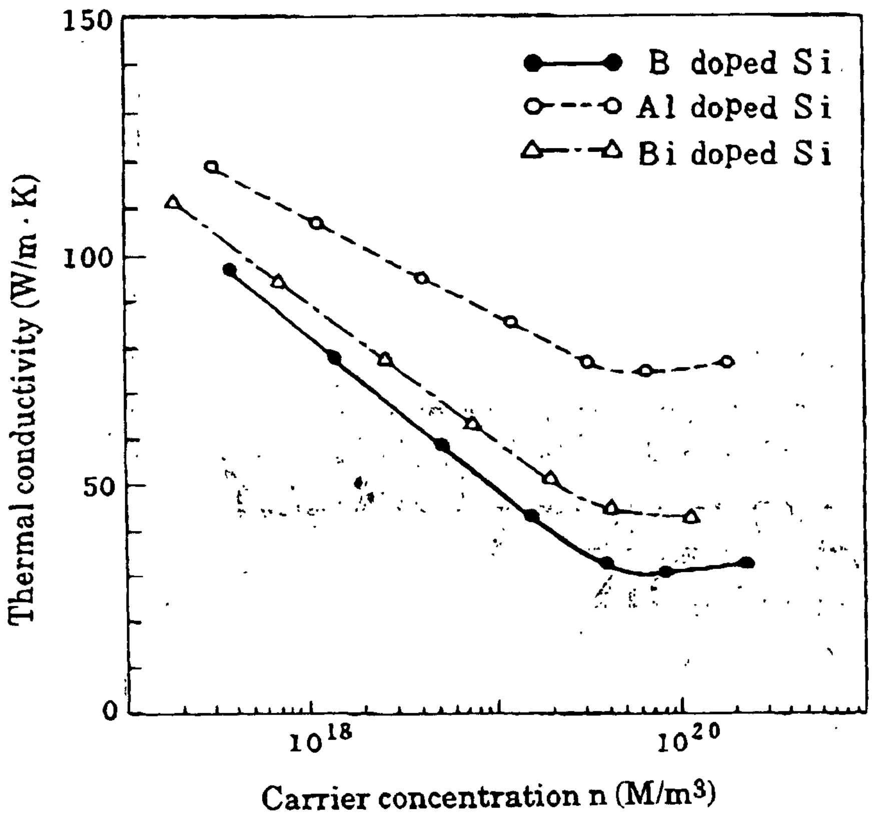
B doped Si
Al doped Si
Bi doped Si
150
100
50
0
Thermal conductivity (W/m · K)
$10^{18}$
$10^{20}$
Carrier concentration n (M/m³)

Fig,9

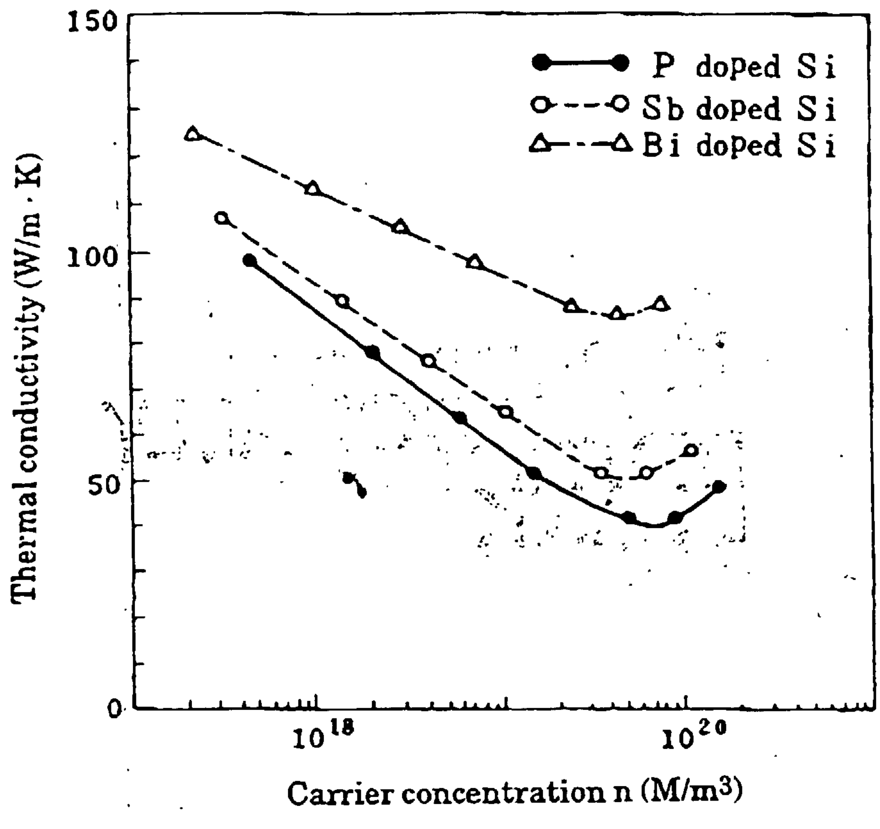
150
100
50
0
Thermal conductivity (W/m · K)
P doped Si
Sb doped Si
Bi doped Si
10^18
10^20
Carrier concentration n (M/m3)

Fig.10

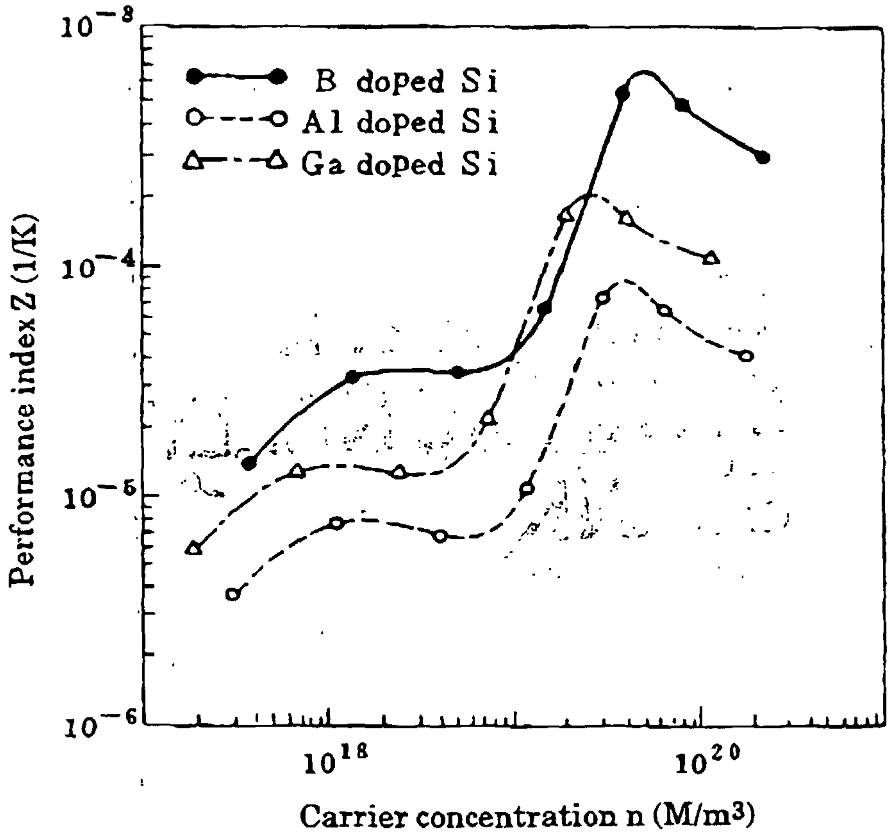
B doped Si
Al doped Si
Ga doped Si
$10^{-8}$
$10^{-4}$
$10^{-5}$
$10^{-6}$
Performance index Z (1/K)
$10^{18}$
$10^{20}$
Carrier concentration n (M/m3)

Fig, 11

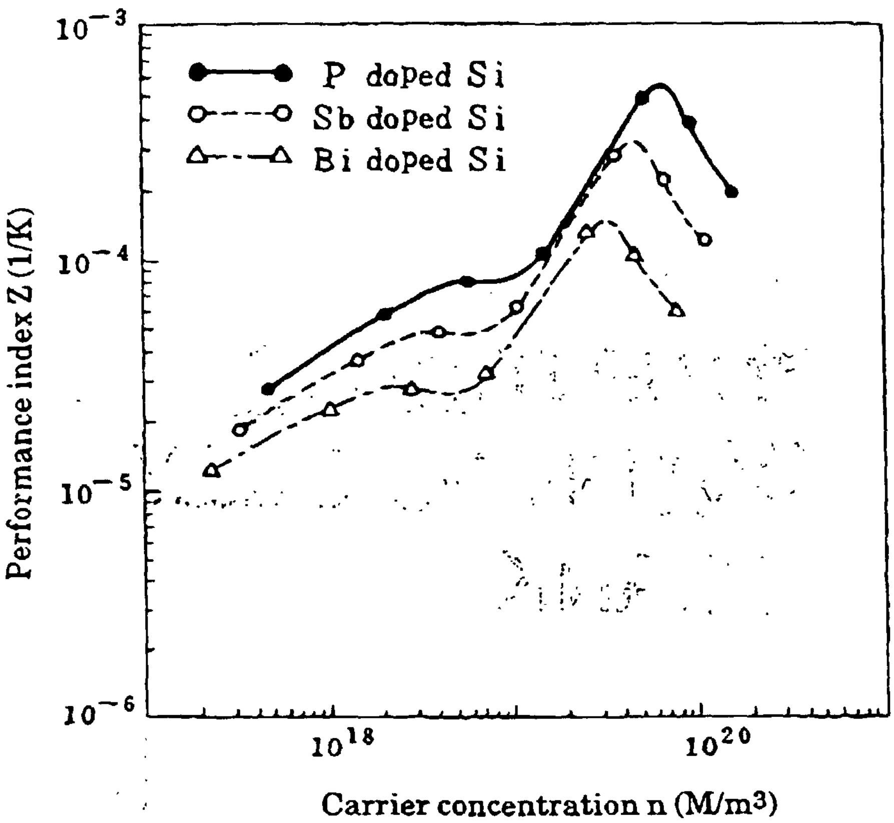
10⁻³
10⁻⁴
10⁻⁵
10⁻⁶
P doped Si
Sb doped Si
Bi doped Si
Performance index Z (1/K)
10¹⁸
10²⁰
Carrier concentration n (M/m3)

Fig,12A

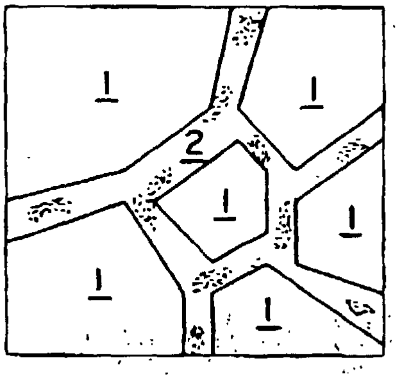


Fig,12B

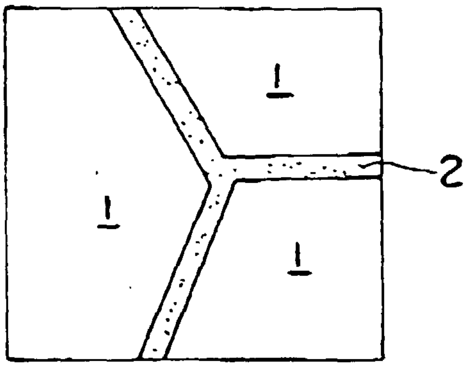

Fig,13

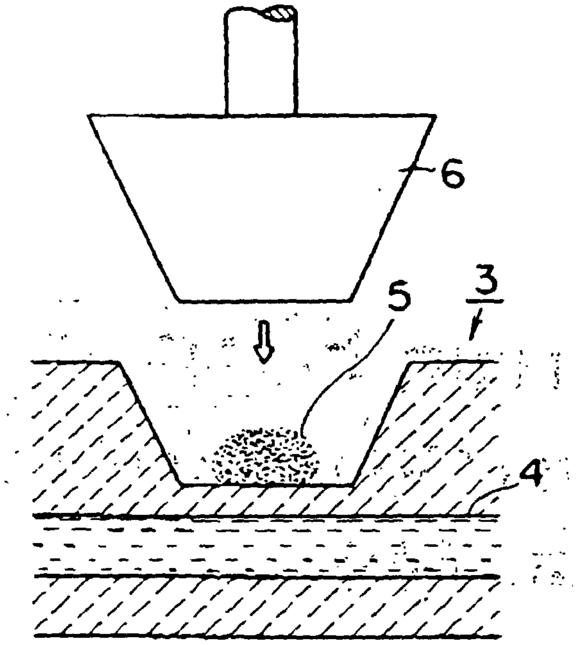

Fig,14A

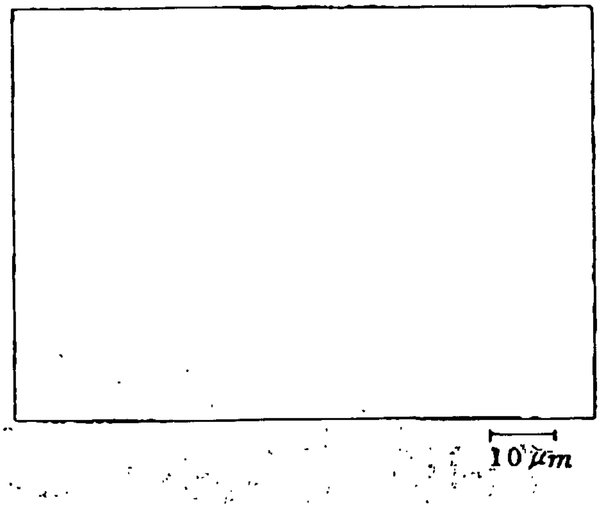


Fig,14B

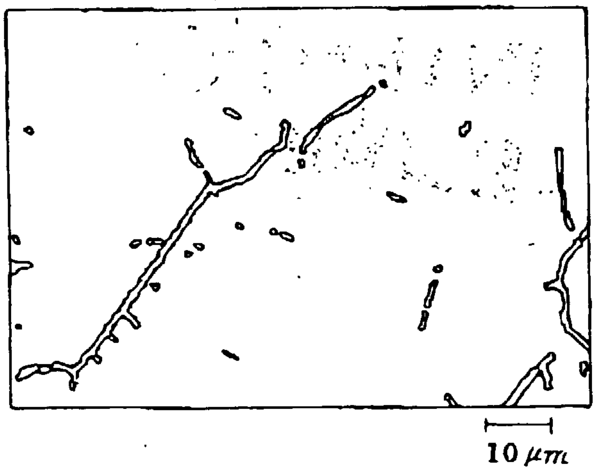


Fig,14C

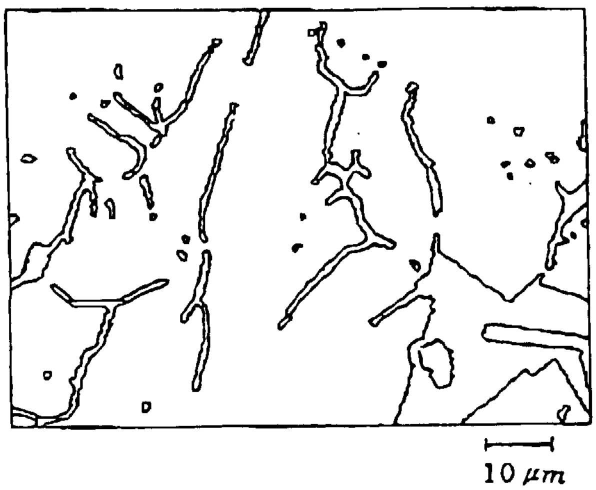

Fig,15A

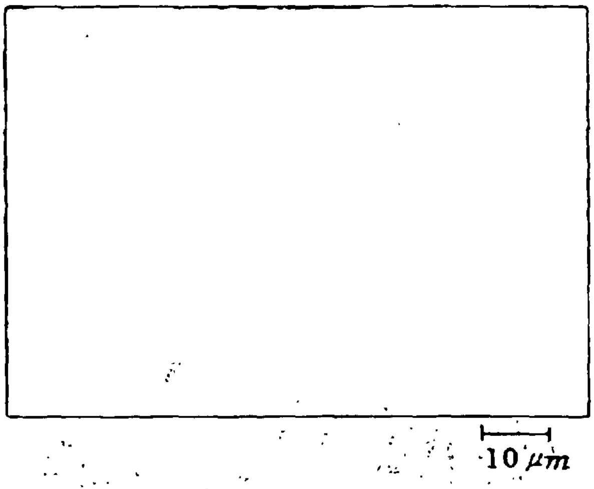


Fig,15B

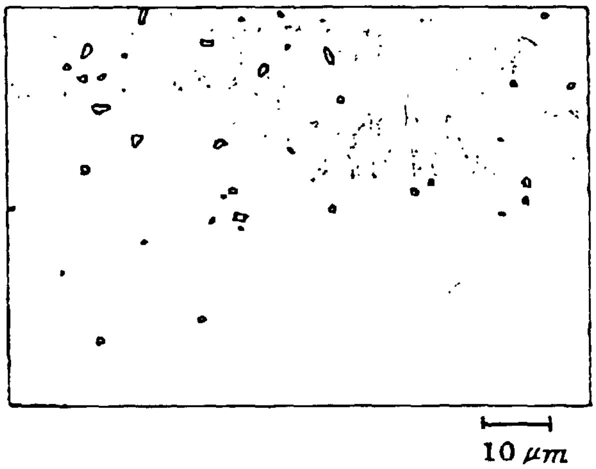


Fig,15C

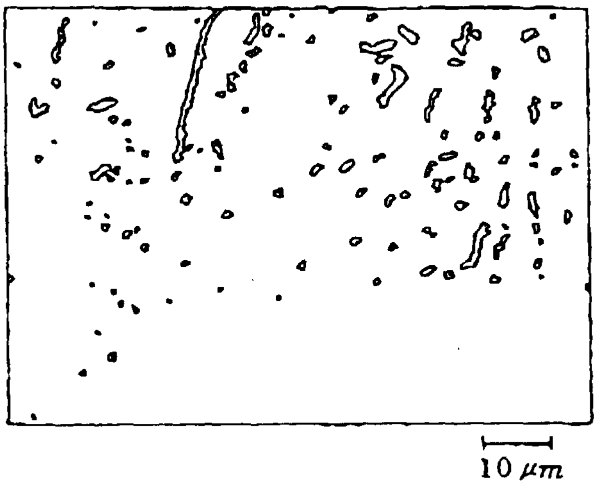

Fig.16A

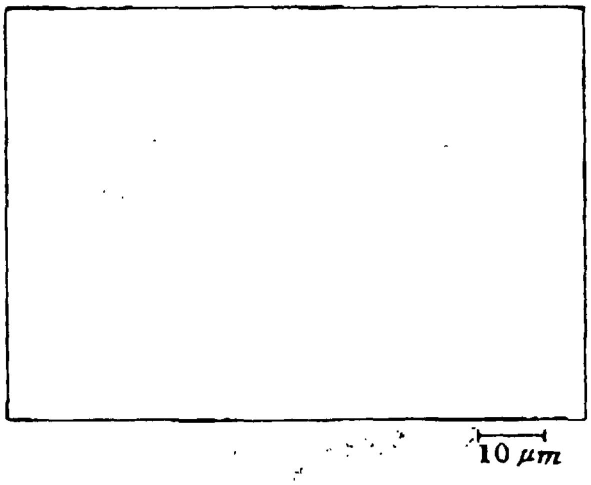


Fig.16B

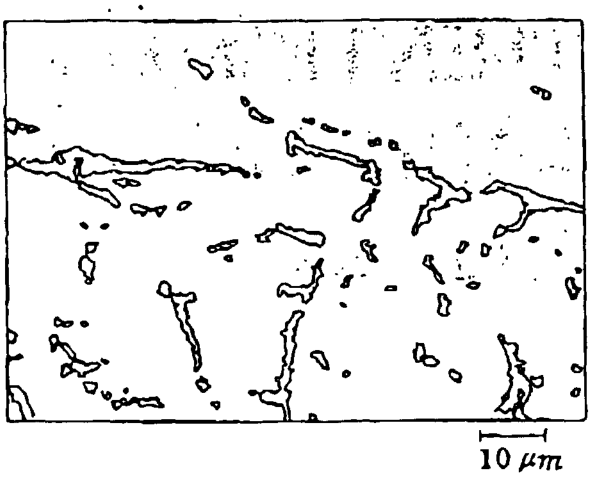


Fig.16C

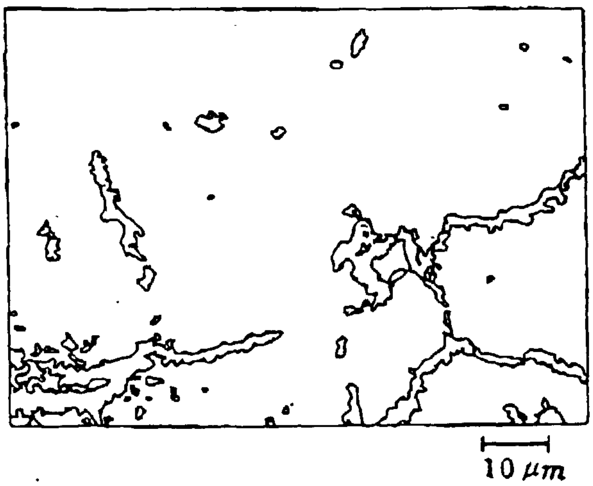

Fig,17A

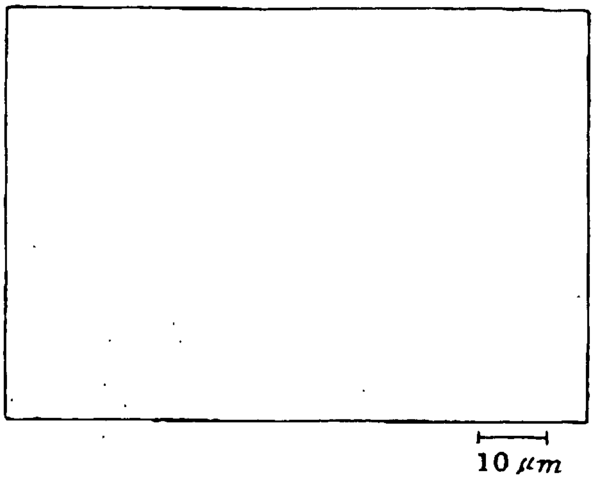


Fig,17B

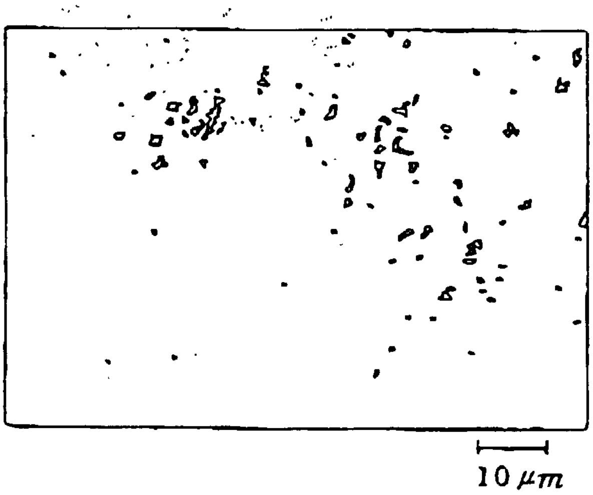


Fig,17C

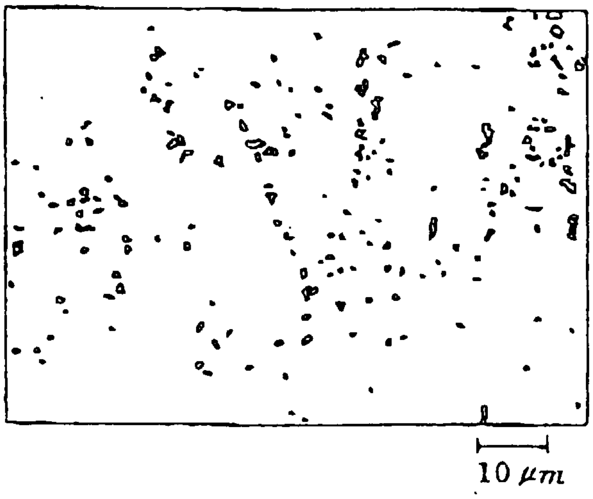

## INTERNATIONAL SEARCH REPORT

International application No.
PCT/JP98/03496

**A. CLASSIFICATION OF SUBJECT MATTER**
Int.Cl[6] H01L35/14, H01L35/34

According to International Patent Classification (IPC) or to both national classification and IPC

**B. FIELDS SEARCHED**

Minimum documentation searched (classification system followed by classification symbols)
Int.Cl[6] H01L35/14, H01L35/34

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-1998 |
| Kokai Jitsuyo Shinan Koho | 1971-1998 | Jitsuyo Shinan Toroku Koho | 1996-1998 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| P, X | JP, 10-22530, A (Sumitomo Special Metals Co., Ltd.), 23 January, 1998 (23. 01. 98), Column 3, lines 8 to 16 (Family: none) | 1, 2, 5, 8, 10, 12 |
| A | JP, 2-219286, A (NEC Corp.), 31 August, 1990 (31. 08. 90), Page 2, lower right column, line 12 to page 4, upper left column, line 6 (Family: none) | 1-41 |
| A | JP, 3-196583, A (Nippon Steel Corp.), 28 August, 1991 (28. 08. 91), Page 3, upper right column, line 10 to page 4, upper left column, line 14 (Family: none) | 1-41 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 October, 1998 (29. 10. 98) | 10 November, 1998 (10. 11. 98) |
| Name and mailing address of the ISA/ Japanese Patent Office | Authorized officer |
| Facsimile No. | Telephone No. |

Form PCT/ISA/210 (second sheet) (July 1992)